(19) **Europäisches Patentamt** / **European Patent Office** / **Office européen des brevets**

(11) **EP 4 752 256 A1**

(12) **EUROPEAN PATENT APPLICATION**
published in accordance with Art. 153(4) EPC

(43) Date of publication:
**03.06.2026 Bulletin 2026/23**

(21) Application number: **24854230.0**

(22) Date of filing: **15.08.2024**

(51) International Patent Classification (IPC):
**C23C 14/34** $^{(2006.01)}$

(52) Cooperative Patent Classification (CPC):
**C23C 14/34**

(86) International application number:
**PCT/JP2024/029116**

(87) International publication number:
**WO 2025/037642 (20.02.2025 Gazette 2025/08)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **17.08.2023 JP 2023133069
30.11.2023 JP 2023202660**

(71) Applicant: **Tosoh Corporation
Yamaguchi 746-8501 (JP)**

(72) Inventors:
• **SHONO, Daiki**
  **Ayase-shi, Kanagawa 252-1123 (JP)**
• **KONDO, Taiga**
  **Ayase-shi, Kanagawa 252-1123 (JP)**
• **HARA, Hiroyuki**
  **Ayase-shi, Kanagawa 252-1123 (JP)**
• **MESUDA, Masami**
  **Ayase-shi, Kanagawa 252-1123 (JP)**

(74) Representative: **Müller-Boré & Partner
Patentanwälte PartG mbB
Friedenheimer Brücke 21
80639 München (DE)**

(54) **METAL SPUTTERING TARGET, METAL SPUTTERING TARGET STRUCTURE, METHOD FOR PRODUCING FILM USING SAME, AND METHOD FOR PRODUCING METAL SPUTTERING TARGET**

(57) A metal sputtering target includes a metal having a body-centered cubic structure or a face-centered cubic structure. In the metal sputtering target, when a cross section perpendicular to a sputtering surface of the metal sputtering target is observed using an electron backscatter diffraction method to analyze crystal orientations in a normal direction (ND direction) of the sputtering surface, the proportion, relative to all measurement points, of measurement points having a plane orientation within 15° from the plane orientation with the highest intensity in an inverse pole figure space obtained from all the measurement points is 35% or more by area, and when a crystal orientation distribution function of the metal sputtering target is represented by Euler angles $(\varphi 1, \Phi, \varphi 2)$, which express a crystal orientation, in orientation groups of $\varphi 1$: $k°$ $(0 \leq k \leq 90)$, $\Phi$: $x°$ $(0 \leq x \leq 90)$, and $\varphi 2$: $y°$ $(0 \leq y \leq 90)$, for all combinations of $(x, y)$ for which the average value of orientation density in the range of $0 \leq k \leq 90$ is 1.2 or more, the coefficient of variation of the average value is 0.5 or less.

**Fig.1**

# EP 4 752 256 A1

## Description

### Technical Field

The present disclosure relates to a metal sputtering target, a metal sputtering target structure, a method for producing a film using the same, and a method for producing a metal sputtering target.

### Background Art

Sputtering targets are widely used as thin-film forming materials for semiconductor wiring and lithography masks. With the recent increase in the degree of integration of semiconductors, the thin films that make up these devices have also become finer. In particular, slight variations in the thickness of thin films (thickness distribution) have a significant impact on product yield.

In film formation by sputtering, the crystallographic orientation of the sputtering target is known to have a significant influence on the film thickness distribution during film formation. For example, Non Patent Literature 1 reports that sputtered particles are emitted along close-packed directions of the sputtering target. Non Patent Literature 2 reports that the close-packed direction fluctuates due to lattice vibration caused by thermal disturbance, and that the lattice vibration is amplified due to an increase in temperature, i.e., film thickness uniformity deteriorates when film is formed at high temperatures. It has been reported in Patent Literature 1 and 2 that film thickness uniformity can be improved by producing a sputtering target so that the close-packed direction is oriented in the normal direction of the sputtering surface.

### Citation List

### Patent Literature

[Patent Literature 1] Japanese Unexamined Patent Publication No. 2014-129599

[Patent Literature 2] Japanese Unexamined Patent Publication No. 2012-507626

### Non Patent Literature

[Non Patent Literature 1] Gottfried K. Wehner, Phys. Rev. 102, 690(1956)
[Non Patent Literature 2] F. Bouchard et al., J. Vac. Sci. Technol. A 11, 2765(1993)

### Summary of Invention

### Technical Problem

However, the sputtering targets described in Non Patent Literature 1 and 2 and Patent Literature 1 and 2 were merely subjected to orientation control in the normal direction of the sputtering surface.

The present disclosure aims to provide at least one of: a metal sputtering target suitable for forming, by sputtering, a sputtered film having a uniform film thickness; a metal sputtering target structure; a method for producing a film using these; and a method for producing a metal sputtering target.

### Solution to Problem

In the present disclosure, the inventors have focused on the crystal structure of a metal sputtering target and have studied the ways to improve the thickness uniformity of films formed by sputter deposition. As a result, the inventors have found that conventional metal sputtering targets exhibit anisotropy in the emission angle of sputtered particles due to in-plane anisotropy of the sputtering surface, thereby causing non-uniformity in the thickness of the resulting sputtered film. Further investigation has revealed that controlling the in-plane orientation of the metal sputtering target to a specific state improves the thickness uniformity of the resulting sputtered film (thin film).

That is, the present invention is as defined in the claims, and the gist of the present disclosure is described below.

[1] A metal sputtering target comprising a metal having a body-centered cubic structure or a face-centered cubic structure,

in which, when a cross section perpendicular to a sputtering surface of the metal sputtering target is observed using an electron backscatter diffraction method to analyze crystal orientations in a normal direction (ND direction) of the sputtering surface, a proportion, relative to all measurement points, of measurement points having a plane orientation within 15° from the plane orientation with the highest intensity in an inverse pole figure space obtained from all the measurement points is 35% or more by area, and

in which, when a crystal orientation distribution function of the metal sputtering target is represented by Euler angles ($\varphi1$, $\Phi$, $\varphi2$), which express a crystal orientation by rotating a crystal coordinate system, in which the [100] direction of a crystal is taken as an X-axis, the [010] direction is taken as a Y-axis, and the [001] direction is taken as a Z-axis, from a state in which the crystal coordinate system coincides respectively with an orthogonal sample coordinate system RD, TD, and ND of the sputtering target, by rotating the crystal coordinate system around the Z-axis by $\varphi1$, subsequently around the rotated X-axis by $\Phi$, and further around the rotated Z-axis by $\varphi2$, in orientation groups of $\varphi1$: k° ($0 \leq k \leq 90$), $\Phi$: x° ($0 \leq x \leq 90$), and $\varphi2$: y° ($0 \leq y \leq 90$), for all combinations of (x, y) for which the average value of orientation density in the range of $0 \leq k \leq 90$ is 1.2 or more, the coefficient of variation of the average value is 0.5 or less.

[2] The metal sputtering target according to [1], wherein the proportion is 98% or less by area.

[3] The metal sputtering target according to [1] or [2], wherein the coefficient of variation of the average value is 0.01 or more.

[4] The metal sputtering target according to any one of [1] to [3], wherein the maximum value of the crystal orientation distribution function is 2.0 or more.

[5] The metal sputtering target according to any one of [1] to [4], wherein the maximum value of the crystal orientation distribution function is 50 or less.

[6] The metal sputtering target according to any one of [1] to [5], wherein the metal is one or more selected from the group consisting of chromium (Cr), iron (Fe), ruthenium (Ru), niobium (Nb), molybdenum (Mo), tantalum (Ta), vanadium (V), tungsten (W), aluminum (Al), copper (Cu), and nickel (Ni).

[7] The metal sputtering target according to any one of [1] to [6], wherein the metal is one or more selected from the group consisting of chromium (Cr), ruthenium (Ru), molybdenum (Mo), and tungsten (W).

[8] A metal sputtering target structure comprising: a metal sputtering target according to any one of [1] to [7]; and a backing plate.

[9] A method for producing a film, comprising using the metal sputtering target according to any one of [1] to [7] or the metal sputtering target structure according to [8].

[10] A method for producing a metal sputtering target according to any one of [1] to [7], the method comprising: a pressing step of subjecting an ingot made of a metal having a body-centered cubic structure or a face-centered cubic structure to pressing treatment at a pressing temperature of 500°C or higher using a buffer member including a buffer layer to obtain a processed ingot; and a heat treatment step of treating the processed ingot at 900°C or higher.

[11] The method for producing a metal sputtering target according to [10], wherein the buffer layer is a buffer layer including a coating.

[12] The method for producing a metal sputtering target according to [10] or [11], wherein the buffer layer is a buffer layer including a graphite lubricant coating.

**Advantageous Effects of Invention**

The present disclosure can provide at least one of a metal sputtering target that enables the formation of a sputtered film with a uniform thickness by sputtering, a metal sputtering target structure, a method for producing a film using these, and a method for producing the metal sputtering target.

**Brief Description of Drawings**

[Fig. 1] Fig. 1 is a cross-sectional view illustrating an embodiment of a metal sputtering target structure of the present disclosure.

[Fig. 2] Fig. 2 is a cross-sectional view illustrating an example of a film-attached substrate produced by a method for producing a film of the present disclosure.

## Description of Embodiments

The present disclosure will be described in detail with reference to the drawings illustrating an embodiment. The configurations and parameters disclosed in the present specification may be combined in any combination, and the upper and lower limits of the values disclosed in the present specification may be combined in any combination. In addition, the same or equivalent constituent elements are given the same reference numerals throughout the drawings.

<<Metal Sputtering Target>>

In the present embodiment, a metal sputtering target includes a metal having a body-centered cubic structure or a face-centered cubic structure,

in which, when a cross section perpendicular to a sputtering surface of the metal sputtering target is observed using an electron backscatter diffraction method to analyze crystal orientations in a normal direction (ND direction) of the sputtering surface, a proportion, relative to all measurement points, of measurement points having an orientation (plane orientation) within 15° from the plane orientation with the highest intensity in an inverse pole figure space obtained from all the measurement points is 35% or more by area, and
in which, when a crystal orientation distribution function of the metal sputtering target is represented by Euler angles ($\varphi 1$, $\Phi$, $\varphi 2$), which express a crystal orientation by rotating a crystal coordinate system, in which the [100] direction of a crystal is taken as an X-axis, the [010] direction is taken as a Y-axis, and the [001] direction is taken as a Z-axis, from a state in which the crystal coordinate system coincides respectively with an orthogonal sample coordinate system RD, TD, and ND of the sputtering target, by rotating the crystal coordinate system around the Z-axis by $\varphi 1$, subsequently around the rotated X-axis by $\Phi$, and further around the rotated Z-axis by $\varphi 2$, in orientation groups of $\varphi 1$: $k°$ ($0 \leq k \leq 90$), $\Phi$: $x°$ ($0 \leq x \leq 90$), and $\varphi 2$: $y°$ ($0 \leq y \leq 90$), for all combinations of $(x, y)$ for which the average value of orientation density in the range of $0 \leq k \leq 90$ is 1.2 or more, the coefficient of variation of the average value is 0.5 or less.

The metal sputtering target of the present embodiment is suitable for forming a sputtered film with a uniform thickness by sputtering.

The present embodiment relates to a metal sputtering target (hereinafter, also referred to as a "target of the present embodiment") containing a metal having a body-centered cubic structure or a face-centered cubic structure, and may be a metal sputtering target containing a metal having a body-centered cubic structure (hereinafter, also referred to as a "bcc metal"), or may be a metal sputtering target made of a bcc metal. Furthermore, the present embodiment may be a metal sputtering target containing a metal having a face-centered cubic structure (hereinafter, also referred to as an "fcc metal"), or may be a metal sputtering target made of an fcc metal.

The bcc metal is preferably one or more selected from the group consisting of chromium (Cr), iron (Fe), ruthenium (Ru), niobium (Nb), molybdenum (Mo), tantalum (Ta), vanadium (V), and tungsten (W), more preferably one or more selected from the group consisting of chromium, molybdenum, ruthenium, and tungsten, still more preferably one or more selected from the group consisting of chromium, molybdenum, and tungsten, and particularly preferably one or more selected from chromium and molybdenum. From the viewpoint of application of the sputtered film formed using the target of the present embodiment as a light-shielding film material in mask blanks, chromium is preferable, whereas from the viewpoint of application of the sputtered film formed using the target of the present embodiment as a reflective layer material in EUV mask blanks, molybdenum is preferable.

The bcc metal may be an alloy. Examples of the alloy constituting the target of the present embodiment include an alloy containing one or more selected from the group consisting of chromium, iron, ruthenium, niobium, molybdenum, tantalum, vanadium, and tungsten, an alloy containing one or more selected from the group consisting of chromium, molybdenum, ruthenium, and tungsten, an alloy containing one or more selected from the group consisting of chromium, molybdenum, and tungsten, an alloy containing chromium and molybdenum, an alloy containing chromium, and a chromium-molybdenum alloy.

The fcc metal is preferably one or more selected from the group consisting of aluminum (Al), copper (Cu), and nickel (Ni), and is more preferably copper (Cu).

The fcc metal may be an alloy. The alloy constituting the target of the present embodiment is preferably one or more selected from the group consisting of aluminum (Al), copper (Cu), and nickel (Ni). Examples thereof include an alloy containing one or more selected from the group consisting of aluminum (Al) and copper (Cu), and an alloy containing one or more selected from the group consisting of copper (Cu) and nickel (Ni).

Hereinafter, the target of the present embodiment is also referred to as, for example, a "molybdenum sputtering target" when the metal contained in the metal sputtering target is molybdenum, or a "chromium-molybdenum sputtering target" when the metal contained in the metal sputtering target is a chromium-molybdenum alloy.

The target of the present embodiment may contain an amorphous phase as long as the generation of particles can be inhibited when the target of the present embodiment is used.

The average crystal grain size of the metal contained in the target of the present embodiment can be, for example, 200 $\mu$m or less, 150 $\mu$m or less, 100 $\mu$m or less, 80 $\mu$m or less, or 50 $\mu$m or less. The average crystal grain size can be, for example, 5 $\mu$m or more, 10 $\mu$m or more, 20 $\mu$m or more, or 30 $\mu$m or more. The average crystal grain size can be, for example, 5 $\mu$m or more and 200 $\mu$m or less, 10 $\mu$m or more and 150 $\mu$m or less, or 20 $\mu$m or more and 100 $\mu$m or less.

In the present embodiment, the average crystal grain size is an average value of crystal grain sizes that can be determined by a method in accordance with JIS G 0551:2020 and Annex JC.

The target of the present embodiment preferably has a low metallic impurity content. For example, the purity of the target of the present embodiment is preferably more than 99.6%, 99.9% or more, 99.99% (4N) or more, or 99.999% (5N) or more, or may be 100% or less or less than 100%. The purity of the target of the present embodiment may be more than 99.6% and 100% or less, 99.9% or more and 100% or less, 99.9% or more and less than 100%, or 99.99% or more and less than 100%.

In the present embodiment, the metallic impurity content refers to a metallic impurity content as measured by glow discharge mass spectrometry (hereinafter, also referred to as "GDMS") in accordance with ASTM F1593. The metallic impurities include metals other than bcc metals. In a metal material made of a specific bcc metal, the metallic impurities include metals other than the specific bcc metal. For example, in the case of a molybdenum sputtering target, the metallic impurities include metals other than molybdenum. In the case of a chromium-molybdenum sputtering target, the metallic impurities include metals other than chromium and molybdenum. The measurement sample may be any prismatic metal material having dimensions of 10 to 25 mm $\times$ 10 to 25 mm $\times$ 0.5 to 15 mm. Prior to measurement, the measurement sample may be pretreated by polishing with SiC abrasive paper (#800) until the surface roughness Ra is 1.6 $\mu$m or less, followed by ultrasonic cleaning in pure water for 10 minutes, dehydration with alcohol, hot-air drying, and vacuum packaging.

The oxygen content of the target of the present embodiment is preferably 200 ppm or less by mass, and is preferably 150 ppm or less by mass, 30 ppm or less by mass, or 10 ppm or less by mass. As a result, when the target of the present embodiment is used, the generation of particles is inhibited more easily. Oxygen may be contained as long as it is within a range in which particle generation is inhibited. For example, the oxygen content is 0 ppm or more by mass, more than 0 ppm by mass, 1 ppm or more by mass, or 3 ppm or more by mass. For example, the oxygen content is 0 ppm or more by mass and 200 ppm or less by mass, more than 0 ppm by mass and 150 ppm or less by mass, or 1 ppm or more by mass and 30 ppm or less by mass.

The oxygen content of the target of the present embodiment can be measured with a general oxygen/nitrogen analyzer (for example, ON736, manufactured by LECO Corporation).

The target of the present embodiment may have any shape, and preferably has a shape suitable for sputtering. Examples thereof include one or more selected from the group consisting of a plate shape, a columnar shape, and a cylindrical shape.

The area of the sputtering surface of the target of the present embodiment is not particularly limited, but is preferably 200 cm$^2$ or more, 350 cm$^2$ or more, or 800 cm$^2$ or more, from the viewpoint of increasing the film formation area. The area of the sputtering surface is, for example, 2000 cm$^2$ or less, 1500 cm$^2$ or less, or 1200 cm$^2$ or less. The area of the sputtering surface is, for example, 200 cm$^2$ or more and 2000 cm$^2$ or less, 350 cm$^2$ or more and 2000 cm$^2$ or less, or 350 cm$^2$ or more and 1500 cm$^2$ or less.

<Degree of Orientation>

In the target of the present embodiment, when a cross-section perpendicular to a sputtering surface of the metal sputtering target is observed using an electron backscatter diffraction method to analyze crystal orientations in the normal direction (ND direction) of the sputtering surface, a plane orientation having the highest intensity in an inverse pole figure space obtained from all measurement points in the cross-section is identified (dominant plane orientation), measurement points having an orientation (plane orientation) within 15° from the identified plane orientation are extracted, and a proportion by area relative to all the measurement points is defined as a degree of orientation, the degree of orientation is 35% by area or more. When the degree of orientation is less than 35% by area, the thickness of a film (sputtered film) to be obtained is non-uniform. That is, when the degree of orientation is 35% or more by area, the thickness uniformity of the film (sputtered film) to be obtained is improved.

The degree of orientation is preferably 40% or more by area. The degree of orientation may be 50% or more by area, 60% or more by area, 70% or more by area, or 80% or more by area.

A high degree of orientation is preferred, and examples thereof include less than 100% by area, 98% or less by area, 95% or less by area, 90% or less by area, 80% or less by area, 70% or less by area, and 60% or less by area.

The degree of orientation may be 35% or more by area and less than 100% by area, 40% or more by area and 98% or less by area, or 50% or more by area and 95% or less by area.

In the present embodiment, the degree of orientation can be determined from a SEM observation image obtained by scanning electron microscope-electron backscatter diffraction (hereinafter also referred to as "SEM-EBSD") measurement under conditions described below.

> Observation magnification: 10×
> Accelerating voltage: 20 kV
> Probe current: 100 μA
> Working distance: 10 mm
> Step size: 5 μm

That is, the SEM observation image is divided into a 5 μm × 5 μm grid to define grid points. The grid points are used as measurement points. Then, the orientation plane at each of all measurement points is identified, and the area of the orientation plane is measured. In addition, the intensity in an inverse pole figure space obtained from each measurement point is determined, and a plane orientation having the highest intensity is identified. Here, the intensity refers to an appearance frequency of a specific plane orientation relative to a state of complete randomness, and is a dimensionless parameter. For example, when the intensity of a specific plane orientation is "5", this means that the specific plane orientation appears at a frequency five times that in the completely random state. Then, the degree of orientation is determined from the proportion by area, relative to all measurement points, of measurement points having a plane orientation within 15° from the plane orientation. For example, when the plane orientation is a {111} plane, the degree of orientation can be determined by the following equation.

Degree of orientation$_{\{111\}}$ [% by area] = {total area of measurement points oriented in the {111} plane/total area of all measurement points} × 100

SEM observation, identification of the orientation plane, measurement of the area thereof, and measurement of the intensity in an inverse pole figure space obtained from each measurement point may be performed using a general-purpose SEM-EBSD apparatus (for example, JSM-IT800 manufactured by JEOL Ltd.) and an associated measurement/analysis program (for example, AZtec, AZtec Crystal).

Prior to SEM-EBSD measurement, a measurement sample (metal sputtering target) may be mirror-polished using SiC abrasive paper and buff polishing, and then an altered material layer of the material may be removed by acid etching or plasma etching. For example, the pretreatment may be performed by electrolytic etching with a 5% by volume aqueous sulfuric acid solution.

<Crystal Orientation Distribution Function>

In the target of the present embodiment, when a crystal orientation distribution function of the metal sputtering target is represented by Euler angles (φ1, Φ, φ2) that express a crystal orientation by rotating a crystal coordinate system, where the [100] direction of a crystal is taken as an X-axis, the [010] direction is taken as a Y-axis, and the [001] direction is taken as a Z-axis, from a state in which the crystal coordinate system coincides respectively with an orthogonal sample coordinate system RD, TD, and ND of the sputtering target, by rotating the crystal coordinate system around the Z-axis by φ1, subsequently around the rotated X-axis by Φ, and further around the rotated Z-axis by φ2, in orientation groups of φ1: k° (0 ≤ k ≤ 90), Φ: x° (0 ≤ x ≤ 90), and φ2: y° (0 ≤ y ≤ 90), for all combinations of (x, y) (combinations of x and y) for which an average value of orientation density in the range of 0 ≤ k ≤ 90 (hereinafter, also referred to as "average orientation density") is 1.2 or more, the coefficient of variation of the average orientation density is 0.5 or less.

Here, the Euler angles (φ1, Φ, φ2) are a set of angles that represent a crystal orientation in a sample coordinate system of a metal sputtering target by rotating a crystal coordinate system, where the [100] direction of a crystal is taken as an X-axis, the [010] direction is taken as a Y-axis, and the [001] direction is taken as a Z-axis, from a state in which the crystal coordinate system coincides respectively with an orthogonal sample coordinate system RD, TD, and ND of the sputtering target, by rotating the crystal coordinate system around the Z-axis by φ1, subsequently around the rotated X-axis by Φ, and further around the rotated Z-axis by φ2. The Euler angles (φ1, Φ, φ2) are expressed in the Bunge convention.

Here, "ND" is the normal direction of the sputtering surface (a direction perpendicular to the sputtering surface), and "TD" is a direction orthogonal to "ND" and "RD". "RD" differs in accordance with the shape of the sputtering surface of the target.

For example, when the sputtering surface has a rectangular shape, "RD" is a longitudinal direction of the rectangle. In this case, "TD" is a direction orthogonal to "ND" and "RD" and is also a width direction.

When the sputtering surface has a circular shape, "RD" is a direction along a diameter passing through the center of the circle.

When the coefficient of variation of the average orientation density is 0.5 or less, in-plane anisotropy of the crystal structure is reduced. As a result, thickness uniformity of a film during film formation is improved.

When the crystal orientation distribution function is represented by Euler angles, if, in the orientation groups of $\varphi1$: $k°$ $(0 \leq k \leq 90)$, $\Phi$: $x°$ $(0 \leq x \leq 90)$, and $\varphi2$: $y°$ $(0 \leq y \leq 90)$, for any of the combinations of $(x, y)$ for which the average orientation density in the range of $0 \leq k \leq 90$ is 1.2 or more, the coefficient of variation of the average orientation density is more than 0.5, in-plane anisotropy of the crystal structure increases, and thickness uniformity of the resulting film decreases. Such a metal sputtering target only produces films with low uniformity in thickness.

The coefficient of variation of the average orientation density can be determined as follows.

Coefficient of variation of average orientation density = standard deviation of average orientation density/average value of average orientation density

The coefficient of variation of the average orientation density may be 0.4 or less, or 0.3 or less.

The lower limit of the coefficient of variation of the average orientation density is, but not particularly limited to, for example, 0.01 or more, 0.05 or more, 0.1 or more, or 0.2 or more. For molybdenum, the coefficient of variation of the average orientation density may be 0.01 or more and 0.5 or less, 0.01 or more and 0.4 or less, or 0.01 or more and 0.3 or less. For chromium, the coefficient of variation of the average orientation density may be 0.01 or more and 0.5 or less, 0.05 or more and 0.5 or less, or 0.1 or more and 0.5 or less.

The maximum value of the crystal orientation distribution function of the target of the present embodiment is preferably 2.0 or more, more preferably 2.5 or more. When the maximum value of the crystal orientation distribution function is 2.0 or more, the anisotropy in the emission angle of the sputtered particles is further reduced, making it easier to control the film thickness during sputtering. The upper limit of the maximum value of the crystal orientation distribution function can be, for example, 50 or less, 40 or less, or 30 or less. The upper limit of the maximum value of the crystal orientation distribution function may be 2.0 or more and 50 or less, 2.0 or more and 40 or less, or 2.5 or more and 30 or less.

The maximum value of the crystal orientation distribution function may be the maximum value of the orientation density.

The maximum value of the crystal orientation distribution function in the present embodiment is the maximum value of the crystal orientation distribution function (hereinafter, also referred to as "ODF") obtained from an SEM observation image obtained by the same method as in the measurement of the degree of orientation. That is, the SEM observation image is analyzed, and the crystal orientations at all measurement points are expressed as Euler angles based on Bunge notation ($\varphi1$, $\Phi$, $\varphi2$). Next, for the Euler angles, the crystal orientation distribution function (ODF) is calculated using an expansion order of 22 as spherical harmonics and a Gaussian half-width of 5°. In orientation groups of $\varphi1$: $k°$ $(0 \leq k \leq 90)$, $\Phi$: $x°$ $(0 \leq x \leq 90)$, and $\varphi2$: $y°$ $(0 \leq y \leq 90)$, the ODF is calculated at 5° intervals, and the maximum value thereof may be taken as the maximum value of the crystal orientation distribution function.

A general analysis program (for example, Aztec Crystal) may be used to analyze the crystal orientation of the SEM observation image and calculate the ODF.

<Method for Producing Metal Sputtering Target>

A method for producing the target of the present embodiment is not particularly limited. A method for producing the target preferably includes a pressing step of subjecting an ingot made of a metal having a body-centered cubic structure or a face-centered cubic structure to pressing treatment at a pressing temperature of 500°C or higher using a buffer member including a buffer layer to obtain a processed ingot; and a heat treatment step of heat-treating the processed ingot at 900°C or higher.

In the pressing step, for example, an ingot made of a metal having a body-centered cubic structure or a face-centered cubic structure is subjected to pressing treatment at a pressing temperature of 500°C or higher and a pressing speed of less than 15 mm/s to obtain a processed ingot.

The ingot to be subjected to the pressing step may be an ingot made of a metal having a body-centered cubic structure or a face-centered cubic structure, and is preferably an ingot made of one or more selected from the group consisting of chromium (Cr), iron (Fe), ruthenium (Ru), niobium (Nb), molybdenum (Mo), tantalum (Ta), vanadium (V), tungsten (W), aluminum (Al), copper (Cu), and nickel (Ni), more preferably an ingot made of one or more selected from the group consisting of chromium, molybdenum, ruthenium, and tungsten, still more preferably an ingot made of one or more selected from the group consisting of chromium, molybdenum, and tungsten, even more preferably an ingot made of at least one of chromium and molybdenum, and particularly preferably an ingot made of molybdenum.

The ingot may be an ingot made of an alloy, and examples thereof can include an ingot made of an alloy containing one or more selected from the group consisting of chromium, iron, ruthenium, niobium, molybdenum, tantalum, vanadium, tungsten, aluminum, copper, and nickel, an ingot made of an alloy containing one or more selected from the group consisting of chromium, molybdenum, tantalum, vanadium, and tungsten, an ingot made of an alloy containing one or more selected from the group consisting of chromium, molybdenum, and tungsten, an alloy containing chromium and molybdenum, an ingot made of an alloy containing molybdenum, and an ingot made of a chromium-molybdenum alloy.

The purity of the ingot to be subjected to the pressing step need only be equivalent to that of the metal contained in the target. Preferably, the purity and oxygen content of the ingot to be subjected to the pressing step are the same as those of the target described above.

The relative density of the ingot to be subjected to the pressing step is preferably 99% or more, or 99.5% or more. This tends to increase the strength of the resulting metal material.

The relative density of the ingot can be, for example, 100% or less. The relative density of the ingot can be, for example, 99% or more and 100% or less, or 99.5% or more and 100% or less.

The average crystal grain size of the ingot to be subjected to the pressing step is, but not limited to, for example, more than 20 $\mu$m, or 30 $\mu$m or more. The average crystal grain size of the ingot can be, for example, 2000 $\mu$m or less, 1000 $\mu$m or less, or 400 $\mu$m or less, and can be, for example, more than 20 $\mu$m and 2000 $\mu$m or less, more than 20 $\mu$m and 1000 $\mu$m or less, or 30 $\mu$m or more and 1000 $\mu$m or less.

The maximum value of the orientation distribution function of the ingot to be subjected to the pressing step can be, for example, 5.0 or less. The orientation distribution function can be determined in the same manner as the crystal orientation distribution function of the target. This improves the uniformity of the structure after the pressing step, and tends to increase the in-plane orientation. The maximum value of the orientation distribution function of the ingot can be, for example, 1.2 or more, 2.0 or more, or 2.5 or more, and can be, for example, 1.2 or more and 5.0 or less, 2.0 or more and 5.0 or less, or 2.5 or more and 5.0 or less.

In order to inhibit non-uniform deformation of the ingot and inhibit the in-plane anisotropy of the crystal structure, the ingot is pressed using a buffer member having a buffer layer in the pressing step. That is, in the processing step, the ingot may be pressed while covered with two buffer members. Here, for example, one of the two buffer members is a first buffer member made of a buffer layer, and the other buffer member is a second buffer member including a buffer layer and a cylindrical sidewall portion provided on the buffer layer. In this case, the ingot is pressed while being placed in a container formed using the first buffer member and the second buffer member. The first buffer member and the second buffer member are preferably welded together by electron beam welding or the like in a vacuum atmosphere. At this time, the atmosphere inside the container is preferably a vacuum atmosphere.

The material of each buffer layer may be any material that can inhibit deformation of, for example, the surface, where stress is concentrated when the pressing treatment is performed together with the ingot during pressing processing. The buffer layer includes a main body portion. The material of the main body portion of the buffer layer may be a metal having a yield stress within ±50% of the yield stress of the ingot. For example, for a chromium ingot having a yield stress of 400 MPa, the metal may have a yield stress of 200 MPa or more and 600 MPa or less. Specific examples thereof include a buffer layer made of a chromium-free steel material, a buffer layer having a main body portion made of rolled steel, and a buffer layer having a main body portion made of carbon steel (SS400) or carbon steel (SN490B).

In order to inhibit uneven deformation of the ingot, the total thickness of the buffer layers of the buffer members arranged on both sides of the ingot is preferably 30% or more, more preferably 40% or more, of the thickness of the ingot. The thickness of each buffer layer can be, but is not particularly limited to, for example, 160% or less, 140% or less, or 100% or less of the thickness of the ingot in order to inhibit deformation of the buffer layer itself due to pressure. The proportion of the thickness of the buffer layer to the thickness of the ingot is preferably 30% or more and 160% or less, more preferably 30% or more and 140% or less, and still more preferably 40% or more and 100% or less.

Since bonding (thermocompression bonding) between the ingot and the buffer layer during processing is inhibited, the buffer layer is preferably coated. That is, the buffer layer preferably includes a main body portion and a coating provided on a surface of the main body portion. Examples of the buffer layer having a coating include a buffer layer having one or more selected from the group consisting of a powder coating, a glass coating, an oil-based lubricant coating, and a graphite lubricant coating. A buffer layer having a graphite lubricant coating is preferred because it is highly effective in preventing thermocompression bonding.

The coating is preferably subjected to heat treatment in a non-oxidizing atmosphere. By performing heat treatment in a non-oxidizing atmosphere, a portion of the coating is altered, improving the heat resistance of the coating. Examples of the non-oxidizing atmosphere include a vacuum atmosphere, an argon atmosphere, a nitrogen atmosphere, and an argon + nitrogen atmosphere. A vacuum atmosphere is preferable.

When the coating is a graphite lubricant coating, i.e., when the coating is obtained by heat treatment of a graphite lubricant, the heat treatment temperature can be, for example, 200°C or higher, 225°C or higher, 250°C or higher, or 300°C or higher, and can be, for example, 450°C or lower, 400°C or lower, or 350°C or lower. When the heat treatment temperature is within the above range, the adhesion between the buffer layer and the ingot is improved, and thermocompression bonding during the pressing treatment can be inhibited. The heat treatment temperature can be, for example, 200°C or higher and 450°C or lower, 225°C or higher and 400°C or lower, or 250°C or higher and 350°C or lower.

When the coating is obtained using a graphite lubricant, the viscosity of the coating liquid containing the graphite lubricant is, for example, 10 Pa·s or more, or 20 Pa·s or more. The viscosity may be measured using a conventional cylindrical rotational viscometer in accordance with JIS Z 8803 (for example, a rotational viscometer VT-06 Viscotester, manufactured by Riontech Co., Ltd.). The upper limit of the viscosity can be, but is not particularly limited to, for example, 100 Pa·s or less, or 50 Pa·s or less, or can be 10 Pa·s or more and 100 Pa·s or less, or 20 Pa·s or more and 50 Pa·s or less.

In the pressing step, the ingot is pressed at a pressing temperature of 500°C or higher. The pressing temperature is preferably 600°C or higher or 700°C or higher. The pressing temperature is preferably 1000°C or lower or 900°C or lower, in order to inhibit the occurrence of defects, such as cracks, during the pressing treatment. The pressing temperature is preferably 500°C or higher and 1000°C or lower, more preferably 600°C or higher and 1000°C or lower, and still more preferably 700°C or higher and 900°C or lower.

The method for the pressing treatment may be any method by which pressure can be applied to the ingot. Examples thereof include one or more methods selected from the group consisting of forging, drawing, extrusion, and rolling.

In the pressing treatment, it is preferable to apply pressure to the ingot so that the ratio of the length of the ingot in the X-direction to the length of the ingot in the Z-direction (hereinafter, also referred to as a "dimensional ratio") is 0.5 or more or 0.6 or more, where the direction in which pressure is applied to the ingot is the Z-direction and the direction perpendicular to the Z-direction is the X-direction. This facilitates uniform deformation of the ingot. When the ingot is pressed in such a manner that the dimensional ratio is 8 or less or 4 or less, the formation of cracks due to deformation is further inhibited. The dimensional ratio of the ingot before the pressing treatment is more preferably 0.5 or more and 8 or less, or 0.6 or more and 4 or less. When the ingot is a polyhedron such as a rectangular parallelepiped, it is preferable that both the dimensional ratio calculated from the ratio of the maximum length of the ingot in the X-direction to the length of the ingot in the Z-direction and the dimensional ratio calculated from the ratio of the minimum length of the ingot in the X-direction to the length of the ingot in the Z-direction satisfy the above-mentioned values.

The pressing treatment in the pressing step is preferably performed two or more times, more preferably three or more times. When the pressing treatment under the above conditions is performed multiple times, strain can be introduced into the target without causing defects such as cracks in the ingot. As a result, a target with a high orientation area fraction (degree of orientation) is easily obtained. The pressing treatment is preferably performed 20 times or less because the surface and interior of the resulting target tend to have a more uniform structure. The pressing treatment is preferably performed 2 or more times and 20 or less times, more preferably 3 or more times and 20 or less times.

The temperature of the ingot may decrease before and after the pressing treatment. When multiple pressing treatments are included in the pressing step, it is preferable to heat the ingot to the pressing temperature before each pressing treatment, in order to inhibit a decrease in the temperature of the ingot.

The total reduction ratio of the processed ingot after the pressing step is preferably 50% or more, or 60% or more. The upper limit of the total reduction ratio is, for example, 95% or less or 90% or less. The total reduction ratio is preferably 50% or more and 95% or less, more preferably 60% or more and 95% or less, and still more preferably 60% or more and 90% or less. The total reduction ratio can be calculated using the following formula.

Total reduction ratio [%] = (1 - thickness of pressed ingot/thickness of ingot before processing step) $\times$ 100

In the heat treatment step, the processed ingot is preferably heat-treated at a heat treatment temperature of 900°C or higher. When the heat treatment temperature is lower than 900°C, it is difficult to align the orientation.

In the heat treatment, the heat treatment temperature is more preferably 1500°C or higher. The heat treatment temperature does not need to be higher than necessary, and may be 2200°C or lower, or 2000°C or lower. The heat treatment temperature is preferably 900°C or higher and 2200°C or lower, more preferably 1500°C or higher and 2000°C or lower.

The heat treatment atmosphere may be any atmosphere, such as an air atmosphere, an inert atmosphere, a reducing atmosphere, or a vacuum atmosphere, and is preferably an inert atmosphere, a reducing atmosphere, or a vacuum atmosphere. The heat treatment atmosphere is more preferably a reducing atmosphere or a vacuum atmosphere.

The heat treatment time may be adjusted appropriately in accordance with the size of the processed ingot to be subjected to the heat treatment step, the performance of the heat treatment furnace, and the like, and may be, for example, 1 hour or more and 5 hours or less.

In order to form the target to be obtained into a predetermined shape, the production method of the present embodiment may include a processing step of processing the processed ingot prior to the heat treatment step. Any processing method may be used, for example, cutting.

In order to reduce the surface roughness of the target, the production method of the present embodiment may further include a surface processing step of processing the surface of the metal material after the heat treatment step.

<<Metal Sputtering Target Structure>>

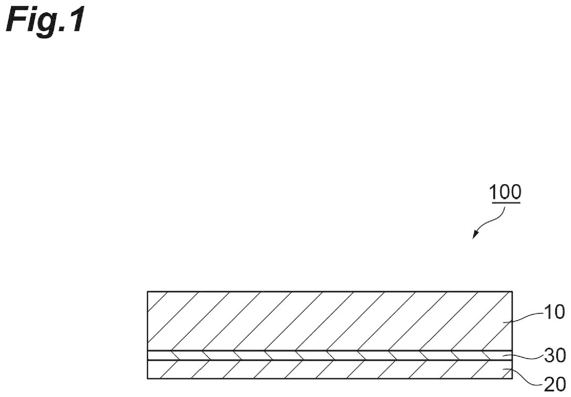

As illustrated in Fig. 1, a metal sputtering target structure (hereinafter, also referred to as "target structure") 100 of the present embodiment includes a target 10 and a backing plate 20. The target 10 is composed of the target described above.

This target structure 100 is also suitable for forming a film with a uniform thickness by sputtering.

The backing plate 20 may be made of any material that can conduct electricity and dissipate heat during sputtering, and examples thereof include backing plates made of one or more selected from the group consisting of copper (Cu), aluminum (Al), titanium (Ti), and SUS.

The backing plate 20 may be bonded directly to the target 10 or may be bonded via a bonding material 30 as illustrated in Fig. 1. The bonding material 30 may be any known material, such as indium (In).

The target structure 100 of the present embodiment can be produced by a production method including a bonding step of bonding the target 10 and the backing plate 20 together.

The bonding method in the bonding step may be any method that can bond the backing plate 20 and the target 10, and examples thereof include one or more methods selected from the group consisting of diffusion bonding, solder bonding, and friction stir welding.

<<Film-Forming Method>>

A method for producing a film (film-forming method) of the present embodiment is a method in which the target or target structure of the present embodiment is used. That is, the target or target structure of the present embodiment can be used in a method for producing a film using it.

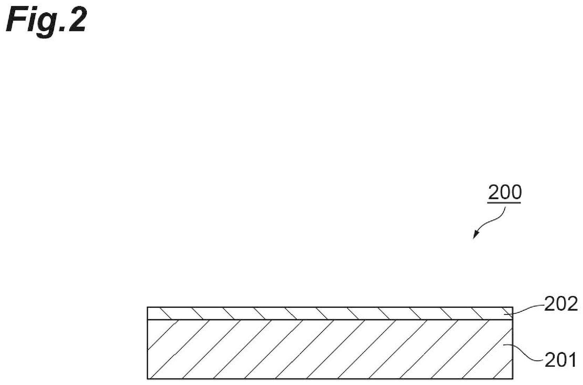

The film 202 is formed by a sputtering method. That is, the method for producing a film of the present embodiment is a method for producing a film-attached substrate 200 by sputtering the target 10 of the present embodiment to produce the film 202 on a substrate 201 (see Fig. 2).

The film 202 is obtained by the method for producing a film of the present embodiment. The film 202 may be a thin film or a sputtered film (film formed by sputtering).

The substrate 201 is not particularly limited, and examples thereof include a silicon substrate, a glass substrate, and a quartz substrate.

The temperature of the substrate 201 (film formation temperature) is not particularly limited, but may be, for example, room temperature (25°C).

The process gas used in film formation is not particularly limited as long as it is a gas species that causes sputtering by discharge, and may be, for example, argon.

The gas pressure during film formation is not particularly limited, but may be, for example, 0.1 Pa or more and 1 Pa or less.

The acceleration voltage during film formation is not particularly limited, but may be, for example, 1 kV or more and 3 kV or less.

The film formation time is not particularly limited, but may be, for example, 10 minutes or more and 60 minutes or less.

Sputtering can be carried out using a general sputtering apparatus.

Any method for producing the film (film formation method) may be used, but examples thereof include a method for producing the film under the following conditions.

Ultimate vacuum: $1 \times 10^{-4}$ Pa
Process gas: argon (Ar)
Gas partial pressure: 0.5 Pa
Film formation temperature: room temperature (25°C)
Substrate: Si substrate
Accelerating voltage: 2 kV

EXAMPLES

The present disclosure will be described below with reference to Examples. However, the present disclosure is not limited to the following Examples.

(Degree of Orientation)

The degree of orientation of the plane orientation was determined as follows.

First, a SEM-EBSD apparatus (apparatus name: JSM-IT800, manufactured by JEOL Ltd.) and a measurement program (software name: AZtec), and an analysis program (software name: AZtec Crystal) were used. SEM observation images were obtained by SEM-EBSD measurement under the following conditions for the metal sputtering targets produced in the Examples and Comparative Examples below.

Observation magnification: 10×
Accelerating voltage: 20 kV
Probe current: 100 $\mu$A
Working distance: 10 mm
Step size: 5 $\mu$m

Then, the SEM observation image was divided into a 5 $\mu$m × 5 $\mu$m grid to define grid points, and each grid point was set as a measurement point. The orientation plane and its area were measured for each measurement point, and the intensity in an inverse pole figure space obtained from each measurement point was determined to identify a plane orientation having the highest intensity (dominant plane orientation). Measurement points having an orientation (plane orientation) within 15° from the plane orientation were selected, and the degree of orientation [% by area] was determined from the proportion by area relative to all measurement points.

The above SEM-EBSD measurement was performed for a metal sputtering target obtained as follows. That is, first, the radius of the circular sputtering surface (sputtering surface) of the disk-shaped target was defined as R. A region having a width of 3 mm was defined inward in a radial direction from a position at a distance of 0.7R from the center of the circle, and a cross-sectional portion having dimensions of 3 mm in width × the total target thickness t (mm) and being perpendicular to the sputtering surface was observed. After the cross-sectional portion (a portion serving as a measurement surface) was mirror-polished using SiC abrasive paper and buff polishing, pretreatment was performed by electrolytic etching in a 5% by volume aqueous sulfuric acid solution to obtain a measurement region. The SEM-EBSD measurement was then performed on the measurement region.

(Crystal Orientation Distribution Function)

The SEM observation image obtained in the measurement of the degree of orientation was used to analyze the measurement results at all measurement points in the SEM observation image with an analysis program (AZtec Crystal), thereby obtaining a crystal orientation at each measurement point, and the crystal orientation was expressed as Euler angles. Bunge notation ($\varphi$1, $\Phi$, $\varphi$2) was used for the Euler angles. Based on the obtained Euler angles at the respective measurement points, a crystal orientation distribution function (ODF) was calculated using the analysis program (AZtec Crystal), with an expansion order of 22 as spherical harmonics and a Gaussian half-width of 5°. The obtained crystal orientation distribution function was calculated in orientation groups of $\varphi$1: k° ($0 \leq k \leq 90$), $\Phi$: x° ($0 \leq x \leq 90$), and $\varphi$2: y° ($0 \leq y \leq 90$), and the maximum value thereof and the average value of orientation density in the range of k = 0 to 90 for all combinations of (x, y) were calculated. In calculating the maximum value and the average value of the crystal orientation distribution function, x, y, and k were each output at 5° increments.

(Oxygen Content)

The oxygen content was measured using an oxygen/nitrogen analyzer (model name: ON736, manufactured by LECO Corporation). As a measurement sample, a metal material cut into a rectangular prism having dimensions of 4 mm × 4 mm × 5 mm was used.

(Area of Sputtering Surface)

The area of the sputtering surface was calculated by measuring the diameter R of the sputtering surface with a vernier caliper and using the following equation.

$$\text{Area of sputtering surface} = \pi \times (R/2)^2$$

(Viscosity)

The viscosity of the coating liquid was measured with a cylindrical rotational viscometer (rotational viscometer VT-06 Viscotester, manufactured by Riontech Co., Ltd.) in accordance with JIS Z 8803.

Measurement temperature: room temperature (25°C)
Rotational speed: 62.5 rpm

(Example 1)

A total of 210 kg of molybdenum powder (purity: 5N) was sealed in a mild-steel can having dimensions of 350 mm × 350 mm × 350 mm, and HIP treatment was performed under the following conditions.

HIP treatment atmosphere: argon gas atmosphere
HIP treatment temperature: 1250°C
HIP treatment pressure: 150 MPa
HIP treatment time: 5 hours

The obtained HIP body was ground and cut to adjust its shape, thereby obtaining a disk-shaped ingot having a diameter of 180 mm and a thickness of 50 mm (dimensional ratio: 3.6). This ingot was used as the molybdenum material of this Example. The ingot had an average crystal grain size of 22.7 μm, and the maximum value of the ODF was 3.7.

As buffer members for the ingot, a first buffer member and a second buffer member were prepared. As the first buffer member, a buffer layer was used. The buffer layer was obtained by mixing an oil-based lubricant (manufactured by Nippon Graphite Industries, Co., Ltd., product name: Rolling Oil, viscosity: 24 Pa·s) containing 30% or more graphite with water to prepare a coating liquid having a viscosity of 20 Pa·s, applying the coating liquid to the surface of a disk-shaped member (thickness: 25 mm, diameter: 240 mm) made of SS400, and performing heat treatment in a vacuum atmosphere at a heat treatment temperature of 300°C for 30 minutes. As the second buffer member, a cylindrical box-shaped buffer member was used. The box-shaped cylindrical buffer member was obtained by using a cylindrical member composed of a disk-shaped buffer layer (thickness: 25 mm, diameter: 240 mm) made of SS400 and a cylindrical sidewall portion having a height of 55 mm extending from the peripheral portion of the surface of the buffer layer, applying the above coating liquid to the surface of the buffer layer and the inner peripheral surface of the sidewall portion, and performing heat treatment for 30 minutes at a heat treatment temperature of 300°C in a vacuum atmosphere. Then, the ingot was placed on the surface of the buffer layer of the second buffer member. The first buffer member was placed on the sidewall portion of the second buffer member so as to cover the ingot, thereby forming a container. The inside of the container was set to a vacuum atmosphere, and sealing was performed by welding the first buffer member and the second buffer member by electron beam welding. The thickness of the buffer layers disposed on both sides of the ingot (the total of the thickness of the buffer layer of the first buffer member and the thickness of the buffer layer of the second buffer member) was 100% relative to the thickness of the ingot.

The ingot placed in the cylindrical box-shaped buffer layer was heated to 800°C, and then the heated ingot was subjected to a pressing treatment in which pressure was applied in the thickness direction of the ingot at a pressing speed of 7 mm/s. Specifically, the pressing treatment was performed in such a manner that a length in a direction in which pressure was applied to the ingot (Z-direction) was 50 mm and a length in a direction perpendicular to the Z-direction (X-direction) was 180 mm. This pressing treatment was repeated 16 times to obtain an ingot (processed ingot) having a diameter of 330 mm and a thickness of 15 mm (total reduction ratio: 85%). During the repeated pressing treatments, when the temperature of the ingot after each pressing treatment was 450°C or lower, the ingot was reheated to 800°C and then subjected to the pressing treatment.

The processed ingot was treated at 1500°C for 3 hours in an argon atmosphere to obtain a disk-shaped molybdenum sputtering target having a diameter of 330 mm and a thickness of 15 mm. This target was used as the molybdenum sputtering target of this Example. The dominant plane orientation, degree of orientation, and maximum value of the ODF of this molybdenum sputtering target were as presented in Table 1.

(Example 2)

A molybdenum sputtering target was produced in the same manner as in Example 1, except that the molybdenum ingot was obtained in the same manner as in Example 1, the obtained ingot was ground and cut to adjust its shape to have a diameter of 180 mm and a thickness of 55 mm (dimensional ratio: 3.3), the ingot was subjected to a pressing treatment with the ratio of the thickness of the buffer layers to the thickness of the ingot set to 91%, and the total reduction ratio was set to 70%, so that the dominant plane orientation, degree of orientation, and maximum value of the ODF were as presented in Table 1.

(Example 3)

Chromium powder (purity: 4N) was sealed in a mild-steel can having dimensions of 350 mm × 350 mm × 350 mm, and HIP treatment was performed under the following conditions.

HIP treatment atmosphere: argon gas atmosphere
HIP treatment temperature: 1150°C
HIP treatment pressure: 100 MPa
HIP treatment time: 2 hours

The obtained HIP body was ground and cut to adjust its shape, thereby obtaining a disk-shaped chromium ingot having a diameter of 180 mm and a thickness of 60 mm. The ingot had an average crystal grain size of 116.4 $\mu$m, and the maximum value of the ODF was 1.3.

A pressed ingot was obtained in the same manner as in Example 1, except that the obtained ingot was ground and cut to adjust its shape to have a diameter of 90 mm and a thickness of 60 mm (dimensional ratio: 1.5), the ingot was subjected to a pressing treatment with the thickness of the buffer layers set to 83% relative to the thickness of the ingot, and the pressing treatment was performed eight times.

The processed ingot was treated at 1600°C for 1 hour in an argon atmosphere, and was ground and cut to adjust its shape, thereby obtaining a chromium sputtering target. This target was used as the chromium sputtering target of this Example. The dominant plane orientation, degree of orientation, and maximum value of the ODF of this chromium sputtering target were as presented in Table 1.

(Example 4)

A pressed ingot was obtained in the same manner as in Example 1, except that a chromium ingot was obtained in the same manner as in Example 3, the obtained ingot was ground and cut to adjust its shape to have a diameter of 60 mm and a thickness of 90 mm (dimensional ratio: 0.67), SN490B was used in place of SS400 as the disk-shaped member, the ratio of the thickness of the buffer layers to the thickness of the ingot was set to 56%, the ingot temperature was set to 1000°C, the pressing treatment was performed eight times, and the total reduction ratio was set to 70%, so that the dominant plane orientation, degree of orientation, and maximum value of the ODF were as presented in Table 1.

The processed ingot was treated at 1000°C for 1 hour in an air atmosphere to produce a chromium sputtering target.

(Example 5)

A pressed ingot was obtained in the same manner as in Example 1, except that a chromium ingot was obtained in the same manner as in Example 3, the obtained ingot was ground and cut to adjust its shape to have a diameter of 120 mm and a thickness of 40 mm (dimensional ratio: 3.0), the heat treatment temperature of the buffer members was set to 400°C, the ratio of the thickness of the buffer layers to the thickness of the ingot was set to 125%, and the total reduction ratio was set to 70%, so that the dominant plane orientation, degree of orientation, and maximum value of the ODF were as presented in Table 1.

The resulting processed ingot was treated at 1000°C for 1 hour in an air atmosphere to produce a chromium sputtering target.

(Example 6)

A molybdenum sputtering target was produced in the same manner as in Example 1, except that the obtained HIP body was ground and cut to adjust its shape to have a diameter of 180 mm and a thickness of 55 mm (dimensional ratio: 3.3), the heat treatment temperature of the buffer members was set to 250°C, the ratio of the thickness of the buffer layers to the thickness of the ingot was set to 91%, and the total reduction ratio was set to 70%, so that the dominant plane orientation, degree of orientation, and maximum value of the ODF were as presented in Table 1.

(Example 7)

A molybdenum sputtering target was produced in the same manner as in Example 1, except that the obtained HIP body was ground and cut to adjust its shape to have a diameter of 180 mm and a thickness of 55 mm (dimensional ratio: 3.3), the buffer layers were used in which the thickness of SS400 was changed from 25 mm to 10 mm, the ratio of the thickness of the buffer layers to the thickness of the ingot was set to 36%, and the total reduction ratio was set to 70%, so that the dominant plane orientation, degree of orientation, and maximum value of the ODF were as presented in Table 1.

(Comparative Example 1)

A total of 210 kg of molybdenum powder (purity: 5N) was sealed in a mild-steel can having dimensions of 350 mm × 350 mm × 350 mm, and HIP treatment was performed under the following conditions.

HIP treatment atmosphere: argon gas atmosphere
HIP treatment temperature: 1250°C
HIP treatment pressure: 150 MPa
HIP treatment time: 5 hours

The obtained HIP body was ground and cut to adjust its shape, thereby obtaining a disk-shaped ingot having a diameter of 180 mm and a thickness of 50 mm.

As buffer layers for the ingot, a first buffer member and a second buffer member were prepared. A buffer layer used as the first buffer member was prepared by mixing an oil-based lubricant (manufactured by Nippon Graphite Industries, Co., Ltd., product name: Rolling Oil, viscosity: 24 Pa·s) containing 30% or more graphite with water to prepare a coating liquid having a viscosity of 20 Pa·s, applying the coating liquid to the surface of a disk-shaped member (thickness: 25 mm, diameter: 240 mm) made of SS400, and performing heat treatment in air at a heat treatment temperature of 300°C for 30 minutes. As the second buffer member, a cylindrical box-shaped buffer member was used. The box-shaped cylindrical buffer member was obtained by using a cylindrical member composed of a disk-shaped buffer layer (thickness: 25 mm, diameter: 240 mm) made of SS400 and a cylindrical sidewall portion having a height of 55 mm extending from the peripheral portion of the surface of the buffer layer, applying the above coating liquid to the surface of the buffer layer and the inner peripheral surface of the sidewall portion of the cylindrical member, and performing heat treatment for 30 minutes at a heat treatment temperature of 300°C in air. Then, the ingot was placed on the surface of the buffer layer of the second buffer member. The first buffer member was placed on the sidewall portion of the second buffer member so as to cover the ingot, thereby forming a container. The inside of the container was set to a vacuum atmosphere, and sealing was performed by welding the first buffer member and the second buffer member by electron beam welding. The ratio of the thickness of the buffer layers to the thickness of the ingot was 100%.

The resulting ingot was heated to 800°C, and then the heated ingot was subjected to a pressing treatment in which pressure was applied in the thickness direction of the ingot at a pressing speed of 7 mm/s. This pressing treatment was repeated 16 times to obtain an ingot (processed ingot) having a diameter of 330 mm and a thickness of 15 mm (total reduction ratio: 70%). During the repeated pressing treatments, when the temperature of the ingot after each pressing treatment was 450°C or lower, the ingot was reheated to 800°C and then subjected to the pressing treatment.

The processed ingot was treated at 1500°C for 3 hours in an argon atmosphere to obtain a disk-shaped molybdenum sputtering target having a diameter of 330 mm and a thickness of 15 mm. This target was used as the molybdenum sputtering target of this Comparative Example. The dominant plane orientation, degree of orientation, and maximum value of the ODF of this molybdenum sputtering target were as presented in Table 1.

(Comparative Example 2)

A pressed ingot was obtained in the same manner as in Example 1, except that a chromium ingot was obtained in the same manner as in Example 3, the chromium ingot was ground and cut to adjust its shape to have a diameter of 200 mm and a thickness of 50 mm (dimensional ratio: 4.0), the buffer members were used in which the thickness of SS400 was changed from 25 mm to 7 mm, the ratio of the thickness of the buffer layers to the thickness of the ingot was set to 28%, and the total reduction ratio was set to 80%, so that the dominant plane orientation, degree of orientation, and maximum value of the ODF were as presented in Table 1.

The resulting processed ingot was treated at 1000°C for 1 hour in an air atmosphere to produce a chromium sputtering target.

(Comparative Example 3)

A pressed ingot was obtained in the same manner as in Example 1, except that a chromium ingot was obtained in the same manner as in Example 3, the chromium ingot was ground and cut to adjust its shape to have a diameter of 90 mm and a thickness of 30 mm (dimensional ratio: 3.0), no buffer member was used, the pressing treatment was repeated eight times, the ratio of the thickness of the buffer layers to the thickness of the ingot was set to 167%, and the total reduction ratio was set to 70%, so that the dominant plane orientation, degree of orientation, and maximum value of the ODF were as presented in Table 1.

The resulting processed ingot was treated at 1000°C for 1 hour in an air atmosphere to produce a chromium sputtering target.

(Comparative Example 4)

A pressed ingot was obtained in the same manner as in Example 1, except that a chromium ingot was obtained in the same manner as in Example 3, the chromium ingot was ground and cut to adjust its shape to have a diameter of 80 mm and a thickness of 40 mm (dimensional ratio: 2.0), the buffer members were used in which SS400 was replaced with cast iron (FC200, thickness: 25 mm), the ratio of the thickness of the buffer layers to the thickness of the ingot was set to 167%, and the total reduction ratio was set to 80%, so that the dominant plane orientation, degree of orientation, and maximum value of the ODF were as presented in Table 1.

The resulting processed ingot was treated at 1000°C for 1 hour in an air atmosphere to produce a chromium sputtering target.

(Comparative Example 5)

A pressed ingot was obtained in the same manner as in Example 1, except that a chromium ingot was obtained in the same manner as in Example 3, the chromium ingot was ground and cut to adjust its shape to have a diameter of 75 mm and a thickness of 25 mm (dimensional ratio: 3.0), a BN-based release agent (manufactured by Advanced Technical Products; model number: ATP-R33) was used as the coating liquid, the ratio of the thickness of the buffer layers to the thickness of the ingot was set to 200%, and the total reduction ratio was set to 65%, so that the dominant plane orientation, degree of orientation, and maximum value of the ODF were as presented in Table 1.

The resulting processed ingot was treated at 1000°C for 1 hour in an air atmosphere to produce a chromium sputtering target.

(Comparative Example 6)

A pressed ingot was obtained in the same manner as in Example 1, except that a chromium ingot was obtained in the same manner as in Example 3 and the chromium ingot was ground and cut to adjust its shape to have a diameter of 70 mm and a thickness of 30 mm (dimensional ratio: 2.3), the heat treatment temperature of the buffer members was set to 500°C, the ratio of the thickness of the buffer layers to the thickness of the ingot was set to 167%, and the total reduction ratio was set to 70%, so that the dominant plane orientation, degree of orientation, and maximum value of the ODF were as presented in Table 1.

The resulting processed ingot was treated at 1000°C for 1 hour in an air atmosphere to produce a chromium sputtering target.

(Comparative Example 7)

A total of 210 kg of molybdenum powder (purity: 4N) was sealed in a mild-steel can having dimensions of 350 mm $\times$ 350 mm $\times$ 350 mm, and HIP treatment was performed under the following conditions.

HIP treatment atmosphere: argon gas atmosphere
HIP treatment temperature: 1250°C
HIP treatment pressure: 150 MPa
HIP treatment time: 5 hours

The obtained HIP body was plastically worked, ground, and cut to adjust its shape, thereby obtaining a disk-shaped ingot having a diameter of 180 mm and a thickness of 50 mm (dimensional ratio: 3.6). This ingot was used as the molybdenum material of this Comparative Example. The ingot had an average crystal grain size of 20.5 $\mu$m, and the maximum value of the ODF was 7.3.

A pressed ingot was obtained in the same manner as in Example 1, except that this ingot was subjected to pressing treatment, and the total reduction ratio was set to 70%, so that the dominant plane orientation, degree of orientation, and maximum value of the ODF were as presented in Table 1.

The resulting processed ingot was treated at 1500°C for 3 hours in an argon atmosphere to produce a molybdenum sputtering target.

(Comparative Example 8)

A pressed ingot was obtained in the same manner as in Example 1, except that the obtained HIP body was ground and cut to adjust its shape to have a diameter of 180 mm and a thickness of 55 mm (dimensional ratio: 3.3), a coating liquid having a viscosity of 2 Pa·s was prepared by mixing water with an oil-based lubricant containing 30% or more graphite (manufactured by Nippon Graphite Industries, Co., Ltd., product name: Rolling Oil, viscosity: 24 Pa·s), and the coating liquid was used, the ratio of the thickness of the buffer layers to the thickness of the ingot was set to 91%, and the total reduction ratio was set to 70%, so that the dominant plane orientation, degree of orientation, and maximum value of the ODF were as presented in Table 1.

The resulting processed ingot was treated at 1500°C for 3 hours in an argon atmosphere to produce a molybdenum sputtering target.

The evaluation results of the molybdenum sputtering targets and chromium sputtering targets obtained in the Examples and Comparative Examples are presented in Table 1 below.

[Table 1]

| | Dominant plane orientation | Degree of orientation | Maximum value of ODF | Purity | Oxygen content |
|---|---|---|---|---|---|
| | | [% by area] | | [%] | [ppm by mass] |
| Example 1 | 111 | 51.3 | 7.0 | 99.999% | 20 |
| Example 2 | 111 | 94.5 | 25.1 | 99.999% | 20 |
| Example 3 | 111 | 94.2 | 31.5 | 99.990% | 31 |
| Example 4 | 114 | 58.0 | 2.0 | 99.990% | 48 |
| Example 5 | 111 | 38.0 | 7.2 | 99.990% | 10 |
| Example 6 | 111 | 76.9 | 15.3 | 99.999% | 20 |
| Example 7 | 111 | 81.8 | 20.1 | 99.999% | 20 |
| Comparative Example 1 | 001 | 43.4 | 7.5 | 99.999% | 20 |
| Comparative Example 2 | 114 | 35.2 | 2.8 | 99.990% | 48 |
| Comparative Example 3 | 001 | 20.3 | 3.1 | 99.990% | 40 |
| Comparative Example 4 | 111 | 27.9 | 4.6 | 99.990% | 48 |
| Comparative Example 5 | 104 | 33.2 | 3.8 | 99.990% | 10 |
| Comparative Example 6 | 111 | 31.4 | 4.6 | 99.990% | 40 |
| Comparative Example 7 | 111 | 42.4 | 16.2 | 99.990% | 10 |
| Comparative Example 8 | 111 | 64.1 | 9.2 | 99.999% | 20 |

The molybdenum sputtering targets and chromium sputtering targets of the Examples were confirmed to each have a degree of orientation of 35% or more by area and a maximum value of the ODF of 2 or more. In contrast, in each of Comparative Examples 3 to 6, the degree of orientation was less than 35% by area.

It was confirmed that in the molybdenum sputtering targets and chromium sputtering targets of Examples 1 to 7, the number of (x, y) combinations for which the average orientation density was 1.2 or more was 110 points in Example 1, 35 points in Example 2, 21 points in Example 3, 157 points in Example 4, 88 points in Example 5, 38 points in Example 6, and 36 points in Example 7, and that the coefficients of variation for all of those (x, y) combinations were 0.5 or less. In contrast, in the molybdenum sputtering targets of Comparative Examples 1, 2, 4, 7, and 8, there were cases where the coefficient of variation for (x, y) combinations for which the average orientation density was 1.2 or more was more than 0.5.

Tables 2A and 2B present the average orientation density of Example 1, and Tables 3A and 3B present the coefficient of variation of (x, y) combinations in Example 1 for which the average orientation density is 1.2 or more.

Tables 4A and 4B present the average orientation density of Example 2, and Tables 5A and 5B present the coefficient of variation of (x, y) combinations in Example 2 for which the average orientation density is 1.2 or more.

Tables 6A and 6B present the average orientation density of Example 3, and Tables 7A and 7B present the coefficient of variation of (x, y) combinations in Example 3 for which the average orientation density is 1.2 or more.

Tables 8A and 8B present the average orientation density of Example 4, and Tables 9A and 9B present the coefficient of variation of (x, y) combinations in Example 4 for which the average orientation density is 1.2 or more.

Tables 10A and 10B present the average orientation density of Example 5, and Tables 11A and 11B present the coefficient of variation of (x, y) combinations in Example 5 for which the average orientation density is 1.2 or more.

Tables 12A and 12B present the average orientation density of Example 6, and Tables 13A and 13B present the coefficient of variation of (x, y) combinations in Example 6 for which the average orientation density is 1.2 or more.

Tables 14A and 14B present the average orientation density of Example 7, and Tables 15A and 15B present the coefficient of variation of (x, y) combinations in Example 7 for which the average orientation density is 1.2 or more.

Tables 16A and 16B present the average orientation density of Comparative Example 1, and Tables 17A and 17B present the coefficient of variation of (x, y) combinations in Comparative Example 1 for which the average orientation density is 1.2 or more.

Tables 18A and 18B present the average orientation density of Comparative Example 2, and Tables 19A and 19B present the coefficient of variation of (x, y) combinations in Comparative Example 2 for which the average orientation density is 1.2 or more.

Tables 20A and 20B present the average orientation density of Comparative Example 3, and Tables 21A and 21B present the coefficient of variation of (x, y) combinations in Comparative Example 3 for which the average orientation density is 1.2 or more.

Tables 22A and 22B present the average orientation density of Comparative Example 4, and Tables 23A and 23B present the coefficient of variation of (x, y) combinations in Comparative Example 4 for which the average orientation density is 1.2 or more.

Tables 24A and 24B present the average orientation density of Comparative Example 5, and Tables 25A and 25B present the coefficient of variation of (x, y) combinations in Comparative Example 5 for which the average orientation density is 1.2 or more.

Tables 26A and 26B present the average orientation density of Comparative Example 6, and Tables 27A and 27B present the coefficient of variation of (x, y) combinations in Comparative Example 6 for which the average orientation density is 1.2 or more.

Tables 28A and 28B present the average orientation density of Comparative Example 7, and Tables 29A and 29B present the coefficient of variation of (x, y) combinations in Comparative Example 7 for which the average orientation density is 1.2 or more.

Tables 30A and 30B present the average orientation density of Comparative Example 8, and Tables 31A and 31B present the coefficient of variation of (x, y) combinations in Comparative Example 8 for which the average orientation density is 1.2 or more.

In Tables 3A and 3B, Tables 5A and 5B, Tables 7A and 7B, Tables 9A and 9B, Tables 11A and 11B, Tables 13A and 13B, Tables 15A and 15B, Tables 17A and 17B, Tables 19A and 19B, Tables 21A and 21B, Tables 23A and 23B, Tables 25A and 25B, Tables 27A and 27B, Tables 29A and 29B, and Tables 31A and 31B, "N/A" indicates an (x, y) combination for which the average orientation density is less than 1.2.

[Table 2A]

| <Example 1> | | | | | | | | | | |
|---|---|---|---|---|---|---|---|---|---|---|
| Average orientation density | | Φ2(y) | | | | | | | | |
| | | 0 | 5 | 10 | 15 | 20 | 25 | 30 | 35 | 40 | 45 |
| Φ (x) | 0 | 1.79 | 1.79 | 1.80 | 1.80 | 1.80 | 1.80 | 1.80 | 1.81 | 1.79 | 1.78 |
| | 5 | 1.71 | 1.71 | 1.72 | 1.72 | 1.72 | 1.71 | 1.72 | 1.72 | 1.71 | 1.70 |
| | 10 | 1.43 | 1.43 | 1.44 | 1.44 | 1.44 | 1.44 | 1.45 | 1.46 | 1.46 | 1.45 |
| | 15 | 0.98 | 0.98 | 0.99 | 1.01 | 1.03 | 1.06 | 1.09 | 1.11 | 1.12 | 1.13 |
| | 20 | 0.54 | 0.55 | 0.58 | 0.62 | 0.68 | 0.73 | 0.77 | 0.81 | 0.83 | 0.85 |
| | 25 | 0.28 | 0.29 | 0.32 | 0.37 | 0.43 | 0.49 | 0.55 | 0.60 | 0.64 | 0.66 |
| | 30 | 0.16 | 0.17 | 0.18 | 0.20 | 0.25 | 0.32 | 0.41 | 0.50 | 0.57 | 0.60 |
| | 35 | 0.09 | 0.09 | 0.08 | 0.09 | 0.15 | 0.25 | 0.41 | 0.60 | 0.77 | 0.85 |
| | 40 | 0.04 | 0.03 | 0.04 | 0.08 | 0.15 | 0.30 | 0.58 | 1.02 | 1.48 | 1.71 |
| | 45 | 0.02 | 0.03 | 0.06 | 0.11 | 0.18 | 0.40 | 0.96 | 1.94 | 2.98 | 3.48 |
| | 50 | 0.04 | 0.05 | 0.07 | 0.12 | 0.22 | 0.59 | 1.57 | 3.25 | 4.98 | 5.75 |
| | 55 | 0.09 | 0.08 | 0.08 | 0.14 | 0.32 | 0.84 | 2.08 | 4.06 | 6.01 | 6.80 |
| | 60 | 0.16 | 0.14 | 0.15 | 0.25 | 0.46 | 0.96 | 1.98 | 3.50 | 4.90 | 5.41 |
| | 65 | 0.28 | 0.28 | 0.33 | 0.43 | 0.57 | 0.84 | 1.35 | 2.01 | 2.56 | 2.74 |
| | 70 | 0.54 | 0.56 | 0.60 | 0.62 | 0.62 | 0.65 | 0.72 | 0.79 | 0.83 | 0.84 |

(continued)

| <Example 1> | | | | | | | | | | | |
|---|---|---|---|---|---|---|---|---|---|---|---|
| Average orientation density | | Φ2(y) | | | | | | | | | |
| | | 0 | 5 | 10 | 15 | 20 | 25 | 30 | 35 | 40 | 45 |
| | 75 | 0.98 | 0.98 | 0.92 | 0.80 | 0.65 | 0.49 | 0.36 | 0.26 | 0.22 | 0.22 |
| | 80 | 1.43 | 1.38 | 1.21 | 0.93 | 0.63 | 0.37 | 0.19 | 0.10 | 0.10 | 0.10 |
| | 85 | 1.71 | 1.64 | 1.38 | 0.98 | 0.57 | 0.29 | 0.14 | 0.08 | 0.05 | 0.04 |
| | 90 | 1.99 | 1.89 | 1.56 | 1.03 | 0.52 | 0.21 | 0.09 | 0.05 | 0.01 | -0.02 |

[Table 2B]

| <Example 1> | | | | | | | | | | |
|---|---|---|---|---|---|---|---|---|---|---|
| Average orientation density | | Φ2(y) | | | | | | | | |
| | | 50 | 55 | 60 | 65 | 70 | 75 | 80 | 85 | 90 |
| Φ(x) | 0 | 1.78 | 1.79 | 1.81 | 1.81 | 1.80 | 1.80 | 1.80 | 1.80 | 1.80 |
| | 5 | 1.70 | 1.71 | 1.72 | 1.73 | 1.72 | 1.72 | 1.72 | 1.71 | 1.71 |
| | 10 | 1.45 | 1.46 | 1.46 | 1.46 | 1.45 | 1.45 | 1.44 | 1.43 | 1.42 |
| | 15 | 1.12 | 1.11 | 1.10 | 1.08 | 1.05 | 1.03 | 1.00 | 0.99 | 0.97 |
| | 20 | 0.84 | 0.81 | 0.77 | 0.72 | 0.67 | 0.62 | 0.58 | 0.55 | 0.52 |
| | 25 | 0.65 | 0.61 | 0.54 | 0.47 | 0.40 | 0.34 | 0.30 | 0.28 | 0.26 |
| | 30 | 0.58 | 0.51 | 0.42 | 0.31 | 0.22 | 0.17 | 0.15 | 0.15 | 0.16 |
| | 35 | 0.80 | 0.64 | 0.43 | 0.26 | 0.14 | 0.09 | 0.08 | 0.09 | 0.10 |
| | 40 | 1.55 | 1.11 | 0.62 | 0.29 | 0.14 | 0.09 | 0.06 | 0.05 | 0.03 |
| | 45 | 3.09 | 2.07 | 1.04 | 0.41 | 0.17 | 0.11 | 0.07 | 0.03 | -0.01 |
| | 50 | 5.03 | 3.33 | 1.65 | 0.64 | 0.24 | 0.12 | 0.06 | 0.03 | 0.01 |
| | 55 | 5.92 | 3.97 | 2.07 | 0.89 | 0.35 | 0.15 | 0.07 | 0.08 | 0.08 |
| | 60 | 4.73 | 3.30 | 1.89 | 0.94 | 0.46 | 0.24 | 0.17 | 0.17 | 0.17 |
| | 65 | 2.46 | 1.88 | 1.25 | 0.78 | 0.52 | 0.41 | 0.36 | 0.32 | 0.28 |
| | 70 | 0.83 | 0.77 | 0.67 | 0.58 | 0.58 | 0.61 | 0.62 | 0.57 | 0.53 |
| | 75 | 0.24 | 0.28 | 0.34 | 0.46 | 0.63 | 0.80 | 0.91 | 0.95 | 1.00 |
| | 80 | 0.09 | 0.10 | 0.20 | 0.39 | 0.64 | 0.91 | 1.17 | 1.35 | 1.53 |
| | 85 | 0.03 | 0.07 | 0.17 | 0.32 | 0.58 | 0.96 | 1.35 | 1.62 | 1.88 |
| | 90 | -0.02 | 0.05 | 0.14 | 0.26 | 0.52 | 1.00 | 1.53 | 1.88 | 2.24 |

[Table 3A]

| <Example 1> | | | | | | | | | | | |
|---|---|---|---|---|---|---|---|---|---|---|---|
| Coefficient of variation | | Φ2(y) | | | | | | | | | |
| | | 0 | 5 | 10 | 15 | 20 | 25 | 30 | 35 | 40 | 45 |
| | 0 | 0.06 | 0.06 | 0.06 | 0.06 | 0.06 | 0.06 | 0.06 | 0.06 | 0.06 | 0.08 |
| | 5 | 0.05 | 0.05 | 0.05 | 0.05 | 0.05 | 0.05 | 0.05 | 0.05 | 0.05 | 0.07 |
| | 10 | 0.04 | 0.04 | 0.04 | 0.04 | 0.04 | 0.04 | 0.04 | 0.04 | 0.04 | 0.05 |
| | 15 | N/A | N/A | N/A | N/A | N/A | N/A | N/A | N/A | N/A | N/A |
| | 20 | N/A | N/A | N/A | N/A | N/A | N/A | N/A | N/A | N/A | N/A |

(continued)

| <Example 1> | | | | | | | | | | | |
|---|---|---|---|---|---|---|---|---|---|---|---|
| Coefficient of variation | | Φ2(y) | | | | | | | | | |
| | | 0 | 5 | 10 | 15 | 20 | 25 | 30 | 35 | 40 | 45 |
| Φ (x) | 25 | N/A | N/A | N/A | N/A | N/A | N/A | N/A | N/A | N/A | N/A |
| | 30 | N/A | N/A | N/A | N/A | N/A | N/A | N/A | N/A | N/A | N/A |
| | 35 | N/A | N/A | N/A | N/A | N/A | N/A | N/A | N/A | N/A | N/A |
| | 40 | N/A | N/A | N/A | N/A | N/A | N/A | N/A | N/A | 0.05 | 0.05 |
| | 45 | N/A | N/A | N/A | N/A | N/A | N/A | N/A | 0.03 | 0.04 | 0.04 |
| | 50 | N/A | N/A | N/A | N/A | N/A | N/A | 0.05 | 0.02 | 0.02 | 0.02 |
| | 55 | N/A | N/A | N/A | N/A | N/A | N/A | 0.04 | 0.02 | 0.01 | 0.02 |
| | 60 | N/A | N/A | N/A | N/A | N/A | N/A | 0.05 | 0.03 | 0.02 | 0.02 |
| | 65 | N/A | N/A | N/A | N/A | N/A | N/A | 0.05 | 0.03 | 0.03 | 0.03 |
| | 70 | N/A | N/A | N/A | N/A | N/A | N/A | N/A | N/A | N/A | N/A |
| | 75 | N/A | N/A | N/A | N/A | N/A | N/A | N/A | N/A | N/A | N/A |
| | 80 | 0.04 | 0.04 | 0.04 | N/A | N/A | N/A | N/A | N/A | N/A | N/A |
| | 85 | 0.05 | 0.05 | 0.04 | N/A | N/A | N/A | N/A | N/A | N/A | N/A |
| | 90 | 0.06 | 0.06 | 0.05 | N/A | N/A | N/A | N/A | N/A | N/A | N/A |

[Table 3B]

| <Example 1> | | | | | | | | | | | |
|---|---|---|---|---|---|---|---|---|---|---|---|
| Coefficient of variation | | Φ2(y) | | | | | | | | | |
| | | 50 | 55 | 60 | 65 | 70 | 75 | 80 | 85 | 90 | |
| Φ (x) | 0 | 0.08 | 0.06 | 0.06 | 0.06 | 0.06 | 0.06 | 0.06 | 0.06 | 0.09 | |
| | 5 | 0.07 | 0.05 | 0.06 | 0.06 | 0.06 | 0.05 | 0.05 | 0.05 | 0.08 | |
| | 10 | 0.05 | 0.05 | 0.05 | 0.05 | 0.05 | 0.05 | 0.05 | 0.04 | 0.07 | |
| | 15 | N/A | N/A | N/A | N/A | N/A | N/A | N/A | N/A | N/A | |
| | 20 | N/A | N/A | N/A | N/A | N/A | N/A | N/A | N/A | N/A | |
| | 25 | N/A | N/A | N/A | N/A | N/A | N/A | N/A | N/A | N/A | |
| | 30 | N/A | N/A | N/A | N/A | N/A | N/A | N/A | N/A | N/A | |
| | 35 | N/A | N/A | N/A | N/A | N/A | N/A | N/A | N/A | N/A | |
| | 40 | 0.05 | N/A | N/A | N/A | N/A | N/A | N/A | N/A | N/A | |
| | 45 | 0.03 | 0.03 | N/A | N/A | N/A | N/A | N/A | N/A | N/A | |
| | 50 | 0.02 | 0.02 | 0.06 | N/A | N/A | N/A | N/A | N/A | N/A | |
| | 55 | 0.02 | 0.02 | 0.04 | N/A | N/A | N/A | N/A | N/A | N/A | |
| | 60 | 0.02 | 0.02 | 0.04 | N/A | N/A | N/A | N/A | N/A | N/A | |
| | 65 | 0.04 | 0.04 | 0.05 | N/A | N/A | N/A | N/A | N/A | N/A | |
| | 70 | N/A | N/A | N/A | N/A | N/A | N/A | N/A | N/A | N/A | |
| | 75 | N/A | N/A | N/A | N/A | N/A | N/A | N/A | N/A | N/A | |
| | 80 | N/A | N/A | N/A | N/A | N/A | N/A | N/A | 0.04 | 0.04 | |
| | 85 | N/A | N/A | N/A | N/A | N/A | N/A | 0.04 | 0.04 | 0.05 | |

(continued)

| <Example 1> | | | | | | | | | | |
|---|---|---|---|---|---|---|---|---|---|---|
| Coefficient of variation | | Φ2(y) | | | | | | | | |
| | | 50 | 55 | 60 | 65 | 70 | 75 | 80 | 85 | 90 |
| | 90 | N/A | N/A | N/A | N/A | N/A | N/A | 0.05 | 0.05 | 0.06 |

[Table 4A]

| <Example 2> | | | | | | | | | | |
|---|---|---|---|---|---|---|---|---|---|---|
| Average orientation density | | Φ2(y) | | | | | | | | |
| | | 0 | 5 | 10 | 15 | 20 | 25 | 30 | 35 | 40 | 45 |
| Φ (x) | 0 | 0.10 | 0.10 | 0.10 | 0.09 | 0.10 | 0.11 | 0.11 | 0.10 | 0.09 | 0.09 |
| | 5 | 0.06 | 0.06 | 0.06 | 0.06 | 0.06 | 0.06 | 0.07 | 0.07 | 0.06 | 0.06 |
| | 10 | 0.06 | 0.06 | 0.06 | 0.06 | 0.06 | 0.07 | 0.08 | 0.09 | 0.08 | 0.07 |
| | 15 | 0.03 | 0.03 | 0.05 | 0.07 | 0.10 | 0.12 | 0.15 | 0.16 | 0.15 | 0.14 |
| | 20 | 0.02 | 0.02 | 0.04 | 0.10 | 0.15 | 0.17 | 0.17 | 0.15 | 0.12 | 0.09 |
| | 25 | 0.03 | 0.03 | 0.03 | 0.06 | 0.09 | 0.12 | 0.12 | 0.10 | 0.07 | 0.04 |
| | 30 | 0.11 | 0.07 | 0.01 | 0.01 | 0.03 | 0.08 | 0.18 | 0.24 | 0.23 | 0.18 |
| | 35 | 0.18 | 0.08 | 0.00 | 0.00 | 0.02 | 0.13 | 0.30 | 0.43 | 0.48 | 0.43 |
| | 40 | 0.09 | 0.02 | 0.00 | 0.01 | 0.09 | 0.26 | 0.54 | 1.12 | 1.78 | 1.99 |
| | 45 | 0.03 | 0.00 | 0.01 | 0.10 | 0.23 | 0.47 | 1.55 | 4.03 | 6.94 | 8.13 |
| | 50 | 0.09 | 0.01 | 0.01 | 0.08 | 0.20 | 0.75 | 3.31 | 8.84 | 15.18 | 17.90 |
| | 55 | 0.18 | 0.03 | 0.00 | 0.03 | 0.17 | 0.90 | 4.11 | 11.04 | 19.07 | 22.61 |
| | 60 | 0.11 | 0.01 | 0.00 | 0.07 | 0.28 | 0.76 | 2.90 | 7.85 | 13.86 | 16.66 |
| | 65 | 0.03 | 0.02 | 0.06 | 0.16 | 0.30 | 0.50 | 1.16 | 2.89 | 5.28 | 6.54 |
| | 70 | 0.02 | 0.06 | 0.14 | 0.09 | 0.13 | 0.31 | 0.42 | 0.50 | 0.80 | 1.10 |
| | 75 | 0.03 | 0.06 | 0.13 | 0.06 | 0.07 | 0.18 | 0.21 | 0.12 | 0.15 | 0.25 |
| | 80 | 0.06 | 0.03 | 0.08 | 0.13 | 0.13 | 0.07 | 0.01 | 0.01 | 0.04 | 0.10 |
| | 85 | 0.06 | 0.02 | 0.03 | 0.06 | 0.07 | 0.02 | 0.01 | 0.01 | 0.00 | 0.00 |
| | 90 | 0.06 | 0.00 | -0.02 | 0.00 | 0.01 | -0.02 | 0.01 | 0.01 | -0.04 | -0.10 |

[Table 4B]

| <Example 2> | | | | | | | | | | |
|---|---|---|---|---|---|---|---|---|---|---|
| Average orientation density | | Φ2(y) | | | | | | | | |
| | | 50 | 55 | 60 | 65 | 70 | 75 | 80 | 85 | 90 |
| | 0 | 0.09 | 0.09 | 0.10 | 0.11 | 0.11 | 0.10 | 0.09 | 0.09 | 0.09 |
| | 5 | 0.05 | 0.05 | 0.05 | 0.05 | 0.06 | 0.05 | 0.05 | 0.05 | 0.06 |
| | 10 | 0.07 | 0.06 | 0.05 | 0.05 | 0.05 | 0.05 | 0.05 | 0.05 | 0.05 |
| | 15 | 0.14 | 0.13 | 0.11 | 0.09 | 0.07 | 0.05 | 0.04 | 0.03 | 0.02 |
| | 20 | 0.09 | 0.11 | 0.12 | 0.12 | 0.10 | 0.07 | 0.04 | 0.02 | 0.00 |
| | 25 | 0.03 | 0.06 | 0.09 | 0.07 | 0.05 | 0.03 | 0.02 | 0.02 | 0.02 |
| | 30 | 0.17 | 0.21 | 0.19 | 0.09 | 0.01 | 0.00 | 0.00 | 0.05 | 0.10 |
| | 35 | 0.36 | 0.32 | 0.26 | 0.12 | 0.02 | 0.00 | 0.00 | 0.09 | 0.18 |

(continued)

| <Example 2> | | | | | | | | | | |
|---|---|---|---|---|---|---|---|---|---|---|
| Average orientation density | | Φ2(y) | | | | | | | | |
| | | 50 | 55 | 60 | 65 | 70 | 75 | 80 | 85 | 90 |
| Φ (x) | 40 | 1.52 | 0.76 | 0.26 | 0.12 | 0.07 | 0.02 | 0.00 | 0.03 | 0.05 |
| | 45 | 6.51 | 3.40 | 1.04 | 0.25 | 0.22 | 0.11 | 0.01 | 0.00 | 0.00 |
| | 50 | 14.69 | 8.12 | 2.75 | 0.58 | 0.26 | 0.11 | 0.00 | 0.01 | 0.01 |
| | 55 | 18.71 | 10.47 | 3.65 | 0.79 | 0.26 | 0.06 | 0.00 | 0.03 | 0.06 |
| | 60 | 13.77 | 7.58 | 2.59 | 0.63 | 0.30 | 0.09 | 0.00 | 0.03 | 0.07 |
| | 65 | 5.41 | 2.91 | 1.01 | 0.35 | 0.23 | 0.13 | 0.06 | 0.04 | 0.02 |
| | 70 | 0.99 | 0.63 | 0.38 | 0.20 | 0.06 | 0.05 | 0.13 | 0.08 | 0.02 |
| | 75 | 0.23 | 0.19 | 0.21 | 0.14 | 0.03 | 0.06 | 0.17 | 0.11 | 0.05 |
| | 80 | 0.03 | 0.00 | 0.02 | 0.07 | 0.12 | 0.17 | 0.19 | 0.13 | 0.06 |
| | 85 | 0.00 | 0.00 | 0.02 | 0.04 | 0.08 | 0.11 | 0.13 | 0.10 | 0.07 |
| | 90 | -0.03 | 0.01 | 0.01 | 0.01 | 0.03 | 0.06 | 0.07 | 0.07 | 0.08 |

[Table 5A]

| <Example 2> | | | | | | | | | | |
|---|---|---|---|---|---|---|---|---|---|---|
| Coefficient of variation | | Φ2(y) | | | | | | | | |
| | | 0 | 5 | 10 | 15 | 20 | 25 | 30 | 35 | 40 | 45 |
| Φ (x) | 0 | N/A | N/A | N/A | N/A | N/A | N/A | N/A | N/A | N/A | N/A |
| | 5 | N/A | N/A | N/A | N/A | N/A | N/A | N/A | N/A | N/A | N/A |
| | 10 | N/A | N/A | N/A | N/A | N/A | N/A | N/A | N/A | N/A | N/A |
| | 15 | N/A | N/A | N/A | N/A | N/A | N/A | N/A | N/A | N/A | N/A |
| | 20 | N/A | N/A | N/A | N/A | N/A | N/A | N/A | N/A | N/A | N/A |
| | 25 | N/A | N/A | N/A | N/A | N/A | N/A | N/A | N/A | N/A | N/A |
| | 30 | N/A | N/A | N/A | N/A | N/A | N/A | N/A | N/A | N/A | N/A |
| | 35 | N/A | N/A | N/A | N/A | N/A | N/A | N/A | N/A | N/A | N/A |
| | 40 | N/A | N/A | N/A | N/A | N/A | N/A | N/A | N/A | 0.13 | 0.12 |
| | 45 | N/A | N/A | N/A | N/A | N/A | N/A | 0.22 | 0.09 | 0.06 | 0.09 |
| | 50 | N/A | N/A | N/A | N/A | N/A | N/A | 0.17 | 0.06 | 0.05 | 0.06 |
| | 55 | N/A | N/A | N/A | N/A | N/A | N/A | 0.17 | 0.08 | 0.06 | 0.05 |
| | 60 | N/A | N/A | N/A | N/A | N/A | N/A | 0.16 | 0.10 | 0.07 | 0.06 |
| | 65 | N/A | N/A | N/A | N/A | N/A | N/A | N/A | 0.15 | 0.12 | 0.10 |
| | 70 | N/A | N/A | N/A | N/A | N/A | N/A | N/A | N/A | N/A | N/A |
| | 75 | N/A | N/A | N/A | N/A | N/A | N/A | N/A | N/A | N/A | N/A |
| | 80 | N/A | N/A | N/A | N/A | N/A | N/A | N/A | N/A | N/A | N/A |
| | 85 | N/A | N/A | N/A | N/A | N/A | N/A | N/A | N/A | N/A | N/A |
| | 90 | N/A | N/A | N/A | N/A | N/A | N/A | N/A | N/A | N/A | N/A |

[Table 5B]

| <Example 2> | | Φ2(y) | | | | | | | | |
|---|---|---|---|---|---|---|---|---|---|---|
| Coefficient of variation | | 50 | 55 | 60 | 65 | 70 | 75 | 80 | 85 | 90 |
| Φ (x) | 0 | N/A | N/A | N/A | N/A | N/A | N/A | N/A | N/A | N/A |
| | 5 | N/A | N/A | N/A | N/A | N/A | N/A | N/A | N/A | N/A |
| | 10 | N/A | N/A | N/A | N/A | N/A | N/A | N/A | N/A | N/A |
| | 15 | N/A | N/A | N/A | N/A | N/A | N/A | N/A | N/A | N/A |
| | 20 | N/A | N/A | N/A | N/A | N/A | N/A | N/A | N/A | N/A |
| | 25 | N/A | N/A | N/A | N/A | N/A | N/A | N/A | N/A | N/A |
| | 30 | N/A | N/A | N/A | N/A | N/A | N/A | N/A | N/A | N/A |
| | 35 | N/A | N/A | N/A | N/A | N/A | N/A | N/A | N/A | N/A |
| | 40 | 0.17 | N/A | N/A | N/A | N/A | N/A | N/A | N/A | N/A |
| | 45 | 0.12 | 0.15 | N/A | N/A | N/A | N/A | N/A | N/A | N/A |
| | 50 | 0.07 | 0.08 | 0.11 | N/A | N/A | N/A | N/A | N/A | N/A |
| | 55 | 0.05 | 0.05 | 0.10 | N/A | N/A | N/A | N/A | N/A | N/A |
| | 60 | 0.04 | 0.04 | 0.06 | N/A | N/A | N/A | N/A | N/A | N/A |
| | 65 | 0.11 | 0.14 | N/A | N/A | N/A | N/A | N/A | N/A | N/A |
| | 70 | N/A | N/A | N/A | N/A | N/A | N/A | N/A | N/A | N/A |
| | 75 | N/A | N/A | N/A | N/A | N/A | N/A | N/A | N/A | N/A |
| | 80 | N/A | N/A | N/A | N/A | N/A | N/A | N/A | N/A | N/A |
| | 85 | N/A | N/A | N/A | N/A | N/A | N/A | N/A | N/A | N/A |
| | 90 | N/A | N/A | N/A | N/A | N/A | N/A | N/A | N/A | N/A |

[Table 6A]

| <Example 3> | | Φ2(y) | | | | | | | | | |
|---|---|---|---|---|---|---|---|---|---|---|---|
| Average orientation density | | 0 | 5 | 10 | 15 | 20 | 25 | 30 | 35 | 40 | 45 |
| Φ (x) | 0 | 0.24 | 0.08 | 0.03 | 0.03 | 0.01 | 0.03 | 0.49 | 0.98 | 0.62 | 0.27 |
| | 5 | 0.24 | 0.08 | 0.04 | 0.05 | 0.01 | 0.02 | 0.27 | 0.53 | 0.17 | 0.01 |
| | 10 | 0.25 | 0.07 | 0.02 | 0.04 | 0.05 | 0.05 | 0.04 | 0.03 | 0.01 | 0.00 |
| | 15 | 0.26 | 0.07 | 0.02 | 0.07 | 0.20 | 0.17 | 0.05 | 0.03 | 0.03 | 0.28 |
| | 20 | 0.26 | 0.10 | 0.03 | 0.12 | 0.35 | 0.28 | 0.10 | 0.07 | 0.39 | 1.02 |
| | 25 | 0.26 | 0.13 | 0.09 | 0.20 | 0.37 | 0.32 | 0.28 | 0.49 | 0.61 | 0.24 |
| | 30 | 0.26 | 0.12 | 0.07 | 0.20 | 0.31 | 0.24 | 0.49 | 0.82 | 0.17 | 0.00 |
| | 35 | 0.26 | 0.11 | 0.09 | 0.21 | 0.24 | 0.14 | 0.43 | 0.68 | 0.03 | 1.00 |
| | 40 | 0.26 | 0.11 | 0.10 | 0.23 | 0.21 | 0.07 | 0.26 | 0.42 | 0.06 | 4.49 |
| | 45 | 0.26 | 0.10 | 0.10 | 0.25 | 0.15 | 0.03 | 0.22 | 0.37 | 0.11 | 6.10 |
| | 50 | 0.25 | 0.10 | 0.10 | 0.28 | 0.21 | 0.04 | 0.28 | 0.54 | 0.06 | 3.74 |
| | 55 | 0.26 | 0.09 | 0.10 | 0.33 | 0.32 | 0.09 | 0.41 | 0.87 | 0.02 | 0.43 |
| | 60 | 0.26 | 0.07 | 0.09 | 0.34 | 0.50 | 0.21 | 0.39 | 0.94 | 0.23 | 0.00 |

(continued)

| <Example 3> | | | | | | | | | | | |
|---|---|---|---|---|---|---|---|---|---|---|---|
| Average orientation density | | Φ2(y) | | | | | | | | | |
| | | 0 | 5 | 10 | 15 | 20 | 25 | 30 | 35 | 40 | 45 |
| | 65 | 0.26 | 0.06 | 0.08 | 0.29 | 0.55 | 0.29 | 0.12 | 0.47 | 0.72 | 0.25 |
| | 70 | 0.26 | 0.09 | 0.08 | 0.25 | 0.45 | 0.20 | 0.00 | 0.00 | 0.38 | 1.02 |
| | 75 | 0.26 | 0.11 | 0.10 | 0.20 | 0.28 | 0.09 | 0.00 | 0.00 | 0.00 | 0.27 |
| | 80 | 0.26 | 0.09 | 0.05 | 0.10 | 0.11 | 0.04 | 0.01 | 0.00 | 0.00 | 0.00 |
| | 85 | 0.25 | 0.07 | 0.04 | 0.06 | 0.04 | 0.04 | 0.28 | 0.47 | 0.13 | 0.01 |
| | 90 | 0.24 | 0.05 | 0.03 | 0.01 | -0.02 | 0.04 | 0.55 | 0.94 | 0.26 | 0.02 |

[Table 6B]

| <Example 3> | | | | | | | | | | | |
|---|---|---|---|---|---|---|---|---|---|---|---|
| Average orientation density | | Φ2(y) | | | | | | | | | |
| | | 50 | 55 | 60 | 65 | 70 | 75 | 80 | 85 | 90 | |
| Φ(x) | 0 | 0.62 | 0.98 | 0.49 | 0.03 | 0.01 | 0.03 | 0.03 | 0.08 | 0.12 | |
| | 5 | 0.03 | 0.13 | 0.05 | 0.04 | 0.20 | 0.24 | 0.13 | 0.10 | 0.08 | |
| | 10 | 0.00 | 0.00 | 0.00 | 0.13 | 0.45 | 0.46 | 0.32 | 0.14 | -0.05 | |
| | 15 | 0.32 | 0.08 | 0.19 | 0.31 | 0.15 | 0.19 | 0.45 | 0.26 | 0.07 | |
| | 20 | 0.87 | 0.63 | 0.91 | 0.74 | 0.08 | 0.10 | 0.45 | 0.24 | 0.03 | |
| | 25 | 0.00 | 0.00 | 0.16 | 0.56 | 0.62 | 0.39 | 0.21 | 0.06 | -0.09 | |
| | 30 | 0.29 | 0.85 | 0.29 | 0.09 | 0.75 | 0.71 | 0.01 | 0.02 | 0.02 | |
| | 35 | 6.77 | 10.10 | 5.40 | 0.28 | 0.11 | 0.65 | 0.00 | 0.00 | 0.01 | |
| | 40 | 17.41 | 24.38 | 14.98 | 2.04 | 0.00 | 0.81 | 0.01 | 0.00 | -0.01 | |
| | 45 | 22.41 | 31.46 | 20.18 | 3.59 | 0.00 | 1.01 | 0.14 | 0.00 | -0.14 | |
| | 50 | 16.73 | 24.42 | 15.53 | 2.45 | 0.00 | 0.81 | 0.05 | 0.01 | -0.04 | |
| | 55 | 6.08 | 10.17 | 5.95 | 0.41 | 0.10 | 0.67 | 0.05 | 0.04 | 0.03 | |
| | 60 | 0.17 | 0.79 | 0.29 | 0.03 | 0.53 | 0.69 | 0.06 | 0.03 | 0.01 | |
| | 65 | 0.01 | 0.00 | 0.04 | 0.23 | 0.27 | 0.26 | 0.18 | 0.06 | -0.06 | |
| | 70 | 0.85 | 0.63 | 0.85 | 0.51 | 0.03 | 0.03 | 0.32 | 0.18 | 0.05 | |
| | 75 | 0.34 | 0.16 | 0.31 | 0.33 | 0.05 | 0.05 | 0.27 | 0.17 | 0.07 | |
| | 80 | 0.01 | 0.03 | 0.04 | 0.15 | 0.38 | 0.31 | 0.16 | 0.06 | -0.03 | |
| | 85 | 0.04 | 0.15 | 0.06 | 0.05 | 0.15 | 0.17 | 0.06 | 0.07 | 0.07 | |
| | 90 | 0.07 | 0.27 | 0.07 | -0.05 | -0.08 | 0.04 | -0.03 | 0.07 | 0.17 | |

[Table 7A]

| <Example 3> | | | | | | | | | | | |
|---|---|---|---|---|---|---|---|---|---|---|---|
| Coefficient of variation | | Φ2(y) | | | | | | | | | |
| | | 0 | 5 | 10 | 15 | 20 | 25 | 30 | 35 | 40 | 45 |
| | 0 | N/A | N/A | N/A | N/A | N/A | N/A | N/A | N/A | N/A | N/A |
| | 5 | N/A | N/A | N/A | N/A | N/A | N/A | N/A | N/A | N/A | N/A |
| | 10 | N/A | N/A | N/A | N/A | N/A | N/A | N/A | N/A | N/A | N/A |

(continued)

| <Example 3> | | | | | | | | | | | |
|---|---|---|---|---|---|---|---|---|---|---|---|
| Coefficient of variation | | Φ2(y) | | | | | | | | | |
| | | 0 | 5 | 10 | 15 | 20 | 25 | 30 | 35 | 40 | 45 |
| Φ (x) | 15 | N/A | N/A | N/A | N/A | N/A | N/A | N/A | N/A | N/A | N/A |
| | 20 | N/A | N/A | N/A | N/A | N/A | N/A | N/A | N/A | N/A | N/A |
| | 25 | N/A | N/A | N/A | N/A | N/A | N/A | N/A | N/A | N/A | N/A |
| | 30 | N/A | N/A | N/A | N/A | N/A | N/A | N/A | N/A | N/A | N/A |
| | 35 | N/A | N/A | N/A | N/A | N/A | N/A | N/A | N/A | N/A | N/A |
| | 40 | N/A | N/A | N/A | N/A | N/A | N/A | N/A | N/A | N/A | 0.26 |
| | 45 | N/A | N/A | N/A | N/A | N/A | N/A | N/A | N/A | N/A | 0.24 |
| | 50 | N/A | N/A | N/A | N/A | N/A | N/A | N/A | N/A | N/A | 0.37 |
| | 55 | N/A | N/A | N/A | N/A | N/A | N/A | N/A | N/A | N/A | N/A |
| | 60 | N/A | N/A | N/A | N/A | N/A | N/A | N/A | N/A | N/A | N/A |
| | 65 | N/A | N/A | N/A | N/A | N/A | N/A | N/A | N/A | N/A | N/A |
| | 70 | N/A | N/A | N/A | N/A | N/A | N/A | N/A | N/A | N/A | N/A |
| | 75 | N/A | N/A | N/A | N/A | N/A | N/A | N/A | N/A | N/A | N/A |
| | 80 | N/A | N/A | N/A | N/A | N/A | N/A | N/A | N/A | N/A | N/A |
| | 85 | N/A | N/A | N/A | N/A | N/A | N/A | N/A | N/A | N/A | N/A |
| | 90 | N/A | N/A | N/A | N/A | N/A | N/A | N/A | N/A | N/A | N/A |

[Table 7B]

| <Example 3> | | | | | | | | | | | |
|---|---|---|---|---|---|---|---|---|---|---|---|
| Coefficient of variation | | Φ2(y) | | | | | | | | | |
| | | 50 | 55 | 60 | 65 | 70 | 75 | 80 | 85 | 90 |
| Φ (x) | 0 | N/A | N/A | N/A | N/A | N/A | N/A | N/A | N/A | N/A |
| | 5 | N/A | N/A | N/A | N/A | N/A | N/A | N/A | N/A | N/A |
| | 10 | N/A | N/A | N/A | N/A | N/A | N/A | N/A | N/A | N/A |
| | 15 | N/A | N/A | N/A | N/A | N/A | N/A | N/A | N/A | N/A |
| | 20 | N/A | N/A | N/A | N/A | N/A | N/A | N/A | N/A | N/A |
| | 25 | N/A | N/A | N/A | N/A | N/A | N/A | N/A | N/A | N/A |
| | 30 | N/A | N/A | N/A | N/A | N/A | N/A | N/A | N/A | N/A |
| | 35 | 0.27 | 0.23 | 0.29 | N/A | N/A | N/A | N/A | N/A | N/A |
| | 40 | 0.16 | 0.15 | 0.17 | 0.47 | N/A | N/A | N/A | N/A | N/A |
| | 45 | 0.12 | 0.12 | 0.13 | 0.28 | N/A | N/A | N/A | N/A | N/A |
| | 50 | 0.13 | 0.10 | 0.11 | 0.30 | N/A | N/A | N/A | N/A | N/A |
| | 55 | 0.16 | 0.10 | 0.14 | N/A | N/A | N/A | N/A | N/A | N/A |
| | 60 | N/A | N/A | N/A | N/A | N/A | N/A | N/A | N/A | N/A |
| | 65 | N/A | N/A | N/A | N/A | N/A | N/A | N/A | N/A | N/A |
| | 70 | N/A | N/A | N/A | N/A | N/A | N/A | N/A | N/A | N/A |
| | 75 | N/A | N/A | N/A | N/A | N/A | N/A | N/A | N/A | N/A |

(continued)

| <Example 3> | | | | | | | | | | |
|---|---|---|---|---|---|---|---|---|---|---|
| Coefficient of variation | | Φ2(y) | | | | | | | | |
| | | 50 | 55 | 60 | 65 | 70 | 75 | 80 | 85 | 90 |
| | 80 | N/A | N/A | N/A | N/A | N/A | N/A | N/A | N/A | N/A |
| | 85 | N/A | N/A | N/A | N/A | N/A | N/A | N/A | N/A | N/A |
| | 90 | N/A | N/A | N/A | N/A | N/A | N/A | N/A | N/A | N/A |

[Table 8A]

| <Example 4> | | | | | | | | | | |
|---|---|---|---|---|---|---|---|---|---|---|
| Average orientation density | | Φ2(y) | | | | | | | | |
| | | 0 | 5 | 10 | 15 | 20 | 25 | 30 | 35 | 40 | 45 |
| Φ (x) | 0 | 1.23 | 1.23 | 1.22 | 1.23 | 1.24 | 1.22 | 1.20 | 1.23 | 1.28 | 1.30 |
| | 5 | 1.27 | 1.30 | 1.31 | 1.31 | 1.33 | 1.32 | 1.29 | 1.30 | 1.33 | 1.33 |
| | 10 | 1.33 | 1.39 | 1.40 | 1.40 | 1.41 | 1.42 | 1.40 | 1.40 | 1.42 | 1.44 |
| | 15 | 1.32 | 1.36 | 1.35 | 1.32 | 1.33 | 1.35 | 1.35 | 1.39 | 1.47 | 1.56 |
| | 20 | 1.21 | 1.22 | 1.20 | 1.18 | 1.19 | 1.22 | 1.25 | 1.34 | 1.47 | 1.61 |
| | 25 | 0.99 | 1.00 | 1.00 | 1.00 | 1.04 | 1.10 | 1.17 | 1.27 | 1.41 | 1.54 |
| | 30 | 0.71 | 0.70 | 0.70 | 0.73 | 0.81 | 0.92 | 1.03 | 1.13 | 1.26 | 1.36 |
| | 35 | 0.46 | 0.45 | 0.43 | 0.46 | 0.56 | 0.70 | 0.81 | 0.92 | 1.02 | 1.10 |
| | 40 | 0.35 | 0.35 | 0.31 | 0.30 | 0.37 | 0.51 | 0.65 | 0.77 | 0.88 | 0.92 |
| | 45 | 0.33 | 0.31 | 0.24 | 0.18 | 0.23 | 0.38 | 0.59 | 0.83 | 1.01 | 1.04 |
| | 50 | 0.35 | 0.30 | 0.23 | 0.20 | 0.26 | 0.42 | 0.70 | 1.07 | 1.37 | 1.43 |
| | 55 | 0.46 | 0.42 | 0.40 | 0.48 | 0.60 | 0.75 | 0.98 | 1.31 | 1.61 | 1.64 |
| | 60 | 0.71 | 0.70 | 0.77 | 0.93 | 1.10 | 1.19 | 1.26 | 1.37 | 1.46 | 1.39 |
| | 65 | 0.99 | 1.07 | 1.20 | 1.38 | 1.50 | 1.50 | 1.39 | 1.20 | 1.02 | 0.87 |
| | 70 | 1.21 | 1.41 | 1.64 | 1.78 | 1.76 | 1.60 | 1.32 | 0.92 | 0.59 | 0.47 |
| | 75 | 1.32 | 1.54 | 1.86 | 2.01 | 1.84 | 1.50 | 1.09 | 0.64 | 0.31 | 0.26 |
| | 80 | 1.33 | 1.41 | 1.69 | 1.87 | 1.68 | 1.27 | 0.83 | 0.45 | 0.22 | 0.21 |
| | 85 | 1.27 | 1.23 | 1.40 | 1.53 | 1.40 | 1.07 | 0.71 | 0.42 | 0.28 | 0.27 |
| | 90 | 1.20 | 1.06 | 1.11 | 1.19 | 1.12 | 0.88 | 0.59 | 0.40 | 0.33 | 0.33 |

[Table 8B]

| <Example 4> | | | | | | | | | | |
|---|---|---|---|---|---|---|---|---|---|---|
| Average orientation density | | Φ2(y) | | | | | | | | |
| | | 50 | 55 | 60 | 65 | 70 | 75 | 80 | 85 | 90 |
| | 0 | 1.29 | 1.26 | 1.22 | 1.19 | 1.21 | 1.24 | 1.24 | 1.22 | 1.21 |
| | 5 | 1.31 | 1.28 | 1.23 | 1.19 | 1.20 | 1.23 | 1.23 | 1.23 | 1.23 |
| | 10 | 1.43 | 1.40 | 1.35 | 1.30 | 1.30 | 1.30 | 1.27 | 1.26 | 1.26 |
| | 15 | 1.61 | 1.62 | 1.59 | 1.54 | 1.49 | 1.44 | 1.36 | 1.30 | 1.25 |
| | 20 | 1.69 | 1.72 | 1.68 | 1.61 | 1.53 | 1.43 | 1.31 | 1.23 | 1.15 |
| | 25 | 1.59 | 1.57 | 1.50 | 1.40 | 1.29 | 1.18 | 1.07 | 1.01 | 0.94 |

(continued)

| <Example 4> | | | | | | | | | | |
|---|---|---|---|---|---|---|---|---|---|---|
| Average orientation density | | Φ2(y) | | | | | | | | |
| | | 50 | 55 | 60 | 65 | 70 | 75 | 80 | 85 | 90 |
| Φ(x) | 30 | 1.39 | 1.32 | 1.20 | 1.07 | 0.95 | 0.84 | 0.76 | 0.72 | 0.67 |
| | 35 | 1.11 | 1.03 | 0.89 | 0.75 | 0.63 | 0.54 | 0.48 | 0.46 | 0.44 |
| | 40 | 0.87 | 0.75 | 0.59 | 0.45 | 0.35 | 0.29 | 0.28 | 0.31 | 0.33 |
| | 45 | 0.90 | 0.68 | 0.46 | 0.31 | 0.24 | 0.21 | 0.22 | 0.27 | 0.32 |
| | 50 | 1.20 | 0.84 | 0.53 | 0.36 | 0.31 | 0.30 | 0.31 | 0.33 | 0.36 |
| | 55 | 1.35 | 0.90 | 0.55 | 0.41 | 0.42 | 0.45 | 0.47 | 0.48 | 0.49 |
| | 60 | 1.08 | 0.69 | 0.47 | 0.48 | 0.59 | 0.66 | 0.69 | 0.71 | 0.73 |
| | 65 | 0.69 | 0.50 | 0.49 | 0.69 | 0.89 | 0.94 | 0.92 | 0.94 | 0.97 |
| | 70 | 0.47 | 0.50 | 0.66 | 0.94 | 1.12 | 1.09 | 1.04 | 1.09 | 1.14 |
| | 75 | 0.38 | 0.52 | 0.74 | 1.00 | 1.11 | 1.08 | 1.10 | 1.20 | 1.30 |
| | 80 | 0.32 | 0.48 | 0.71 | 0.94 | 1.05 | 1.10 | 1.23 | 1.34 | 1.44 |
| | 85 | 0.33 | 0.47 | 0.70 | 0.94 | 1.09 | 1.20 | 1.34 | 1.37 | 1.41 |
| | 90 | 0.34 | 0.46 | 0.69 | 0.94 | 1.13 | 1.30 | 1.44 | 1.41 | 1.38 |

[Table 9A]

| <Example 4> | | | | | | | | | | | |
|---|---|---|---|---|---|---|---|---|---|---|---|
| Coefficient of variation | | Φ2(y) | | | | | | | | | |
| | | 0 | 5 | 10 | 15 | 20 | 25 | 30 | 35 | 40 | 45 |
| Φ (x) | 0 | 0.30 | 0.30 | 0.30 | 0.30 | 0.29 | 0.30 | 0.33 | 0.30 | 0.31 | 0.35 |
| | 5 | 0.27 | 0.26 | 0.26 | 0.26 | 0.26 | 0.26 | 0.29 | 0.28 | 0.29 | 0.31 |
| | 10 | 0.28 | 0.22 | 0.18 | 0.19 | 0.18 | 0.18 | 0.19 | 0.20 | 0.23 | 0.27 |
| | 15 | 0.28 | 0.19 | 0.13 | 0.13 | 0.10 | 0.12 | 0.13 | 0.18 | 0.30 | 0.38 |
| | 20 | 0.23 | 0.18 | 0.13 | N/A | N/A | 0.18 | 0.22 | 0.29 | 0.37 | 0.43 |
| | 25 | N/A | N/A | N/A | N/A | N/A | N/A | N/A | 0.26 | 0.28 | 0.32 |
| | 30 | N/A | N/A | N/A | N/A | N/A | N/A | N/A | N/A | 0.30 | 0.30 |
| | 35 | N/A | N/A | N/A | N/A | N/A | N/A | N/A | N/A | N/A | N/A |
| | 40 | N/A | N/A | N/A | N/A | N/A | N/A | N/A | N/A | N/A | N/A |
| | 45 | N/A | N/A | N/A | N/A | N/A | N/A | N/A | N/A | N/A | N/A |
| | 50 | N/A | N/A | N/A | N/A | N/A | N/A | N/A | N/A | 0.34 | 0.26 |
| | 55 | N/A | N/A | N/A | N/A | N/A | N/A | N/A | 0.34 | 0.24 | 0.20 |
| | 60 | N/A | N/A | N/A | N/A | N/A | N/A | 0.35 | 0.29 | 0.28 | 0.29 |
| | 65 | N/A | N/A | 0.19 | 0.21 | 0.22 | 0.25 | 0.30 | N/A | N/A | N/A |
| | 70 | 0.23 | 0.27 | 0.27 | 0.21 | 0.14 | 0.19 | 0.28 | N/A | N/A | N/A |
| | 75 | 0.28 | 0.32 | 0.33 | 0.28 | 0.19 | 0.20 | N/A | N/A | N/A | N/A |
| | 80 | 0.28 | 0.30 | 0.34 | 0.34 | 0.28 | 0.20 | N/A | N/A | N/A | N/A |
| | 85 | 0.27 | 0.27 | 0.31 | 0.35 | 0.30 | N/A | N/A | N/A | N/A | N/A |
| | 90 | 0.34 | N/A | N/A | N/A | N/A | N/A | N/A | N/A | N/A | N/A |

[Table 9B]

<Example 4>

| Coefficient of variation | | Φ2(y) | | | | | | | | |
|---|---|---|---|---|---|---|---|---|---|---|
| | | 50 | 55 | 60 | 65 | 70 | 75 | 80 | 85 | 90 |
| Φ (x) | 0 | 0.33 | 0.30 | 0.30 | N/A | 0.32 | 0.29 | 0.29 | 0.30 | 0.44 |
| | 5 | 0.29 | 0.27 | 0.27 | N/A | 0.29 | 0.28 | 0.28 | 0.29 | 0.40 |
| | 10 | 0.29 | 0.29 | 0.29 | 0.32 | 0.31 | 0.31 | 0.32 | 0.32 | 0.41 |
| | 15 | 0.40 | 0.41 | 0.40 | 0.39 | 0.38 | 0.36 | 0.36 | 0.34 | 0.45 |
| | 20 | 0.45 | 0.43 | 0.40 | 0.38 | 0.35 | 0.33 | 0.31 | 0.29 | N/A |
| | 25 | 0.33 | 0.31 | 0.29 | 0.27 | 0.25 | N/A | N/A | N/A | N/A |
| | 30 | 0.31 | 0.30 | 0.28 | N/A | N/A | N/A | N/A | N/A | N/A |
| | 35 | N/A | N/A | N/A | N/A | N/A | N/A | N/A | N/A | N/A |
| | 40 | N/A | N/A | N/A | N/A | N/A | N/A | N/A | N/A | N/A |
| | 45 | N/A | N/A | N/A | N/A | N/A | N/A | N/A | N/A | N/A |
| | 50 | 0.22 | N/A | N/A | N/A | N/A | N/A | N/A | N/A | N/A |
| | 55 | 0.20 | N/A | N/A | N/A | N/A | N/A | N/A | N/A | N/A |
| | 60 | N/A | N/A | N/A | N/A | N/A | N/A | N/A | N/A | N/A |
| | 65 | N/A | N/A | N/A | N/A | N/A | N/A | N/A | N/A | N/A |
| | 70 | N/A | N/A | N/A | N/A | N/A | N/A | N/A | N/A | N/A |
| | 75 | N/A | N/A | N/A | N/A | N/A | N/A | N/A | 0.24 | 0.35 |
| | 80 | N/A | N/A | N/A | N/A | N/A | N/A | 0.18 | 0.23 | 0.33 |
| | 85 | N/A | N/A | N/A | N/A | N/A | 0.28 | 0.25 | 0.25 | 0.33 |
| | 90 | N/A | N/A | N/A | N/A | N/A | 0.38 | 0.34 | 0.33 | 0.41 |

[Table 10A]

<Example 5>

| Average orientation density | | Φ2(y) | | | | | | | | |
|---|---|---|---|---|---|---|---|---|---|---|
| | | 0 | 5 | 10 | 15 | 20 | 25 | 30 | 35 | 40 | 45 |
| Φ (x) | 0 | 1.42 | 1.43 | 1.42 | 1.43 | 1.47 | 1.46 | 1.42 | 1.41 | 1.42 | 1.43 |
| | 5 | 1.36 | 1.36 | 1.34 | 1.34 | 1.37 | 1.37 | 1.35 | 1.34 | 1.35 | 1.36 |
| | 10 | 1.19 | 1.19 | 1.17 | 1.16 | 1.18 | 1.21 | 1.22 | 1.22 | 1.23 | 1.25 |
| | 15 | 0.99 | 1.02 | 1.05 | 1.07 | 1.09 | 1.12 | 1.16 | 1.18 | 1.19 | 1.21 |
| | 20 | 0.87 | 0.92 | 0.99 | 1.03 | 1.05 | 1.07 | 1.12 | 1.16 | 1.18 | 1.18 |
| | 25 | 0.78 | 0.81 | 0.86 | 0.90 | 0.89 | 0.91 | 0.98 | 1.05 | 1.06 | 1.04 |
| | 30 | 0.62 | 0.62 | 0.63 | 0.64 | 0.64 | 0.69 | 0.78 | 0.87 | 0.87 | 0.82 |
| | 35 | 0.42 | 0.40 | 0.39 | 0.42 | 0.46 | 0.53 | 0.62 | 0.70 | 0.69 | 0.63 |
| | 40 | 0.29 | 0.28 | 0.28 | 0.33 | 0.38 | 0.44 | 0.57 | 0.77 | 0.93 | 0.91 |
| | 45 | 0.26 | 0.25 | 0.26 | 0.31 | 0.35 | 0.42 | 0.77 | 1.51 | 2.27 | 2.48 |
| | 50 | 0.29 | 0.27 | 0.26 | 0.31 | 0.34 | 0.48 | 1.20 | 2.73 | 4.41 | 5.05 |
| | 55 | 0.42 | 0.36 | 0.30 | 0.34 | 0.40 | 0.55 | 1.35 | 3.19 | 5.34 | 6.31 |
| | 60 | 0.62 | 0.53 | 0.43 | 0.47 | 0.53 | 0.56 | 0.99 | 2.25 | 3.90 | 4.75 |

(continued)

| <Example 5> | | | | | | | | | | | |
|---|---|---|---|---|---|---|---|---|---|---|---|
| Average orientation density | | Φ2(y) | | | | | | | | | |
| | | 0 | 5 | 10 | 15 | 20 | 25 | 30 | 35 | 40 | 45 |
| | 65 | 0.78 | 0.70 | 0.65 | 0.72 | 0.76 | 0.66 | 0.62 | 1.00 | 1.67 | 2.08 |
| | 70 | 0.87 | 0.84 | 0.87 | 0.96 | 0.98 | 0.80 | 0.58 | 0.50 | 0.55 | 0.62 |
| | 75 | 0.99 | 1.04 | 1.09 | 1.10 | 1.01 | 0.79 | 0.55 | 0.42 | 0.37 | 0.35 |
| | 80 | 1.19 | 1.30 | 1.26 | 1.10 | 0.90 | 0.68 | 0.45 | 0.31 | 0.28 | 0.26 |
| | 85 | 1.36 | 1.43 | 1.30 | 1.04 | 0.83 | 0.69 | 0.52 | 0.34 | 0.25 | 0.23 |
| | 90 | 1.52 | 1.57 | 1.33 | 0.97 | 0.77 | 0.71 | 0.58 | 0.37 | 0.22 | 0.19 |

[Table 10B]

| <Example 5> | | | | | | | | | | |
|---|---|---|---|---|---|---|---|---|---|---|
| Average orientation density | | Φ2(y) | | | | | | | | |
| | | 50 | 55 | 60 | 65 | 70 | 75 | 80 | 85 | 90 |
| Φ(x) | 0 | 1.43 | 1.43 | 1.42 | 1.42 | 1.45 | 1.47 | 1.44 | 1.41 | 1.38 |
| | 5 | 1.37 | 1.37 | 1.37 | 1.38 | 1.42 | 1.43 | 1.39 | 1.35 | 1.32 |
| | 10 | 1.26 | 1.26 | 1.26 | 1.26 | 1.27 | 1.25 | 1.21 | 1.18 | 1.16 |
| | 15 | 1.21 | 1.19 | 1.15 | 1.10 | 1.06 | 1.00 | 0.97 | 0.97 | 0.97 |
| | 20 | 1.16 | 1.12 | 1.05 | 0.97 | 0.87 | 0.80 | 0.79 | 0.83 | 0.87 |
| | 25 | 1.00 | 0.95 | 0.88 | 0.80 | 0.70 | 0.64 | 0.68 | 0.75 | 0.81 |
| | 30 | 0.77 | 0.73 | 0.68 | 0.60 | 0.50 | 0.45 | 0.50 | 0.59 | 0.68 |
| | 35 | 0.57 | 0.55 | 0.54 | 0.48 | 0.36 | 0.28 | 0.31 | 0.39 | 0.47 |
| | 40 | 0.72 | 0.54 | 0.45 | 0.41 | 0.33 | 0.23 | 0.22 | 0.26 | 0.31 |
| | 45 | 1.96 | 1.14 | 0.58 | 0.38 | 0.32 | 0.24 | 0.20 | 0.23 | 0.26 |
| | 50 | 4.14 | 2.41 | 1.04 | 0.47 | 0.36 | 0.28 | 0.23 | 0.25 | 0.28 |
| | 55 | 5.33 | 3.19 | 1.40 | 0.63 | 0.48 | 0.40 | 0.32 | 0.37 | 0.41 |
| | 60 | 4.11 | 2.54 | 1.20 | 0.67 | 0.61 | 0.58 | 0.53 | 0.58 | 0.63 |
| | 65 | 1.88 | 1.28 | 0.77 | 0.64 | 0.74 | 0.80 | 0.79 | 0.79 | 0.79 |
| | 70 | 0.64 | 0.63 | 0.63 | 0.72 | 0.90 | 1.04 | 1.03 | 0.94 | 0.85 |
| | 75 | 0.37 | 0.47 | 0.61 | 0.80 | 1.04 | 1.19 | 1.15 | 1.03 | 0.91 |
| | 80 | 0.26 | 0.34 | 0.53 | 0.78 | 1.04 | 1.16 | 1.13 | 1.10 | 1.06 |
| | 85 | 0.24 | 0.35 | 0.55 | 0.78 | 0.94 | 1.03 | 1.10 | 1.20 | 1.30 |
| | 90 | 0.22 | 0.35 | 0.58 | 0.78 | 0.85 | 0.91 | 1.06 | 1.30 | 1.54 |

[Table 11A]

| <Example 5> | | | | | | | | | | | |
|---|---|---|---|---|---|---|---|---|---|---|---|
| Coefficient of variation | | Φ2(y) | | | | | | | | | |
| | | 0 | 5 | 10 | 15 | 20 | 25 | 30 | 35 | 40 | 45 |
| | 0 | 0.15 | 0.15 | 0.15 | 0.14 | 0.17 | 0.17 | 0.15 | 0.17 | 0.15 | 0.14 |
| | 5 | 0.14 | 0.13 | 0.13 | 0.12 | 0.16 | 0.18 | 0.15 | 0.16 | 0.15 | 0.15 |
| | 10 | N/A | N/A | N/A | N/A | N/A | 0.18 | 0.16 | 0.16 | 0.16 | 0.15 |

(continued)

| <Example 5> Coefficient of variation | | Φ2(y) | | | | | | | | | |
|---|---|---|---|---|---|---|---|---|---|---|---|
| | | 0 | 5 | 10 | 15 | 20 | 25 | 30 | 35 | 40 | 45 |
| Φ (x) | 15 | N/A | N/A | N/A | N/A | N/A | N/A | N/A | N/A | N/A | 0.14 |
| | 20 | N/A | N/A | N/A | N/A | N/A | N/A | N/A | N/A | N/A | N/A |
| | 25 | N/A | N/A | N/A | N/A | N/A | N/A | N/A | N/A | N/A | N/A |
| | 30 | N/A | N/A | N/A | N/A | N/A | N/A | N/A | N/A | N/A | N/A |
| | 35 | N/A | N/A | N/A | N/A | N/A | N/A | N/A | N/A | N/A | N/A |
| | 40 | N/A | N/A | N/A | N/A | N/A | N/A | N/A | N/A | N/A | N/A |
| | 45 | N/A | N/A | N/A | N/A | N/A | N/A | N/A | 0.23 | 0.17 | 0.13 |
| | 50 | N/A | N/A | N/A | N/A | N/A | N/A | N/A | 0.18 | 0.13 | 0.11 |
| | 55 | N/A | N/A | N/A | N/A | N/A | N/A | 0.18 | 0.10 | 0.09 | 0.10 |
| | 60 | N/A | N/A | N/A | N/A | N/A | N/A | N/A | 0.07 | 0.08 | 0.13 |
| | 65 | N/A | N/A | N/A | N/A | N/A | N/A | N/A | N/A | 0.19 | 0.24 |
| | 70 | N/A | N/A | N/A | N/A | N/A | N/A | N/A | N/A | N/A | N/A |
| | 75 | N/A | N/A | N/A | N/A | N/A | N/A | N/A | N/A | N/A | N/A |
| | 80 | N/A | 0.11 | 0.13 | N/A | N/A | N/A | N/A | N/A | N/A | N/A |
| | 85 | 0.14 | 0.14 | 0.11 | N/A | N/A | N/A | N/A | N/A | N/A | N/A |
| | 90 | 0.18 | 0.19 | 0.21 | N/A | N/A | N/A | N/A | N/A | N/A | N/A |

[Table 11B]

| <Example 5> Coefficient of variation | | Φ2(y) | | | | | | | | |
|---|---|---|---|---|---|---|---|---|---|---|
| | | 50 | 55 | 60 | 65 | 70 | 75 | 80 | 85 | 90 |
| Φ (x) | 0 | 0.14 | 0.15 | 0.15 | 0.15 | 0.16 | 0.18 | 0.15 | 0.17 | 0.31 |
| | 5 | 0.14 | 0.14 | 0.14 | 0.13 | 0.15 | 0.17 | 0.14 | 0.15 | 0.27 |
| | 10 | 0.14 | 0.13 | 0.13 | 0.12 | 0.15 | 0.15 | 0.14 | N/A | N/A |
| | 15 | 0.15 | N/A | N/A | N/A | N/A | N/A | N/A | N/A | N/A |
| | 20 | N/A | N/A | N/A | N/A | N/A | N/A | N/A | N/A | N/A |
| | 25 | N/A | N/A | N/A | N/A | N/A | N/A | N/A | N/A | N/A |
| | 30 | N/A | N/A | N/A | N/A | N/A | N/A | N/A | N/A | N/A |
| | 35 | N/A | N/A | N/A | N/A | N/A | N/A | N/A | N/A | N/A |
| | 40 | N/A | N/A | N/A | N/A | N/A | N/A | N/A | N/A | N/A |
| | 45 | 0.11 | N/A | N/A | N/A | N/A | N/A | N/A | N/A | N/A |
| | 50 | 0.13 | 0.23 | N/A | N/A | N/A | N/A | N/A | N/A | N/A |
| | 55 | 0.12 | 0.19 | 0.29 | N/A | N/A | N/A | N/A | N/A | N/A |
| | 60 | 0.13 | 0.14 | N/A | N/A | N/A | N/A | N/A | N/A | N/A |
| | 65 | 0.24 | 0.21 | N/A | N/A | N/A | N/A | N/A | N/A | N/A |
| | 70 | N/A | N/A | N/A | N/A | N/A | N/A | N/A | N/A | N/A |
| | 75 | N/A | N/A | N/A | N/A | N/A | N/A | N/A | N/A | N/A |

(continued)

| <Example 5> | | | | | | | | | | |
|---|---|---|---|---|---|---|---|---|---|---|
| Coefficient of variation | | Φ2(y) | | | | | | | | |
| | | 50 | 55 | 60 | 65 | 70 | 75 | 80 | 85 | 90 |
| | 80 | N/A | N/A | N/A | N/A | N/A | N/A | N/A | N/A | N/A |
| | 85 | N/A | N/A | N/A | N/A | N/A | N/A | N/A | N/A | 0.14 |
| | 90 | N/A | N/A | N/A | N/A | N/A | N/A | N/A | 0.15 | 0.18 |

[Table 12A]

| <Example 6> | | | | | | | | | | |
|---|---|---|---|---|---|---|---|---|---|---|
| Average orientation density | | Φ2(y) | | | | | | | | |
| | | 0 | 5 | 10 | 15 | 20 | 25 | 30 | 35 | 40 | 45 |
| Φ (x) | 0 | 0.63 | 0.63 | 0.64 | 0.65 | 0.66 | 0.66 | 0.65 | 0.64 | 0.65 | 0.66 |
| | 5 | 0.71 | 0.72 | 0.74 | 0.77 | 0.77 | 0.77 | 0.75 | 0.73 | 0.72 | 0.73 |
| | 10 | 0.70 | 0.72 | 0.76 | 0.80 | 0.81 | 0.79 | 0.77 | 0.74 | 0.72 | 0.71 |
| | 15 | 0.37 | 0.40 | 0.46 | 0.52 | 0.57 | 0.61 | 0.64 | 0.64 | 0.63 | 0.62 |
| | 20 | 0.04 | 0.06 | 0.14 | 0.25 | 0.38 | 0.53 | 0.65 | 0.72 | 0.74 | 0.74 |
| | 25 | 0.02 | 0.02 | 0.04 | 0.12 | 0.26 | 0.43 | 0.59 | 0.69 | 0.73 | 0.73 |
| | 30 | 0.15 | 0.10 | 0.01 | 0.00 | 0.03 | 0.18 | 0.34 | 0.48 | 0.56 | 0.58 |
| | 35 | 0.14 | 0.07 | 0.00 | 0.00 | 0.00 | 0.09 | 0.33 | 0.65 | 0.91 | 0.99 |
| | 40 | 0.01 | 0.00 | 0.01 | 0.04 | 0.07 | 0.13 | 0.50 | 1.35 | 2.28 | 2.62 |
| | 45 | 0.00 | 0.00 | 0.07 | 0.20 | 0.10 | 0.02 | 0.73 | 2.86 | 5.42 | 6.52 |
| | 50 | 0.01 | 0.00 | 0.02 | 0.14 | 0.05 | 0.07 | 1.60 | 5.51 | 10.19 | 12.34 |
| | 55 | 0.14 | 0.02 | 0.00 | 0.02 | 0.19 | 0.67 | 2.79 | 7.38 | 12.74 | 15.32 |
| | 60 | 0.15 | 0.05 | 0.00 | 0.05 | 0.39 | 1.08 | 2.84 | 6.03 | 9.55 | 11.32 |
| | 65 | 0.02 | 0.05 | 0.14 | 0.28 | 0.46 | 0.88 | 1.71 | 2.77 | 3.66 | 4.13 |
| | 70 | 0.04 | 0.12 | 0.37 | 0.55 | 0.54 | 0.54 | 0.70 | 0.72 | 0.44 | 0.28 |
| | 75 | 0.37 | 0.35 | 0.46 | 0.61 | 0.58 | 0.36 | 0.19 | 0.15 | 0.09 | 0.05 |
| | 80 | 0.70 | 0.59 | 0.48 | 0.47 | 0.41 | 0.19 | 0.00 | 0.00 | 0.08 | 0.19 |
| | 85 | 0.71 | 0.69 | 0.59 | 0.35 | 0.14 | 0.06 | 0.03 | 0.00 | 0.00 | 0.00 |
| | 90 | 0.72 | 0.78 | 0.69 | 0.24 | -0.13 | -0.07 | 0.05 | 0.01 | -0.07 | -0.19 |

[Table 12B]

| <Example 6> | | | | | | | | | | |
|---|---|---|---|---|---|---|---|---|---|---|
| Average orientation density | | Φ2(y) | | | | | | | | |
| | | 50 | 55 | 60 | 65 | 70 | 75 | 80 | 85 | 90 |
| | 0 | 0.66 | 0.65 | 0.64 | 0.65 | 0.66 | 0.66 | 0.65 | 0.64 | 0.63 |
| | 5 | 0.73 | 0.71 | 0.70 | 0.70 | 0.70 | 0.71 | 0.71 | 0.71 | 0.72 |
| | 10 | 0.70 | 0.67 | 0.64 | 0.63 | 0.63 | 0.64 | 0.67 | 0.69 | 0.72 |
| | 15 | 0.59 | 0.53 | 0.47 | 0.42 | 0.38 | 0.35 | 0.35 | 0.36 | 0.37 |
| | 20 | 0.69 | 0.59 | 0.48 | 0.37 | 0.27 | 0.16 | 0.08 | 0.05 | 0.01 |
| | 25 | 0.69 | 0.59 | 0.46 | 0.33 | 0.21 | 0.10 | 0.05 | 0.03 | 0.01 |

(continued)

| <Example 6> | | | | | | | | | | |
|---|---|---|---|---|---|---|---|---|---|---|
| Average orientation density | | Φ2(y) | | | | | | | | |
| | | 50 | 55 | 60 | 65 | 70 | 75 | 80 | 85 | 90 |
| Φ (x) | 30 | 0.54 | 0.45 | 0.30 | 0.13 | 0.02 | 0.01 | 0.03 | 0.12 | 0.20 |
| | 35 | 0.86 | 0.61 | 0.34 | 0.10 | 0.00 | 0.00 | 0.00 | 0.07 | 0.14 |
| | 40 | 2.11 | 1.18 | 0.45 | 0.15 | 0.09 | 0.03 | 0.00 | 0.00 | 0.00 |
| | 45 | 5.23 | 2.64 | 0.62 | 0.01 | 0.12 | 0.19 | 0.06 | 0.00 | -0.06 |
| | 50 | 10.23 | 5.57 | 1.65 | 0.10 | 0.06 | 0.14 | 0.03 | 0.00 | -0.02 |
| | 55 | 13.15 | 7.91 | 3.14 | 0.78 | 0.19 | 0.02 | 0.00 | 0.02 | 0.04 |
| | 60 | 10.10 | 6.71 | 3.26 | 1.21 | 0.40 | 0.07 | 0.00 | 0.03 | 0.06 |
| | 65 | 4.01 | 3.18 | 1.94 | 0.96 | 0.54 | 0.38 | 0.20 | 0.05 | -0.10 |
| | 70 | 0.53 | 0.82 | 0.77 | 0.64 | 0.71 | 0.76 | 0.53 | 0.20 | -0.14 |
| | 75 | 0.09 | 0.15 | 0.24 | 0.49 | 0.81 | 0.89 | 0.70 | 0.48 | 0.27 |
| | 80 | 0.08 | 0.00 | 0.00 | 0.27 | 0.59 | 0.72 | 0.72 | 0.72 | 0.73 |
| | 85 | 0.01 | 0.01 | 0.01 | 0.06 | 0.22 | 0.50 | 0.73 | 0.77 | 0.81 |
| | 90 | -0.07 | 0.01 | 0.02 | -0.15 | -0.16 | 0.27 | 0.74 | 0.81 | 0.88 |

[Table 13A]

| <Example 6> | | | | | | | | | | |
|---|---|---|---|---|---|---|---|---|---|---|
| Coefficient of variation | | Φ2(y) | | | | | | | | |
| | | 0 | 5 | 10 | 15 | 20 | 25 | 30 | 35 | 40 | 45 |
| Φ (x) | 0 | N/A | N/A | N/A | N/A | N/A | N/A | N/A | N/A | N/A | N/A |
| | 5 | N/A | N/A | N/A | N/A | N/A | N/A | N/A | N/A | N/A | N/A |
| | 10 | N/A | N/A | N/A | N/A | N/A | N/A | N/A | N/A | N/A | N/A |
| | 15 | N/A | N/A | N/A | N/A | N/A | N/A | N/A | N/A | N/A | N/A |
| | 20 | N/A | N/A | N/A | N/A | N/A | N/A | N/A | N/A | N/A | N/A |
| | 25 | N/A | N/A | N/A | N/A | N/A | N/A | N/A | N/A | N/A | N/A |
| | 30 | N/A | N/A | N/A | N/A | N/A | N/A | N/A | N/A | N/A | N/A |
| | 35 | N/A | N/A | N/A | N/A | N/A | N/A | N/A | N/A | N/A | N/A |
| | 40 | N/A | N/A | N/A | N/A | N/A | N/A | N/A | 0.14 | 0.12 | 0.13 |
| | 45 | N/A | N/A | N/A | N/A | N/A | N/A | N/A | 0.13 | 0.10 | 0.09 |
| | 50 | N/A | N/A | N/A | N/A | N/A | N/A | 0.07 | 0.05 | 0.04 | 0.04 |
| | 55 | N/A | N/A | N/A | N/A | N/A | N/A | 0.10 | 0.05 | 0.03 | 0.02 |
| | 60 | N/A | N/A | N/A | N/A | N/A | N/A | 0.10 | 0.09 | 0.05 | 0.02 |
| | 65 | N/A | N/A | N/A | N/A | N/A | N/A | 0.06 | 0.10 | 0.08 | 0.05 |
| | 70 | N/A | N/A | N/A | N/A | N/A | N/A | N/A | N/A | N/A | N/A |
| | 75 | N/A | N/A | N/A | N/A | N/A | N/A | N/A | N/A | N/A | N/A |
| | 80 | N/A | N/A | N/A | N/A | N/A | N/A | N/A | N/A | N/A | N/A |
| | 85 | N/A | N/A | N/A | N/A | N/A | N/A | N/A | N/A | N/A | N/A |
| | 90 | N/A | N/A | N/A | N/A | N/A | N/A | N/A | N/A | N/A | N/A |

[Table 13B]

<Example 6>

| Coefficient of variation | | Φ2(y) | | | | | | | | |
|---|---|---|---|---|---|---|---|---|---|---|
| | | 50 | 55 | 60 | 65 | 70 | 75 | 80 | 85 | 90 |
| Φ (x) | 0 | N/A | N/A | N/A | N/A | N/A | N/A | N/A | N/A | N/A |
| | 5 | N/A | N/A | N/A | N/A | N/A | N/A | N/A | N/A | N/A |
| | 10 | N/A | N/A | N/A | N/A | N/A | N/A | N/A | N/A | N/A |
| | 15 | N/A | N/A | N/A | N/A | N/A | N/A | N/A | N/A | N/A |
| | 20 | N/A | N/A | N/A | N/A | N/A | N/A | N/A | N/A | N/A |
| | 25 | N/A | N/A | N/A | N/A | N/A | N/A | N/A | N/A | N/A |
| | 30 | N/A | N/A | N/A | N/A | N/A | N/A | N/A | N/A | N/A |
| | 35 | N/A | N/A | N/A | N/A | N/A | N/A | N/A | N/A | N/A |
| | 40 | 0.13 | N/A | N/A | N/A | N/A | N/A | N/A | N/A | N/A |
| | 45 | 0.09 | 0.10 | N/A | N/A | N/A | N/A | N/A | N/A | N/A |
| | 50 | 0.03 | 0.03 | 0.11 | N/A | N/A | N/A | N/A | N/A | N/A |
| | 55 | 0.01 | 0.04 | 0.10 | N/A | N/A | N/A | N/A | N/A | N/A |
| | 60 | 0.03 | 0.05 | 0.08 | 0.14 | N/A | N/A | N/A | N/A | N/A |
| | 65 | 0.08 | 0.09 | 0.11 | N/A | N/A | N/A | N/A | N/A | N/A |
| | 70 | N/A | N/A | N/A | N/A | N/A | N/A | N/A | N/A | N/A |
| | 75 | N/A | N/A | N/A | N/A | N/A | N/A | N/A | N/A | N/A |
| | 80 | N/A | N/A | N/A | N/A | N/A | N/A | N/A | N/A | N/A |
| | 85 | N/A | N/A | N/A | N/A | N/A | N/A | N/A | N/A | N/A |
| | 90 | N/A | N/A | N/A | N/A | N/A | N/A | N/A | N/A | N/A |

[Table 14A]

<Example 7>

| Average orientation density | | Φ2(y) | | | | | | | | | |
|---|---|---|---|---|---|---|---|---|---|---|---|
| | | 0 | 5 | 10 | 15 | 20 | 25 | 30 | 35 | 40 | 45 |
| Φ (x) | 0 | 0.31 | 0.31 | 0.30 | 0.28 | 0.28 | 0.28 | 0.29 | 0.28 | 0.28 | 0.28 |
| | 5 | 0.37 | 0.37 | 0.37 | 0.36 | 0.35 | 0.35 | 0.35 | 0.35 | 0.34 | 0.35 |
| | 10 | 0.42 | 0.43 | 0.44 | 0.44 | 0.43 | 0.43 | 0.43 | 0.43 | 0.43 | 0.44 |
| | 15 | 0.29 | 0.29 | 0.32 | 0.35 | 0.39 | 0.43 | 0.47 | 0.49 | 0.50 | 0.52 |
| | 20 | 0.04 | 0.05 | 0.11 | 0.20 | 0.31 | 0.42 | 0.50 | 0.53 | 0.54 | 0.55 |
| | 25 | 0.01 | 0.01 | 0.03 | 0.07 | 0.18 | 0.31 | 0.40 | 0.45 | 0.46 | 0.46 |
| | 30 | 0.20 | 0.11 | 0.00 | 0.00 | 0.00 | 0.13 | 0.32 | 0.45 | 0.53 | 0.57 |
| | 35 | 0.29 | 0.14 | 0.00 | 0.00 | 0.00 | 0.16 | 0.39 | 0.60 | 0.80 | 0.94 |
| | 40 | 0.10 | 0.01 | 0.00 | 0.00 | 0.14 | 0.22 | 0.33 | 0.83 | 1.63 | 2.11 |
| | 45 | 0.01 | 0.00 | 0.00 | 0.21 | 0.29 | 0.06 | 0.43 | 2.47 | 5.43 | 6.95 |
| | 50 | 0.10 | 0.00 | 0.00 | 0.17 | 0.19 | 0.07 | 1.49 | 6.26 | 12.52 | 15.57 |
| | 55 | 0.29 | 0.04 | 0.00 | 0.01 | 0.24 | 0.48 | 2.73 | 8.78 | 16.42 | 20.06 |
| | 60 | 0.20 | 0.01 | 0.00 | 0.08 | 0.50 | 0.95 | 2.59 | 6.68 | 11.81 | 14.24 |

(continued)

| <Example 7> | | | | | | | | | | |
|---|---|---|---|---|---|---|---|---|---|---|
| Average orientation density | | Φ2(y) | | | | | | | | |
| | | 0 | 5 | 10 | 15 | 20 | 25 | 30 | 35 | 40 | 45 |
| | 65 | 0.01 | 0.04 | 0.12 | 0.31 | 0.59 | 0.96 | 1.54 | 2.61 | 3.92 | 4.53 |
| | 70 | 0.04 | 0.22 | 0.45 | 0.46 | 0.48 | 0.71 | 0.86 | 0.66 | 0.30 | 0.14 |
| | 75 | 0.29 | 0.42 | 0.58 | 0.57 | 0.48 | 0.43 | 0.36 | 0.24 | 0.19 | 0.21 |
| | 80 | 0.42 | 0.46 | 0.54 | 0.59 | 0.48 | 0.18 | 0.00 | 0.00 | 0.03 | 0.18 |
| | 85 | 0.37 | 0.39 | 0.46 | 0.43 | 0.25 | 0.05 | 0.00 | 0.00 | 0.00 | 0.00 |
| | 90 | 0.31 | 0.32 | 0.37 | 0.27 | 0.01 | -0.09 | 0.00 | 0.00 | -0.03 | -0.18 |

[Table 14B]

| <Example 7> | | | | | | | | | | |
|---|---|---|---|---|---|---|---|---|---|---|
| Average orientation density | | Φ2(y) | | | | | | | | |
| | | 50 | 55 | 60 | 65 | 70 | 75 | 80 | 85 | 90 |
| Φ (x) | 0 | 0.29 | 0.28 | 0.28 | 0.29 | 0.29 | 0.28 | 0.29 | 0.30 | 0.31 |
| | 5 | 0.36 | 0.35 | 0.34 | 0.35 | 0.35 | 0.34 | 0.35 | 0.36 | 0.37 |
| | 10 | 0.46 | 0.45 | 0.44 | 0.44 | 0.44 | 0.42 | 0.42 | 0.42 | 0.42 |
| | 15 | 0.54 | 0.53 | 0.50 | 0.48 | 0.44 | 0.39 | 0.34 | 0.30 | 0.27 |
| | 20 | 0.56 | 0.56 | 0.53 | 0.48 | 0.39 | 0.27 | 0.16 | 0.08 | 0.00 |
| | 25 | 0.47 | 0.47 | 0.44 | 0.34 | 0.21 | 0.10 | 0.04 | 0.02 | 0.00 |
| | 30 | 0.59 | 0.55 | 0.41 | 0.17 | 0.01 | 0.00 | 0.00 | 0.12 | 0.23 |
| | 35 | 0.95 | 0.80 | 0.53 | 0.19 | 0.00 | 0.00 | 0.00 | 0.16 | 0.32 |
| | 40 | 1.82 | 1.05 | 0.44 | 0.21 | 0.11 | 0.01 | 0.00 | 0.02 | 0.04 |
| | 45 | 5.61 | 2.65 | 0.47 | 0.04 | 0.26 | 0.22 | 0.00 | 0.00 | 0.00 |
| | 50 | 12.70 | 6.42 | 1.52 | 0.04 | 0.20 | 0.19 | 0.00 | 0.00 | 0.00 |
| | 55 | 16.54 | 8.88 | 2.73 | 0.47 | 0.26 | 0.03 | 0.00 | 0.03 | 0.06 |
| | 60 | 11.81 | 6.61 | 2.47 | 0.87 | 0.50 | 0.09 | 0.00 | 0.01 | 0.03 |
| | 65 | 3.83 | 2.41 | 1.31 | 0.83 | 0.58 | 0.32 | 0.11 | 0.04 | -0.04 |
| | 70 | 0.25 | 0.51 | 0.67 | 0.62 | 0.49 | 0.46 | 0.40 | 0.18 | -0.05 |
| | 75 | 0.21 | 0.22 | 0.31 | 0.40 | 0.47 | 0.52 | 0.51 | 0.37 | 0.23 |
| | 80 | 0.05 | 0.00 | 0.00 | 0.17 | 0.43 | 0.51 | 0.49 | 0.45 | 0.41 |
| | 85 | 0.00 | 0.00 | 0.00 | 0.04 | 0.19 | 0.37 | 0.45 | 0.42 | 0.39 |
| | 90 | -0.05 | 0.00 | 0.00 | -0.09 | -0.05 | 0.23 | 0.41 | 0.39 | 0.37 |

[Table 15A]

| <Example 7> | | | | | | | | | | |
|---|---|---|---|---|---|---|---|---|---|---|
| Coefficient of variation | | Φ2(y) | | | | | | | | |
| | | 0 | 5 | 10 | 15 | 20 | 25 | 30 | 35 | 40 | 45 |
| | 0 | N/A | N/A | N/A | N/A | N/A | N/A | N/A | N/A | N/A | N/A |
| | 5 | N/A | N/A | N/A | N/A | N/A | N/A | N/A | N/A | N/A | N/A |
| | 10 | N/A | N/A | N/A | N/A | N/A | N/A | N/A | N/A | N/A | N/A |

(continued)

| <Example 7> | | | | | | | | | | | | |
|---|---|---|---|---|---|---|---|---|---|---|---|---|
| Coefficient of variation | | Φ2(y) | | | | | | | | | | |
| | | 0 | 5 | 10 | 15 | 20 | 25 | 30 | 35 | 40 | 45 |
| Φ (x) | 15 | N/A | N/A | N/A | N/A | N/A | N/A | N/A | N/A | N/A | N/A |
| | 20 | N/A | N/A | N/A | N/A | N/A | N/A | N/A | N/A | N/A | N/A |
| | 25 | N/A | N/A | N/A | N/A | N/A | N/A | N/A | N/A | N/A | N/A |
| | 30 | N/A | N/A | N/A | N/A | N/A | N/A | N/A | N/A | N/A | N/A |
| | 35 | N/A | N/A | N/A | N/A | N/A | N/A | N/A | N/A | N/A | N/A |
| | 40 | N/A | N/A | N/A | N/A | N/A | N/A | N/A | N/A | 0.19 | 0.16 |
| | 45 | N/A | N/A | N/A | N/A | N/A | N/A | N/A | 0.16 | 0.11 | 0.09 |
| | 50 | N/A | N/A | N/A | N/A | N/A | N/A | 0.19 | 0.07 | 0.05 | 0.04 |
| | 55 | N/A | N/A | N/A | N/A | N/A | N/A | 0.16 | 0.07 | 0.03 | 0.03 |
| | 60 | N/A | N/A | N/A | N/A | N/A | N/A | 0.18 | 0.10 | 0.05 | 0.04 |
| | 65 | N/A | N/A | N/A | N/A | N/A | N/A | 0.16 | 0.15 | 0.11 | 0.09 |
| | 70 | N/A | N/A | N/A | N/A | N/A | N/A | N/A | N/A | N/A | N/A |
| | 75 | N/A | N/A | N/A | N/A | N/A | N/A | N/A | N/A | N/A | N/A |
| | 80 | N/A | N/A | N/A | N/A | N/A | N/A | N/A | N/A | N/A | N/A |
| | 85 | N/A | N/A | N/A | N/A | N/A | N/A | N/A | N/A | N/A | N/A |
| | 90 | N/A | N/A | N/A | N/A | N/A | N/A | N/A | N/A | N/A | N/A |

[Table 15B]

| <Example 7> | | | | | | | | | | | | |
|---|---|---|---|---|---|---|---|---|---|---|---|---|
| Coefficient of variation | | Φ2(y) | | | | | | | | | | |
| | | 50 | 55 | 60 | 65 | 70 | 75 | 80 | 85 | 90 |
| Φ (x) | 0 | N/A | N/A | N/A | N/A | N/A | N/A | N/A | N/A | N/A |
| | 5 | N/A | N/A | N/A | N/A | N/A | N/A | N/A | N/A | N/A |
| | 10 | N/A | N/A | N/A | N/A | N/A | N/A | N/A | N/A | N/A |
| | 15 | N/A | N/A | N/A | N/A | N/A | N/A | N/A | N/A | N/A |
| | 20 | N/A | N/A | N/A | N/A | N/A | N/A | N/A | N/A | N/A |
| | 25 | N/A | N/A | N/A | N/A | N/A | N/A | N/A | N/A | N/A |
| | 30 | N/A | N/A | N/A | N/A | N/A | N/A | N/A | N/A | N/A |
| | 35 | N/A | N/A | N/A | N/A | N/A | N/A | N/A | N/A | N/A |
| | 40 | 0.14 | N/A | N/A | N/A | N/A | N/A | N/A | N/A | N/A |
| | 45 | 0.09 | 0.13 | N/A | N/A | N/A | N/A | N/A | N/A | N/A |
| | 50 | 0.05 | 0.07 | 0.17 | N/A | N/A | N/A | N/A | N/A | N/A |
| | 55 | 0.04 | 0.06 | 0.12 | N/A | N/A | N/A | N/A | N/A | N/A |
| | 60 | 0.06 | 0.09 | 0.12 | N/A | N/A | N/A | N/A | N/A | N/A |
| | 65 | 0.12 | 0.16 | 0.14 | N/A | N/A | N/A | N/A | N/A | N/A |
| | 70 | N/A | N/A | N/A | N/A | N/A | N/A | N/A | N/A | N/A |
| | 75 | N/A | N/A | N/A | N/A | N/A | N/A | N/A | N/A | N/A |

(continued)

| <Example 7> | | | | | | | | | | |
|---|---|---|---|---|---|---|---|---|---|---|
| Coefficient of variation | | Φ2(y) | | | | | | | | |
| | | 50 | 55 | 60 | 65 | 70 | 75 | 80 | 85 | 90 |
| | 80 | N/A | N/A | N/A | N/A | N/A | N/A | N/A | N/A | N/A |
| | 85 | N/A | N/A | N/A | N/A | N/A | N/A | N/A | N/A | N/A |
| | 90 | N/A | N/A | N/A | N/A | N/A | N/A | N/A | N/A | N/A |

[Table 16A]

| <Comparative Example 1> | | | | | | | | | | |
|---|---|---|---|---|---|---|---|---|---|---|
| Average orientation density | | Φ2(y) | | | | | | | | |
| | | 0 | 5 | 10 | 15 | 20 | 25 | 30 | 35 | 40 | 45 |
| Φ (x) | 0 | 2.96 | 2.97 | 3.02 | 3.09 | 3.13 | 3.16 | 3.23 | 3.30 | 3.23 | 3.04 |
| | 5 | 2.86 | 2.84 | 2.86 | 2.93 | 3.02 | 3.04 | 3.04 | 3.06 | 3.05 | 3.00 |
| | 10 | 2.43 | 2.36 | 2.30 | 2.36 | 2.50 | 2.52 | 2.40 | 2.32 | 2.40 | 2.57 |
| | 15 | 1.68 | 1.59 | 1.50 | 1.53 | 1.69 | 1.72 | 1.55 | 1.39 | 1.43 | 1.59 |
| | 20 | 0.96 | 0.95 | 0.98 | 1.10 | 1.25 | 1.31 | 1.18 | 1.00 | 0.84 | 0.72 |
| | 25 | 0.57 | 0.67 | 0.85 | 1.08 | 1.26 | 1.29 | 1.22 | 1.07 | 0.81 | 0.48 |
| | 30 | 0.37 | 0.48 | 0.65 | 0.82 | 0.91 | 0.97 | 1.03 | 1.06 | 0.96 | 0.71 |
| | 35 | 0.21 | 0.22 | 0.21 | 0.20 | 0.22 | 0.30 | 0.48 | 0.75 | 0.96 | 0.96 |
| | 40 | 0.10 | 0.08 | 0.06 | 0.03 | 0.05 | 0.09 | 0.22 | 0.48 | 0.76 | 0.89 |
| | 45 | 0.10 | 0.12 | 0.12 | 0.16 | 0.20 | 0.20 | 0.19 | 0.25 | 0.40 | 0.47 |
| | 50 | 0.10 | 0.16 | 0.17 | 0.16 | 0.15 | 0.13 | 0.09 | 0.08 | 0.10 | 0.07 |
| | 55 | 0.21 | 0.22 | 0.12 | 0.08 | 0.10 | 0.08 | 0.08 | 0.09 | 0.07 | 0.03 |
| | 60 | 0.37 | 0.40 | 0.31 | 0.32 | 0.52 | 0.70 | 0.63 | 0.35 | 0.11 | 0.06 |
| | 65 | 0.57 | 0.62 | 0.58 | 0.59 | 0.96 | 1.33 | 1.10 | 0.46 | 0.10 | 0.10 |
| | 70 | 0.96 | 1.09 | 0.79 | 0.41 | 0.62 | 1.06 | 0.86 | 0.28 | 0.07 | 0.16 |
| | 75 | 1.68 | 1.82 | 1.24 | 0.49 | 0.34 | 0.58 | 0.43 | 0.09 | 0.08 | 0.21 |
| | 80 | 2.43 | 2.53 | 2.01 | 1.24 | 0.76 | 0.58 | 0.32 | 0.09 | 0.15 | 0.17 |
| | 85 | 2.86 | 2.89 | 2.55 | 1.84 | 1.10 | 0.62 | 0.37 | 0.17 | 0.14 | 0.10 |
| | 90 | 3.29 | 3.26 | 3.08 | 2.44 | 1.45 | 0.66 | 0.41 | 0.25 | 0.14 | 0.02 |

[Table 16B]

| <Comparative Example 1> | | | | | | | | | | |
|---|---|---|---|---|---|---|---|---|---|---|
| Average orientation density | | Φ2(y) | | | | | | | | |
| | | 50 | 55 | 60 | 65 | 70 | 75 | 80 | 85 | 90 |
| | 0 | 3.01 | 3.20 | 3.33 | 3.25 | 3.12 | 3.07 | 3.05 | 3.00 | 2.95 |
| | 5 | 3.03 | 3.15 | 3.20 | 3.14 | 3.08 | 3.06 | 3.01 | 2.92 | 2.82 |
| | 10 | 2.69 | 2.69 | 2.63 | 2.62 | 2.71 | 2.77 | 2.67 | 2.52 | 2.37 |
| | 15 | 1.68 | 1.63 | 1.57 | 1.65 | 1.85 | 1.97 | 1.90 | 1.76 | 1.62 |
| | 20 | 0.64 | 0.60 | 0.60 | 0.73 | 0.93 | 1.07 | 1.06 | 0.99 | 0.92 |
| | 25 | 0.23 | 0.16 | 0.22 | 0.30 | 0.40 | 0.50 | 0.56 | 0.56 | 0.56 |

(continued)

<Comparative Example 1>

| Average orientation density | | Φ2(y) | | | | | | | | |
|---|---|---|---|---|---|---|---|---|---|---|
| | | 50 | 55 | 60 | 65 | 70 | 75 | 80 | 85 | 90 |
| Φ (x) | 30 | 0.42 | 0.27 | 0.22 | 0.20 | 0.21 | 0.28 | 0.35 | 0.37 | 0.39 |
| | 35 | 0.73 | 0.42 | 0.17 | 0.05 | 0.04 | 0.08 | 0.15 | 0.19 | 0.23 |
| | 40 | 0.72 | 0.39 | 0.16 | 0.05 | 0.05 | 0.10 | 0.11 | 0.10 | 0.09 |
| | 45 | 0.36 | 0.24 | 0.19 | 0.18 | 0.18 | 0.16 | 0.09 | 0.07 | 0.04 |
| | 50 | 0.07 | 0.14 | 0.23 | 0.25 | 0.14 | 0.05 | 0.03 | 0.01 | 0.00 |
| | 55 | 0.04 | 0.23 | 0.41 | 0.27 | 0.07 | 0.01 | 0.03 | 0.12 | 0.21 |
| | 60 | 0.20 | 0.61 | 0.73 | 0.44 | 0.19 | 0.33 | 0.48 | 0.44 | 0.40 |
| | 65 | 0.32 | 0.70 | 0.75 | 0.52 | 0.49 | 0.81 | 0.93 | 0.71 | 0.49 |
| | 70 | 0.25 | 0.38 | 0.47 | 0.52 | 0.63 | 0.85 | 0.93 | 0.86 | 0.78 |
| | 75 | 0.11 | 0.10 | 0.40 | 0.77 | 0.78 | 0.72 | 0.86 | 1.20 | 1.53 |
| | 80 | 0.04 | 0.05 | 0.52 | 0.94 | 0.91 | 0.84 | 1.21 | 1.88 | 2.54 |
| | 85 | 0.04 | 0.12 | 0.49 | 0.75 | 0.86 | 1.19 | 1.89 | 2.52 | 3.16 |
| | 90 | 0.03 | 0.19 | 0.47 | 0.56 | 0.81 | 1.54 | 2.56 | 3.17 | 3.79 |

[Table 17A]

<Comparative Example 1>

| Coefficient of variation | | Φ2(y) | | | | | | | | | |
|---|---|---|---|---|---|---|---|---|---|---|---|
| | | 0 | 5 | 10 | 15 | 20 | 25 | 30 | 35 | 40 | 45 |
| Φ (x) | 0 | 0.56 | 0.55 | 0.52 | 0.49 | 0.48 | 0.48 | 0.49 | 0.52 | 0.49 | 0.51 |
| | 5 | 0.54 | 0.53 | 0.51 | 0.46 | 0.45 | 0.45 | 0.46 | 0.47 | 0.47 | 0.46 |
| | 10 | 0.62 | 0.61 | 0.58 | 0.48 | 0.48 | 0.49 | 0.46 | 0.46 | 0.47 | 0.53 |
| | 15 | 0.78 | 0.78 | 0.77 | 0.65 | 0.65 | 0.66 | 0.63 | 0.73 | 0.64 | 0.71 |
| | 20 | N/A | N/A | N/A | N/A | 0.85 | 0.75 | N/A | N/A | N/A | N/A |
| | 25 | N/A | N/A | N/A | N/A | 0.81 | 0.80 | 0.81 | N/A | N/A | N/A |
| | 30 | N/A | N/A | N/A | N/A | N/A | N/A | N/A | N/A | N/A | N/A |
| | 35 | N/A | N/A | N/A | N/A | N/A | N/A | N/A | N/A | N/A | N/A |
| | 40 | N/A | N/A | N/A | N/A | N/A | N/A | N/A | N/A | N/A | N/A |
| | 45 | N/A | N/A | N/A | N/A | N/A | N/A | N/A | N/A | N/A | N/A |
| | 50 | N/A | N/A | N/A | N/A | N/A | N/A | N/A | N/A | N/A | N/A |
| | 55 | N/A | N/A | N/A | N/A | N/A | N/A | N/A | N/A | N/A | N/A |
| | 60 | N/A | N/A | N/A | N/A | N/A | N/A | N/A | N/A | N/A | N/A |
| | 65 | N/A | N/A | N/A | N/A | N/A | 0.81 | N/A | N/A | N/A | N/A |
| | 70 | N/A | N/A | N/A | N/A | N/A | N/A | N/A | N/A | N/A | N/A |
| | 75 | 0.78 | 0.70 | 0.82 | N/A | N/A | N/A | N/A | N/A | N/A | N/A |
| | 80 | 0.62 | 0.65 | 0.71 | 0.79 | N/A | N/A | N/A | N/A | N/A | N/A |
| | 85 | 0.54 | 0.57 | 0.63 | 0.67 | N/A | N/A | N/A | N/A | N/A | N/A |
| | 90 | 0.57 | 0.56 | 0.63 | 0.68 | 0.67 | N/A | N/A | N/A | N/A | N/A |

[Table 17B]

<Comparative Example 1>

| Coefficient of variation | | Φ2(y) | | | | | | | | |
|---|---|---|---|---|---|---|---|---|---|---|
| | | 50 | 55 | 60 | 65 | 70 | 75 | 80 | 85 | 90 |
| Φ (x) | 0 | 0.53 | 0.49 | 0.53 | 0.50 | 0.49 | 0.50 | 0.51 | 0.53 | 0.74 |
| | 5 | 0.45 | 0.45 | 0.47 | 0.46 | 0.46 | 0.46 | 0.47 | 0.51 | 0.68 |
| | 10 | 0.54 | 0.52 | 0.53 | 0.54 | 0.55 | 0.55 | 0.54 | 0.61 | 0.84 |
| | 15 | 0.77 | 0.72 | 0.80 | 0.77 | 0.74 | 0.74 | 0.70 | 0.77 | 1.18 |
| | 20 | N/A | N/A | N/A | N/A | N/A | N/A | N/A | N/A | N/A |
| | 25 | N/A | N/A | N/A | N/A | N/A | N/A | N/A | N/A | N/A |
| | 30 | N/A | N/A | N/A | N/A | N/A | N/A | N/A | N/A | N/A |
| | 35 | N/A | N/A | N/A | N/A | N/A | N/A | N/A | N/A | N/A |
| | 40 | N/A | N/A | N/A | N/A | N/A | N/A | N/A | N/A | N/A |
| | 45 | N/A | N/A | N/A | N/A | N/A | N/A | N/A | N/A | N/A |
| | 50 | N/A | N/A | N/A | N/A | N/A | N/A | N/A | N/A | N/A |
| | 55 | N/A | N/A | N/A | N/A | N/A | N/A | N/A | N/A | N/A |
| | 60 | N/A | N/A | N/A | N/A | N/A | N/A | N/A | N/A | N/A |
| | 65 | N/A | N/A | N/A | N/A | N/A | N/A | N/A | N/A | N/A |
| | 70 | N/A | N/A | N/A | N/A | N/A | N/A | N/A | N/A | N/A |
| | 75 | N/A | N/A | N/A | N/A | N/A | N/A | N/A | N/A | 1.07 |
| | 80 | N/A | N/A | N/A | N/A | N/A | N/A | 0.48 | 0.52 | 0.63 |
| | 85 | N/A | N/A | N/A | N/A | N/A | N/A | 0.50 | 0.48 | 0.53 |
| | 90 | N/A | N/A | N/A | N/A | N/A | 1.03 | 0.60 | 0.52 | 0.60 |

[Table 18A]

<Comparative Example 2>

| Average orientation density | | Φ2(y) | | | | | | | | | |
|---|---|---|---|---|---|---|---|---|---|---|---|
| | | 0 | 5 | 10 | 15 | 20 | 25 | 30 | 35 | 40 | 45 |
| Φ (x) | 0 | 1.02 | 0.99 | 0.91 | 0.87 | 0.89 | 0.94 | 0.98 | 1.03 | 1.11 | 1.16 |
| | 5 | 1.02 | 1.00 | 0.94 | 0.90 | 0.90 | 0.95 | 0.98 | 1.01 | 1.06 | 1.09 |
| | 10 | 1.01 | 1.00 | 0.96 | 0.93 | 0.93 | 0.98 | 1.00 | 1.00 | 1.02 | 1.04 |
| | 15 | 1.01 | 1.00 | 0.97 | 0.95 | 0.96 | 1.01 | 1.03 | 1.01 | 1.02 | 1.04 |
| | 20 | 1.00 | 0.99 | 0.97 | 0.96 | 0.98 | 1.03 | 1.05 | 1.04 | 1.07 | 1.11 |
| | 25 | 1.01 | 0.99 | 0.97 | 0.97 | 0.99 | 1.01 | 1.04 | 1.07 | 1.14 | 1.22 |
| | 30 | 1.01 | 0.99 | 0.97 | 0.98 | 0.98 | 0.98 | 1.01 | 1.08 | 1.20 | 1.34 |
| | 35 | 0.99 | 0.97 | 0.96 | 0.97 | 0.96 | 0.93 | 0.96 | 1.07 | 1.22 | 1.44 |
| | 40 | 0.97 | 0.95 | 0.94 | 0.96 | 0.93 | 0.88 | 0.90 | 1.02 | 1.19 | 1.47 |
| | 45 | 0.96 | 0.93 | 0.93 | 0.95 | 0.91 | 0.83 | 0.84 | 0.95 | 1.10 | 1.39 |
| | 50 | 0.96 | 0.93 | 0.92 | 0.93 | 0.88 | 0.80 | 0.80 | 0.88 | 0.96 | 1.18 |
| | 55 | 0.97 | 0.94 | 0.90 | 0.91 | 0.87 | 0.81 | 0.80 | 0.82 | 0.83 | 0.95 |
| | 60 | 0.99 | 0.95 | 0.90 | 0.89 | 0.88 | 0.83 | 0.82 | 0.80 | 0.76 | 0.80 |

(continued)

<Comparative Example 2>

| Average orientation density | Φ2(y) | | | | | | | | | |
|---|---|---|---|---|---|---|---|---|---|---|
| | 0 | 5 | 10 | 15 | 20 | 25 | 30 | 35 | 40 | 45 |
| 65 | 1.01 | 0.96 | 0.90 | 0.88 | 0.88 | 0.86 | 0.85 | 0.82 | 0.78 | 0.80 |
| 70 | 1.02 | 0.97 | 0.89 | 0.87 | 0.88 | 0.89 | 0.89 | 0.88 | 0.87 | 0.89 |
| 75 | 1.01 | 0.96 | 0.87 | 0.85 | 0.88 | 0.93 | 0.95 | 0.96 | 1.00 | 1.02 |
| 80 | 1.01 | 0.96 | 0.87 | 0.84 | 0.89 | 0.95 | 0.98 | 1.02 | 1.09 | 1.13 |
| 85 | 1.02 | 0.97 | 0.89 | 0.85 | 0.89 | 0.95 | 0.99 | 1.04 | 1.14 | 1.18 |
| 90 | 1.02 | 0.99 | 0.91 | 0.86 | 0.89 | 0.95 | 0.99 | 1.06 | 1.18 | 1.23 |

[Table 18B]

<Comparative Example 2>

| | Average orientation density | Φ2(y) | | | | | | | | |
|---|---|---|---|---|---|---|---|---|---|---|
| | | 50 | 55 | 60 | 65 | 70 | 75 | 80 | 85 | 90 |
| Φ (x) | 0 | 1.11 | 1.03 | 0.98 | 0.94 | 0.89 | 0.87 | 0.91 | 0.99 | 1.06 |
| | 5 | 1.06 | 1.00 | 0.97 | 0.97 | 0.95 | 0.92 | 0.90 | 0.92 | 0.95 |
| | 10 | 1.02 | 0.96 | 0.95 | 0.97 | 0.97 | 0.96 | 0.94 | 0.90 | 0.85 |
| | 15 | 1.02 | 0.96 | 0.94 | 0.92 | 0.89 | 0.92 | 0.96 | 0.91 | 0.86 |
| | 20 | 1.09 | 1.02 | 0.97 | 0.91 | 0.84 | 0.87 | 0.95 | 0.95 | 0.95 |
| | 25 | 1.21 | 1.12 | 1.04 | 0.97 | 0.88 | 0.87 | 0.95 | 0.97 | 1.00 |
| | 30 | 1.39 | 1.29 | 1.13 | 0.99 | 0.90 | 0.89 | 0.93 | 0.98 | 1.02 |
| | 35 | 1.61 | 1.56 | 1.29 | 1.01 | 0.88 | 0.88 | 0.94 | 1.01 | 1.08 |
| | 40 | 1.80 | 1.87 | 1.56 | 1.16 | 0.95 | 0.93 | 1.00 | 1.09 | 1.18 |
| | 45 | 1.81 | 2.04 | 1.82 | 1.39 | 1.11 | 1.03 | 1.06 | 1.14 | 1.22 |
| | 50 | 1.59 | 1.90 | 1.82 | 1.50 | 1.22 | 1.08 | 1.06 | 1.10 | 1.14 |
| | 55 | 1.25 | 1.54 | 1.57 | 1.39 | 1.19 | 1.07 | 1.03 | 1.04 | 1.04 |
| | 60 | 1.00 | 1.21 | 1.27 | 1.17 | 1.06 | 1.02 | 1.02 | 1.00 | 0.99 |
| | 65 | 0.91 | 1.03 | 1.07 | 1.00 | 0.92 | 0.93 | 0.97 | 0.96 | 0.95 |
| | 70 | 0.94 | 0.98 | 0.99 | 0.92 | 0.85 | 0.87 | 0.92 | 0.90 | 0.89 |
| | 75 | 1.00 | 0.99 | 0.98 | 0.93 | 0.87 | 0.89 | 0.95 | 0.92 | 0.88 |
| | 80 | 1.08 | 1.01 | 0.99 | 0.95 | 0.91 | 0.94 | 1.01 | 1.00 | 0.98 |
| | 85 | 1.12 | 1.03 | 0.98 | 0.94 | 0.89 | 0.91 | 0.99 | 1.03 | 1.08 |
| | 90 | 1.17 | 1.06 | 0.98 | 0.93 | 0.87 | 0.87 | 0.97 | 1.07 | 1.18 |

[Table 19A]

<Comparative Example 2>

| Coefficient of variation | Φ2(y) | | | | | | | | | |
|---|---|---|---|---|---|---|---|---|---|---|
| | 0 | 5 | 10 | 15 | 20 | 25 | 30 | 35 | 40 | 45 |
| 0 | N/A | N/A | N/A | N/A | N/A | N/A | N/A | N/A | N/A | N/A |
| 5 | N/A | N/A | N/A | N/A | N/A | N/A | N/A | N/A | N/A | N/A |
| 10 | N/A | N/A | N/A | N/A | N/A | N/A | N/A | N/A | N/A | N/A |

(continued)

| <Comparative Example 2> | | | | | | | | | | | |
|---|---|---|---|---|---|---|---|---|---|---|---|
| Coefficient of variation | | Φ2(y) | | | | | | | | | |
| | | 0 | 5 | 10 | 15 | 20 | 25 | 30 | 35 | 40 | 45 |
| Φ (x) | 15 | N/A | N/A | N/A | N/A | N/A | N/A | N/A | N/A | N/A | N/A |
| | 20 | N/A | N/A | N/A | N/A | N/A | N/A | N/A | N/A | N/A | N/A |
| | 25 | N/A | N/A | N/A | N/A | N/A | N/A | N/A | N/A | N/A | 0.54 |
| | 30 | N/A | N/A | N/A | N/A | N/A | N/A | N/A | N/A | 0.55 | 0.51 |
| | 35 | N/A | N/A | N/A | N/A | N/A | N/A | N/A | N/A | 0.51 | 0.46 |
| | 40 | N/A | N/A | N/A | N/A | N/A | N/A | N/A | N/A | N/A | 0.40 |
| | 45 | N/A | N/A | N/A | N/A | N/A | N/A | N/A | N/A | N/A | 0.36 |
| | 50 | N/A | N/A | N/A | N/A | N/A | N/A | N/A | N/A | N/A | N/A |
| | 55 | N/A | N/A | N/A | N/A | N/A | N/A | N/A | N/A | N/A | N/A |
| | 60 | N/A | N/A | N/A | N/A | N/A | N/A | N/A | N/A | N/A | N/A |
| | 65 | N/A | N/A | N/A | N/A | N/A | N/A | N/A | N/A | N/A | N/A |
| | 70 | N/A | N/A | N/A | N/A | N/A | N/A | N/A | N/A | N/A | N/A |
| | 75 | N/A | N/A | N/A | N/A | N/A | N/A | N/A | N/A | N/A | N/A |
| | 80 | N/A | N/A | N/A | N/A | N/A | N/A | N/A | N/A | N/A | N/A |
| | 85 | N/A | N/A | N/A | N/A | N/A | N/A | N/A | N/A | N/A | N/A |
| | 90 | N/A | N/A | N/A | N/A | N/A | N/A | N/A | N/A | N/A | 0.44 |

[Table 19B]

| <Comparative Example 2> | | | | | | | | | | |
|---|---|---|---|---|---|---|---|---|---|---|
| Coefficient of variation | | Φ2(y) | | | | | | | | |
| | | 50 | 55 | 60 | 65 | 70 | 75 | 80 | 85 | 90 |
| Φ (x) | 0 | N/A | N/A | N/A | N/A | N/A | N/A | N/A | N/A | N/A |
| | 5 | N/A | N/A | N/A | N/A | N/A | N/A | N/A | N/A | N/A |
| | 10 | N/A | N/A | N/A | N/A | N/A | N/A | N/A | N/A | N/A |
| | 15 | N/A | N/A | N/A | N/A | N/A | N/A | N/A | N/A | N/A |
| | 20 | N/A | N/A | N/A | N/A | N/A | N/A | N/A | N/A | N/A |
| | 25 | 0.58 | N/A | N/A | N/A | N/A | N/A | N/A | N/A | N/A |
| | 30 | 0.52 | 0.57 | N/A | N/A | N/A | N/A | N/A | N/A | N/A |
| | 35 | 0.39 | 0.40 | 0.40 | N/A | N/A | N/A | N/A | N/A | N/A |
| | 40 | 0.25 | 0.19 | 0.28 | N/A | N/A | N/A | N/A | N/A | N/A |
| | 45 | 0.19 | 0.04 | 0.22 | 0.43 | N/A | N/A | N/A | N/A | 0.43 |
| | 50 | 0.24 | 0.13 | 0.24 | 0.43 | 0.57 | N/A | N/A | N/A | N/A |
| | 55 | 0.31 | 0.25 | 0.30 | 0.43 | N/A | N/A | N/A | N/A | N/A |
| | 60 | N/A | 0.41 | 0.39 | N/A | N/A | N/A | N/A | N/A | N/A |
| | 65 | N/A | N/A | N/A | N/A | N/A | N/A | N/A | N/A | N/A |
| | 70 | N/A | N/A | N/A | N/A | N/A | N/A | N/A | N/A | N/A |
| | 75 | N/A | N/A | N/A | N/A | N/A | N/A | N/A | N/A | N/A |

(continued)

| <Comparative Example 2> | | | | | | | | | | |
|---|---|---|---|---|---|---|---|---|---|---|
| Coefficient of variation | | Φ2(y) | | | | | | | | |
| | | 50 | 55 | 60 | 65 | 70 | 75 | 80 | 85 | 90 |
| | 80 | N/A | N/A | N/A | N/A | N/A | N/A | N/A | N/A | N/A |
| | 85 | N/A | N/A | N/A | N/A | N/A | N/A | N/A | N/A | N/A |
| | 90 | N/A | N/A | N/A | N/A | N/A | N/A | N/A | N/A | N/A |

[Table 20A]

| <Comparative Example 3> | | | | | | | | | | | |
|---|---|---|---|---|---|---|---|---|---|---|---|
| Average orientation density | | Φ2(y) | | | | | | | | | |
| | | 0 | 5 | 10 | 15 | 20 | 25 | 30 | 35 | 40 | 45 |
| Φ (x) | 0 | 2.01 | 2.00 | 2.03 | 2.04 | 1.99 | 1.98 | 2.01 | 2.02 | 2.00 | 1.99 |
| | 5 | 1.87 | 1.87 | 1.90 | 1.90 | 1.86 | 1.84 | 1.87 | 1.88 | 1.86 | 1.85 |
| | 10 | 1.57 | 1.58 | 1.62 | 1.62 | 1.59 | 1.58 | 1.61 | 1.62 | 1.60 | 1.59 |
| | 15 | 1.27 | 1.30 | 1.34 | 1.37 | 1.37 | 1.39 | 1.42 | 1.43 | 1.42 | 1.41 |
| | 20 | 0.99 | 1.02 | 1.10 | 1.17 | 1.23 | 1.27 | 1.31 | 1.31 | 1.28 | 1.25 |
| | 25 | 0.71 | 0.76 | 0.86 | 0.97 | 1.06 | 1.12 | 1.16 | 1.13 | 1.08 | 1.05 |
| | 30 | 0.53 | 0.58 | 0.67 | 0.77 | 0.84 | 0.91 | 0.94 | 0.92 | 0.88 | 0.86 |
| | 35 | 0.49 | 0.51 | 0.56 | 0.61 | 0.65 | 0.69 | 0.72 | 0.71 | 0.69 | 0.71 |
| | 40 | 0.51 | 0.52 | 0.53 | 0.53 | 0.54 | 0.57 | 0.58 | 0.58 | 0.59 | 0.63 |
| | 45 | 0.52 | 0.54 | 0.54 | 0.52 | 0.52 | 0.54 | 0.58 | 0.65 | 0.73 | 0.80 |
| | 50 | 0.51 | 0.54 | 0.54 | 0.51 | 0.49 | 0.52 | 0.63 | 0.84 | 1.08 | 1.20 |
| | 55 | 0.49 | 0.51 | 0.53 | 0.50 | 0.46 | 0.48 | 0.61 | 0.91 | 1.26 | 1.42 |
| | 60 | 0.53 | 0.53 | 0.57 | 0.55 | 0.50 | 0.47 | 0.54 | 0.75 | 1.04 | 1.18 |
| | 65 | 0.71 | 0.67 | 0.68 | 0.62 | 0.54 | 0.49 | 0.49 | 0.54 | 0.66 | 0.75 |
| | 70 | 0.99 | 0.88 | 0.81 | 0.69 | 0.58 | 0.54 | 0.51 | 0.46 | 0.47 | 0.51 |
| | 75 | 1.27 | 1.10 | 0.95 | 0.80 | 0.69 | 0.63 | 0.57 | 0.49 | 0.45 | 0.46 |
| | 80 | 1.57 | 1.34 | 1.13 | 0.95 | 0.82 | 0.70 | 0.59 | 0.51 | 0.47 | 0.45 |
| | 85 | 1.87 | 1.64 | 1.34 | 1.10 | 0.89 | 0.69 | 0.54 | 0.50 | 0.50 | 0.49 |
| | 90 | 2.18 | 1.94 | 1.55 | 1.24 | 0.96 | 0.67 | 0.49 | 0.49 | 0.53 | 0.53 |

[Table 20B]

| <Comparative Example 3> | | | | | | | | | | |
|---|---|---|---|---|---|---|---|---|---|---|
| Average orientation density | | Φ2(y) | | | | | | | | |
| | | 50 | 55 | 60 | 65 | 70 | 75 | 80 | 85 | 90 |
| | 0 | 1.99 | 2.00 | 2.01 | 2.02 | 1.99 | 1.99 | 2.03 | 2.05 | 2.07 |
| | 5 | 1.85 | 1.86 | 1.88 | 1.88 | 1.86 | 1.85 | 1.88 | 1.89 | 1.91 |
| | 10 | 1.59 | 1.58 | 1.59 | 1.60 | 1.58 | 1.56 | 1.56 | 1.57 | 1.58 |
| | 15 | 1.39 | 1.36 | 1.34 | 1.33 | 1.30 | 1.27 | 1.26 | 1.27 | 1.27 |
| | 20 | 1.22 | 1.18 | 1.13 | 1.09 | 1.04 | 1.00 | 0.98 | 0.98 | 0.98 |
| | 25 | 1.02 | 0.98 | 0.92 | 0.88 | 0.82 | 0.76 | 0.72 | 0.70 | 0.69 |

(continued)

| <Comparative Example 3> | | | | | | | | | |
|---|---|---|---|---|---|---|---|---|---|
| Average orientation density | Φ2(y) | | | | | | | | |
| | 50 | 55 | 60 | 65 | 70 | 75 | 80 | 85 | 90 |
| Φ(x) 30 | 0.85 | 0.81 | 0.76 | 0.72 | 0.66 | 0.59 | 0.54 | 0.52 | 0.51 |
| 35 | 0.72 | 0.69 | 0.63 | 0.57 | 0.53 | 0.48 | 0.47 | 0.48 | 0.49 |
| 40 | 0.64 | 0.58 | 0.49 | 0.43 | 0.40 | 0.40 | 0.43 | 0.48 | 0.53 |
| 45 | 0.75 | 0.59 | 0.43 | 0.36 | 0.35 | 0.35 | 0.40 | 0.47 | 0.54 |
| 50 | 1.05 | 0.75 | 0.51 | 0.42 | 0.41 | 0.40 | 0.42 | 0.47 | 0.51 |
| 55 | 1.24 | 0.88 | 0.63 | 0.58 | 0.59 | 0.57 | 0.54 | 0.50 | 0.47 |
| 60 | 1.06 | 0.84 | 0.73 | 0.77 | 0.83 | 0.85 | 0.78 | 0.64 | 0.50 |
| 65 | 0.74 | 0.73 | 0.81 | 0.94 | 1.07 | 1.15 | 1.09 | 0.89 | 0.70 |
| 70 | 0.57 | 0.69 | 0.88 | 1.09 | 1.27 | 1.41 | 1.41 | 1.21 | 1.01 |
| 75 | 0.52 | 0.67 | 0.92 | 1.19 | 1.43 | 1.62 | 1.65 | 1.50 | 1.34 |
| 80 | 0.48 | 0.59 | 0.83 | 1.14 | 1.44 | 1.67 | 1.77 | 1.73 | 1.69 |
| 85 | 0.48 | 0.51 | 0.65 | 0.91 | 1.23 | 1.51 | 1.74 | 1.89 | 2.05 |
| 90 | 0.48 | 0.43 | 0.47 | 0.68 | 1.01 | 1.34 | 1.70 | 2.05 | 2.41 |

[Table 21A]

| <Comparative Example 3> | | | | | | | | | | |
|---|---|---|---|---|---|---|---|---|---|---|
| Coefficient of variation | Φ2(y) | | | | | | | | | |
| | 0 | 5 | 10 | 15 | 20 | 25 | 30 | 35 | 40 | 45 |
| Φ (x) 0 | 0.10 | 0.10 | 0.11 | 0.12 | 0.11 | 0.12 | 0.10 | 0.11 | 0.11 | 0.11 |
| 5 | 0.11 | 0.11 | 0.11 | 0.10 | 0.10 | 0.11 | 0.10 | 0.10 | 0.11 | 0.13 |
| 10 | 0.18 | 0.18 | 0.15 | 0.12 | 0.11 | 0.13 | 0.12 | 0.13 | 0.17 | 0.20 |
| 15 | 0.26 | 0.24 | 0.20 | 0.16 | 0.18 | 0.21 | 0.21 | 0.24 | 0.28 | 0.30 |
| 20 | N/A | N/A | N/A | N/A | 0.26 | 0.30 | 0.33 | 0.36 | 0.39 | 0.40 |
| 25 | N/A | N/A | N/A | N/A | N/A | N/A | N/A | N/A | N/A | N/A |
| 30 | N/A | N/A | N/A | N/A | N/A | N/A | N/A | N/A | N/A | N/A |
| 35 | N/A | N/A | N/A | N/A | N/A | N/A | N/A | N/A | N/A | N/A |
| 40 | N/A | N/A | N/A | N/A | N/A | N/A | N/A | N/A | N/A | N/A |
| 45 | N/A | N/A | N/A | N/A | N/A | N/A | N/A | N/A | N/A | N/A |
| 50 | N/A | N/A | N/A | N/A | N/A | N/A | N/A | N/A | N/A | N/A |
| 55 | N/A | N/A | N/A | N/A | N/A | N/A | N/A | N/A | 0.30 | 0.20 |
| 60 | N/A | N/A | N/A | N/A | N/A | N/A | N/A | N/A | N/A | N/A |
| 65 | N/A | N/A | N/A | N/A | N/A | N/A | N/A | N/A | N/A | N/A |
| 70 | N/A | N/A | N/A | N/A | N/A | N/A | N/A | N/A | N/A | N/A |
| 75 | 0.26 | N/A | N/A | N/A | N/A | N/A | N/A | N/A | N/A | N/A |
| 80 | 0.18 | 0.20 | N/A | N/A | N/A | N/A | N/A | N/A | N/A | N/A |
| 85 | 0.11 | 0.12 | 0.20 | N/A | N/A | N/A | N/A | N/A | N/A | N/A |
| 90 | 0.11 | 0.12 | 0.23 | 0.35 | N/A | N/A | N/A | N/A | N/A | N/A |

[Table 21B]

<Comparative Example 3>

| Coefficient of variation | | Φ2(y) | | | | | | | | |
|---|---|---|---|---|---|---|---|---|---|---|
| | | 50 | 55 | 60 | 65 | 70 | 75 | 80 | 85 | 90 |
| Φ (x) | 0 | 0.11 | 0.11 | 0.10 | 0.10 | 0.11 | 0.11 | 0.11 | 0.13 | 0.20 |
| | 5 | 0.13 | 0.13 | 0.13 | 0.13 | 0.13 | 0.14 | 0.13 | 0.13 | 0.20 |
| | 10 | 0.21 | 0.23 | 0.23 | 0.23 | 0.24 | 0.24 | 0.22 | 0.19 | 0.23 |
| | 15 | 0.31 | 0.33 | 0.33 | 0.33 | 0.34 | 0.35 | 0.32 | 0.29 | 0.30 |
| | 20 | 0.39 | N/A | N/A | N/A | N/A | N/A | N/A | N/A | N/A |
| | 25 | N/A | N/A | N/A | N/A | N/A | N/A | N/A | N/A | N/A |
| | 30 | N/A | N/A | N/A | N/A | N/A | N/A | N/A | N/A | N/A |
| | 35 | N/A | N/A | N/A | N/A | N/A | N/A | N/A | N/A | N/A |
| | 40 | N/A | N/A | N/A | N/A | N/A | N/A | N/A | N/A | N/A |
| | 45 | N/A | N/A | N/A | N/A | N/A | N/A | N/A | N/A | N/A |
| | 50 | N/A | N/A | N/A | N/A | N/A | N/A | N/A | N/A | N/A |
| | 55 | 0.18 | N/A | N/A | N/A | N/A | N/A | N/A | N/A | N/A |
| | 60 | N/A | N/A | N/A | N/A | N/A | N/A | N/A | N/A | N/A |
| | 65 | N/A | N/A | N/A | N/A | N/A | N/A | N/A | N/A | N/A |
| | 70 | N/A | N/A | N/A | N/A | 0.20 | 0.20 | 0.18 | 0.19 | N/A |
| | 75 | N/A | N/A | N/A | N/A | 0.20 | 0.16 | 0.11 | 0.15 | 0.31 |
| | 80 | N/A | N/A | N/A | N/A | 0.19 | 0.12 | 0.08 | 0.12 | 0.21 |
| | 85 | N/A | N/A | N/A | N/A | 0.20 | 0.16 | 0.12 | 0.11 | 0.12 |
| | 90 | N/A | N/A | N/A | N/A | N/A | 0.30 | 0.21 | 0.13 | 0.11 |

[Table 22A]

<Comparative Example 4>

| Average orientation density | | Φ2(y) | | | | | | | | |
|---|---|---|---|---|---|---|---|---|---|---|
| | | 0 | 5 | 10 | 15 | 20 | 25 | 30 | 35 | 40 | 45 |
| Φ (x) | 0 | 1.37 | 1.38 | 1.37 | 1.38 | 1.42 | 1.40 | 1.34 | 1.31 | 1.32 | 1.34 |
| | 5 | 1.25 | 1.26 | 1.27 | 1.30 | 1.34 | 1.32 | 1.26 | 1.22 | 1.22 | 1.22 |
| | 10 | 1.06 | 1.07 | 1.11 | 1.17 | 1.19 | 1.17 | 1.12 | 1.07 | 1.04 | 1.00 |
| | 15 | 0.95 | 0.95 | 1.02 | 1.08 | 1.09 | 1.06 | 1.04 | 1.01 | 0.95 | 0.89 |
| | 20 | 0.80 | 0.80 | 0.87 | 0.94 | 0.96 | 0.98 | 1.02 | 1.01 | 0.95 | 0.87 |
| | 25 | 0.55 | 0.56 | 0.64 | 0.73 | 0.81 | 0.91 | 0.99 | 1.00 | 0.93 | 0.85 |
| | 30 | 0.43 | 0.46 | 0.54 | 0.63 | 0.73 | 0.85 | 0.93 | 0.94 | 0.87 | 0.80 |
| | 35 | 0.53 | 0.56 | 0.60 | 0.64 | 0.71 | 0.80 | 0.88 | 0.90 | 0.88 | 0.82 |
| | 40 | 0.69 | 0.68 | 0.66 | 0.64 | 0.67 | 0.80 | 0.97 | 1.11 | 1.18 | 1.15 |
| | 45 | 0.75 | 0.70 | 0.64 | 0.60 | 0.65 | 0.90 | 1.28 | 1.63 | 1.83 | 1.83 |
| | 50 | 0.69 | 0.63 | 0.61 | 0.60 | 0.70 | 1.07 | 1.65 | 2.19 | 2.48 | 2.48 |
| | 55 | 0.53 | 0.52 | 0.61 | 0.67 | 0.78 | 1.15 | 1.78 | 2.39 | 2.73 | 2.72 |
| | 60 | 0.43 | 0.50 | 0.67 | 0.76 | 0.82 | 1.06 | 1.55 | 2.10 | 2.48 | 2.51 |

(continued)

| <Comparative Example 4> | | | | | | | | | | | |
|---|---|---|---|---|---|---|---|---|---|---|---|
| Average orientation density | | Φ2(y) | | | | | | | | | |
| | | 0 | 5 | 10 | 15 | 20 | 25 | 30 | 35 | 40 | 45 |
| | 65 | 0.55 | 0.66 | 0.81 | 0.85 | 0.81 | 0.88 | 1.14 | 1.52 | 1.88 | 2.01 |
| | 70 | 0.80 | 0.87 | 0.92 | 0.89 | 0.81 | 0.79 | 0.86 | 1.02 | 1.27 | 1.44 |
| | 75 | 0.95 | 0.92 | 0.90 | 0.89 | 0.87 | 0.83 | 0.78 | 0.79 | 0.92 | 1.07 |
| | 80 | 1.06 | 0.94 | 0.86 | 0.89 | 0.91 | 0.82 | 0.71 | 0.70 | 0.79 | 0.92 |
| | 85 | 1.25 | 1.09 | 0.94 | 0.92 | 0.86 | 0.67 | 0.53 | 0.57 | 0.71 | 0.82 |
| | 90 | 1.44 | 1.24 | 1.02 | 0.96 | 0.82 | 0.52 | 0.35 | 0.44 | 0.62 | 0.71 |

[Table 22B]

| <Comparative Example 4> | | | | | | | | | | |
|---|---|---|---|---|---|---|---|---|---|---|
| Average orientation density | | Φ2(y) | | | | | | | | |
| | | 50 | 55 | 60 | 65 | 70 | 75 | 80 | 85 | 90 |
| Φ(x) | 0 | 1.34 | 1.33 | 1.33 | 1.35 | 1.40 | 1.43 | 1.40 | 1.36 | 1.32 |
| | 5 | 1.21 | 1.20 | 1.19 | 1.20 | 1.24 | 1.27 | 1.26 | 1.24 | 1.22 |
| | 10 | 0.97 | 0.96 | 0.95 | 0.95 | 0.97 | 1.00 | 1.03 | 1.05 | 1.08 |
| | 15 | 0.84 | 0.82 | 0.82 | 0.82 | 0.82 | 0.84 | 0.90 | 0.95 | 1.00 |
| | 20 | 0.80 | 0.77 | 0.77 | 0.79 | 0.78 | 0.77 | 0.80 | 0.82 | 0.84 |
| | 25 | 0.77 | 0.73 | 0.74 | 0.76 | 0.75 | 0.70 | 0.65 | 0.60 | 0.55 |
| | 30 | 0.73 | 0.69 | 0.69 | 0.73 | 0.75 | 0.69 | 0.59 | 0.48 | 0.38 |
| | 35 | 0.75 | 0.70 | 0.71 | 0.77 | 0.83 | 0.81 | 0.70 | 0.58 | 0.46 |
| | 40 | 1.07 | 0.98 | 0.94 | 0.96 | 1.01 | 1.00 | 0.89 | 0.75 | 0.61 |
| | 45 | 1.71 | 1.53 | 1.36 | 1.24 | 1.20 | 1.15 | 1.01 | 0.85 | 0.69 |
| | 50 | 2.28 | 1.96 | 1.61 | 1.34 | 1.20 | 1.12 | 1.00 | 0.83 | 0.65 |
| | 55 | 2.40 | 1.92 | 1.45 | 1.13 | 0.99 | 0.94 | 0.85 | 0.68 | 0.51 |
| | 60 | 2.15 | 1.59 | 1.13 | 0.90 | 0.82 | 0.78 | 0.68 | 0.53 | 0.38 |
| | 65 | 1.74 | 1.27 | 0.94 | 0.85 | 0.84 | 0.78 | 0.67 | 0.58 | 0.48 |
| | 70 | 1.33 | 1.05 | 0.88 | 0.89 | 0.92 | 0.87 | 0.80 | 0.77 | 0.75 |
| | 75 | 1.08 | 0.95 | 0.84 | 0.87 | 0.92 | 0.93 | 0.93 | 0.95 | 0.97 |
| | 80 | 0.97 | 0.87 | 0.75 | 0.75 | 0.85 | 0.95 | 1.02 | 1.09 | 1.15 |
| | 85 | 0.83 | 0.70 | 0.57 | 0.61 | 0.80 | 0.96 | 1.09 | 1.23 | 1.37 |
| | 90 | 0.69 | 0.53 | 0.39 | 0.47 | 0.74 | 0.98 | 1.16 | 1.38 | 1.59 |

[Table 23A]

| <Comparative Example 4> | | | | | | | | | | | |
|---|---|---|---|---|---|---|---|---|---|---|---|
| Coefficient of variation | | Φ2(y) | | | | | | | | | |
| | | 0 | 5 | 10 | 15 | 20 | 25 | 30 | 35 | 40 | 45 |
| | 0 | 0.34 | 0.34 | 0.34 | 0.34 | 0.36 | 0.35 | 0.35 | 0.39 | 0.37 | 0.35 |
| | 5 | 0.35 | 0.34 | 0.34 | 0.34 | 0.36 | 0.34 | 0.34 | 0.38 | 0.37 | 0.37 |
| | 10 | N/A | N/A | N/A | N/A | N/A | N/A | N/A | N/A | N/A | N/A |

(continued)

| <Comparative Example 4> | | | | | | | | | | | |
|---|---|---|---|---|---|---|---|---|---|---|---|
| Coefficient of variation | | Φ2(y) | | | | | | | | | |
| | | 0 | 5 | 10 | 15 | 20 | 25 | 30 | 35 | 40 | 45 |
| Φ (x) | 15 | N/A | N/A | N/A | N/A | N/A | N/A | N/A | N/A | N/A | N/A |
| | 20 | N/A | N/A | N/A | N/A | N/A | N/A | N/A | N/A | N/A | N/A |
| | 25 | N/A | N/A | N/A | N/A | N/A | N/A | N/A | N/A | N/A | N/A |
| | 30 | N/A | N/A | N/A | N/A | N/A | N/A | N/A | N/A | N/A | N/A |
| | 35 | N/A | N/A | N/A | N/A | N/A | N/A | N/A | N/A | N/A | N/A |
| | 40 | N/A | N/A | N/A | N/A | N/A | N/A | N/A | N/A | N/A | N/A |
| | 45 | N/A | N/A | N/A | N/A | N/A | N/A | 0.43 | 0.38 | 0.32 | 0.25 |
| | 50 | N/A | N/A | N/A | N/A | N/A | N/A | 0.35 | 0.28 | 0.23 | 0.17 |
| | 55 | N/A | N/A | N/A | N/A | N/A | N/A | 0.27 | 0.18 | 0.13 | 0.14 |
| | 60 | N/A | N/A | N/A | N/A | N/A | N/A | 0.20 | 0.12 | 0.13 | 0.18 |
| | 65 | N/A | N/A | N/A | N/A | N/A | N/A | N/A | 0.20 | 0.24 | 0.30 |
| | 70 | N/A | N/A | N/A | N/A | N/A | N/A | N/A | N/A | 0.52 | 0.64 |
| | 75 | N/A | N/A | N/A | N/A | N/A | N/A | N/A | N/A | N/A | N/A |
| | 80 | N/A | N/A | N/A | N/A | N/A | N/A | N/A | N/A | N/A | N/A |
| | 85 | 0.35 | N/A | N/A | N/A | N/A | N/A | N/A | N/A | N/A | N/A |
| | 90 | 0.34 | 0.40 | N/A | N/A | N/A | N/A | N/A | N/A | N/A | N/A |

[Table 23B]

| <Comparative Example 4> | | | | | | | | | | | |
|---|---|---|---|---|---|---|---|---|---|---|---|
| Coefficient of variation | | Φ2(y) | | | | | | | | | |
| | | 50 | 55 | 60 | 65 | 70 | 75 | 80 | 85 | 90 |
| Φ (x) | 0 | 0.36 | 0.36 | 0.37 | 0.35 | 0.35 | 0.38 | 0.34 | 0.34 | 0.49 |
| | 5 | 0.37 | N/A | N/A | 0.36 | 0.36 | 0.38 | 0.36 | 0.35 | 0.48 |
| | 10 | N/A | N/A | N/A | N/A | N/A | N/A | N/A | N/A | N/A |
| | 15 | N/A | N/A | N/A | N/A | N/A | N/A | N/A | N/A | N/A |
| | 20 | N/A | N/A | N/A | N/A | N/A | N/A | N/A | N/A | N/A |
| | 25 | N/A | N/A | N/A | N/A | N/A | N/A | N/A | N/A | N/A |
| | 30 | N/A | N/A | N/A | N/A | N/A | N/A | N/A | N/A | N/A |
| | 35 | N/A | N/A | N/A | N/A | N/A | N/A | N/A | N/A | N/A |
| | 40 | N/A | N/A | N/A | N/A | N/A | N/A | N/A | N/A | N/A |
| | 45 | 0.18 | 0.28 | 0.55 | 0.83 | N/A | N/A | N/A | N/A | N/A |
| | 50 | 0.13 | 0.21 | 0.45 | 0.72 | N/A | N/A | N/A | N/A | N/A |
| | 55 | 0.17 | 0.21 | 0.34 | N/A | N/A | N/A | N/A | N/A | N/A |
| | 60 | 0.24 | 0.28 | N/A | N/A | N/A | N/A | N/A | N/A | N/A |
| | 65 | 0.35 | 0.38 | N/A | N/A | N/A | N/A | N/A | N/A | N/A |
| | 70 | 0.64 | N/A | N/A | N/A | N/A | N/A | N/A | N/A | N/A |
| | 75 | N/A | N/A | N/A | N/A | N/A | N/A | N/A | N/A | N/A |

(continued)

| <Comparative Example 4> | | | | | | | | | | |
|---|---|---|---|---|---|---|---|---|---|---|
| Coefficient of variation | | Φ2(y) | | | | | | | | |
| | | 50 | 55 | 60 | 65 | 70 | 75 | 80 | 85 | 90 |
| | 80 | N/A | N/A | N/A | N/A | N/A | N/A | N/A | N/A | N/A |
| | 85 | N/A | N/A | N/A | N/A | N/A | N/A | N/A | 0.33 | 0.34 |
| | 90 | N/A | N/A | N/A | N/A | N/A | N/A | N/A | 0.34 | 0.30 |

[Table 24A]

| <Comparative Example 5> | | | | | | | | | | |
|---|---|---|---|---|---|---|---|---|---|---|
| Average orientation density | | Φ2(y) | | | | | | | | |
| | | 0 | 5 | 10 | 15 | 20 | 25 | 30 | 35 | 40 | 45 |
| Φ(x) | 0 | 1.02 | 1.02 | 1.02 | 1.01 | 1.00 | 0.98 | 0.97 | 0.96 | 0.96 | 0.97 |
| | 5 | 1.06 | 1.05 | 1.04 | 1.02 | 1.02 | 1.01 | 1.01 | 1.00 | 1.00 | 1.00 |
| | 10 | 1.11 | 1.10 | 1.07 | 1.04 | 1.04 | 1.05 | 1.05 | 1.05 | 1.05 | 1.05 |
| | 15 | 1.12 | 1.10 | 1.06 | 1.04 | 1.04 | 1.03 | 1.02 | 1.02 | 1.03 | 1.04 |
| | 20 | 1.06 | 1.04 | 1.03 | 1.04 | 1.06 | 1.05 | 1.02 | 1.01 | 1.00 | 0.98 |
| | 25 | 1.01 | 0.98 | 1.00 | 1.05 | 1.09 | 1.10 | 1.08 | 1.05 | 1.00 | 0.94 |
| | 30 | 1.00 | 0.97 | 0.98 | 1.01 | 1.05 | 1.08 | 1.08 | 1.05 | 0.99 | 0.92 |
| | 35 | 0.99 | 0.96 | 0.94 | 0.95 | 0.96 | 0.99 | 0.99 | 0.98 | 0.96 | 0.94 |
| | 40 | 0.97 | 0.92 | 0.90 | 0.92 | 0.95 | 0.96 | 0.95 | 0.94 | 0.95 | 0.98 |
| | 45 | 0.96 | 0.87 | 0.87 | 0.92 | 0.98 | 1.00 | 0.98 | 0.95 | 0.95 | 0.97 |
| | 50 | 0.97 | 0.89 | 0.87 | 0.89 | 0.94 | 0.97 | 0.98 | 0.96 | 0.94 | 0.94 |
| | 55 | 0.99 | 0.97 | 0.93 | 0.88 | 0.87 | 0.90 | 0.94 | 0.96 | 0.95 | 0.93 |
| | 60 | 1.00 | 1.03 | 1.01 | 0.93 | 0.88 | 0.90 | 0.93 | 0.95 | 0.96 | 0.95 |
| | 65 | 1.01 | 1.06 | 1.04 | 0.96 | 0.92 | 0.92 | 0.91 | 0.92 | 0.94 | 0.98 |
| | 70 | 1.06 | 1.10 | 1.05 | 0.95 | 0.90 | 0.90 | 0.88 | 0.87 | 0.93 | 1.01 |
| | 75 | 1.12 | 1.16 | 1.10 | 0.99 | 0.94 | 0.94 | 0.92 | 0.89 | 0.95 | 1.05 |
| | 80 | 1.11 | 1.18 | 1.17 | 1.10 | 1.05 | 1.05 | 1.03 | 0.98 | 0.98 | 1.05 |
| | 85 | 1.06 | 1.13 | 1.18 | 1.16 | 1.11 | 1.08 | 1.06 | 1.01 | 0.99 | 1.02 |
| | 90 | 1.00 | 1.07 | 1.19 | 1.22 | 1.16 | 1.11 | 1.09 | 1.05 | 1.00 | 0.98 |

[Table 24B]

| <Comparative Example 5> | | | | | | | | | | |
|---|---|---|---|---|---|---|---|---|---|---|
| Average orientation density | | Φ2(y) | | | | | | | | |
| | | 50 | 55 | 60 | 65 | 70 | 75 | 80 | 85 | 90 |
| | 0 | 0.97 | 0.97 | 0.97 | 0.97 | 0.99 | 1.01 | 1.02 | 1.02 | 1.03 |
| | 5 | 1.00 | 1.01 | 1.02 | 1.03 | 1.05 | 1.06 | 1.06 | 1.06 | 1.05 |
| | 10 | 1.05 | 1.08 | 1.11 | 1.14 | 1.16 | 1.15 | 1.13 | 1.11 | 1.10 |
| | 15 | 1.05 | 1.10 | 1.14 | 1.16 | 1.16 | 1.15 | 1.13 | 1.11 | 1.10 |
| | 20 | 0.98 | 1.02 | 1.05 | 1.05 | 1.06 | 1.07 | 1.08 | 1.07 | 1.06 |
| | 25 | 0.90 | 0.90 | 0.92 | 0.94 | 0.98 | 1.04 | 1.07 | 1.05 | 1.03 |

(continued)

| <Comparative Example 5> | | | | | | | | | | |
|---|---|---|---|---|---|---|---|---|---|---|
| Average orientation density | | Φ2(y) | | | | | | | | |
| | | 50 | 55 | 60 | 65 | 70 | 75 | 80 | 85 | 90 |
| Φ (x) | 30 | 0.86 | 0.85 | 0.86 | 0.90 | 0.98 | 1.07 | 1.09 | 1.06 | 1.02 |
| | 35 | 0.91 | 0.88 | 0.87 | 0.91 | 1.01 | 1.08 | 1.10 | 1.05 | 1.01 |
| | 40 | 0.97 | 0.92 | 0.89 | 0.93 | 1.02 | 1.09 | 1.10 | 1.05 | 0.99 |
| | 45 | 0.97 | 0.93 | 0.91 | 0.96 | 1.05 | 1.13 | 1.14 | 1.07 | 1.00 |
| | 50 | 0.93 | 0.93 | 0.95 | 1.00 | 1.08 | 1.15 | 1.15 | 1.08 | 1.01 |
| | 55 | 0.93 | 0.97 | 1.01 | 1.03 | 1.06 | 1.11 | 1.10 | 1.04 | 0.99 |
| | 60 | 0.98 | 1.05 | 1.07 | 1.04 | 1.04 | 1.07 | 1.06 | 1.00 | 0.95 |
| | 65 | 1.03 | 1.09 | 1.09 | 1.04 | 1.02 | 1.05 | 1.05 | 1.00 | 0.95 |
| | 70 | 1.07 | 1.09 | 1.09 | 1.04 | 1.01 | 1.02 | 1.03 | 1.02 | 1.02 |
| | 75 | 1.10 | 1.10 | 1.08 | 1.06 | 1.01 | 0.97 | 0.98 | 1.03 | 1.09 |
| | 80 | 1.10 | 1.08 | 1.05 | 1.05 | 1.02 | 0.97 | 0.97 | 1.02 | 1.08 |
| | 85 | 1.05 | 1.03 | 1.00 | 1.00 | 1.02 | 1.03 | 1.02 | 1.02 | 1.02 |
| | 90 | 1.00 | 0.99 | 0.94 | 0.95 | 1.03 | 1.09 | 1.08 | 1.02 | 0.96 |

[Table 25A]

| <Comparative Example 5> | | | | | | | | | | |
|---|---|---|---|---|---|---|---|---|---|---|
| Coefficient of variation | | Φ2(y) | | | | | | | | |
| | | 0 | 5 | 10 | 15 | 20 | 25 | 30 | 35 | 40 | 45 |
| Φ (x) | 0 | N/A | N/A | N/A | N/A | N/A | N/A | N/A | N/A | N/A | N/A |
| | 5 | N/A | N/A | N/A | N/A | N/A | N/A | N/A | N/A | N/A | N/A |
| | 10 | N/A | N/A | N/A | N/A | N/A | N/A | N/A | N/A | N/A | N/A |
| | 15 | N/A | N/A | N/A | N/A | N/A | N/A | N/A | N/A | N/A | N/A |
| | 20 | N/A | N/A | N/A | N/A | N/A | N/A | N/A | N/A | N/A | N/A |
| | 25 | N/A | N/A | N/A | N/A | N/A | N/A | N/A | N/A | N/A | N/A |
| | 30 | N/A | N/A | N/A | N/A | N/A | N/A | N/A | N/A | N/A | N/A |
| | 35 | N/A | N/A | N/A | N/A | N/A | N/A | N/A | N/A | N/A | N/A |
| | 40 | N/A | N/A | N/A | N/A | N/A | N/A | N/A | N/A | N/A | N/A |
| | 45 | N/A | N/A | N/A | N/A | N/A | N/A | N/A | N/A | N/A | N/A |
| | 50 | N/A | N/A | N/A | N/A | N/A | N/A | N/A | N/A | N/A | N/A |
| | 55 | N/A | N/A | N/A | N/A | N/A | N/A | N/A | N/A | N/A | N/A |
| | 60 | N/A | N/A | N/A | N/A | N/A | N/A | N/A | N/A | N/A | N/A |
| | 65 | N/A | N/A | N/A | N/A | N/A | N/A | N/A | N/A | N/A | N/A |
| | 70 | N/A | N/A | N/A | N/A | N/A | N/A | N/A | N/A | N/A | N/A |
| | 75 | N/A | N/A | N/A | N/A | N/A | N/A | N/A | N/A | N/A | N/A |
| | 80 | N/A | N/A | N/A | N/A | N/A | N/A | N/A | N/A | N/A | N/A |
| | 85 | N/A | N/A | N/A | N/A | N/A | N/A | N/A | N/A | N/A | N/A |
| | 90 | N/A | N/A | N/A | 0.39 | N/A | N/A | N/A | N/A | N/A | N/A |

[Table 25B]

<Comparative Example 5>

| Coefficient of variation | | Φ2(y) | | | | | | | | |
|---|---|---|---|---|---|---|---|---|---|---|
| | | 50 | 55 | 60 | 65 | 70 | 75 | 80 | 85 | 90 |
| Φ (x) | 0 | N/A | N/A | N/A | N/A | N/A | N/A | N/A | N/A | N/A |
| | 5 | N/A | N/A | N/A | N/A | N/A | N/A | N/A | N/A | N/A |
| | 10 | N/A | N/A | N/A | N/A | N/A | N/A | N/A | N/A | N/A |
| | 15 | N/A | N/A | N/A | N/A | N/A | N/A | N/A | N/A | N/A |
| | 20 | N/A | N/A | N/A | N/A | N/A | N/A | N/A | N/A | N/A |
| | 25 | N/A | N/A | N/A | N/A | N/A | N/A | N/A | N/A | N/A |
| | 30 | N/A | N/A | N/A | N/A | N/A | N/A | N/A | N/A | N/A |
| | 35 | N/A | N/A | N/A | N/A | N/A | N/A | N/A | N/A | N/A |
| | 40 | N/A | N/A | N/A | N/A | N/A | N/A | N/A | N/A | N/A |
| | 45 | N/A | N/A | N/A | N/A | N/A | N/A | N/A | N/A | N/A |
| | 50 | N/A | N/A | N/A | N/A | N/A | N/A | N/A | N/A | N/A |
| | 55 | N/A | N/A | N/A | N/A | N/A | N/A | N/A | N/A | N/A |
| | 60 | N/A | N/A | N/A | N/A | N/A | N/A | N/A | N/A | N/A |
| | 65 | N/A | N/A | N/A | N/A | N/A | N/A | N/A | N/A | N/A |
| | 70 | N/A | N/A | N/A | N/A | N/A | N/A | N/A | N/A | N/A |
| | 75 | N/A | N/A | N/A | N/A | N/A | N/A | N/A | N/A | N/A |
| | 80 | N/A | N/A | N/A | N/A | N/A | N/A | N/A | N/A | N/A |
| | 85 | N/A | N/A | N/A | N/A | N/A | N/A | N/A | N/A | N/A |
| | 90 | N/A | N/A | N/A | N/A | N/A | N/A | N/A | N/A | N/A |

[Table 26A]

<Comparative Example 6>

| Average orientation density | | Φ2(y) | | | | | | | | |
|---|---|---|---|---|---|---|---|---|---|---|
| | | 0 | 5 | 10 | 15 | 20 | 25 | 30 | 35 | 40 | 45 |
| Φ (x) | 0 | 1.09 | 1.09 | 1.08 | 1.07 | 1.07 | 1.08 | 1.09 | 1.09 | 1.07 | 1.05 |
| | 5 | 1.10 | 1.11 | 1.10 | 1.10 | 1.11 | 1.12 | 1.11 | 1.11 | 1.10 | 1.08 |
| | 10 | 1.08 | 1.10 | 1.11 | 1.13 | 1.15 | 1.16 | 1.14 | 1.13 | 1.13 | 1.14 |
| | 15 | 0.98 | 1.01 | 1.04 | 1.08 | 1.13 | 1.15 | 1.14 | 1.14 | 1.14 | 1.15 |
| | 20 | 0.87 | 0.90 | 0.95 | 1.00 | 1.06 | 1.09 | 1.10 | 1.09 | 1.09 | 1.09 |
| | 25 | 0.77 | 0.78 | 0.83 | 0.90 | 0.95 | 0.99 | 0.99 | 0.97 | 0.94 | 0.92 |
| | 30 | 0.67 | 0.63 | 0.65 | 0.71 | 0.76 | 0.81 | 0.84 | 0.83 | 0.79 | 0.75 |
| | 35 | 0.62 | 0.56 | 0.53 | 0.55 | 0.58 | 0.64 | 0.73 | 0.78 | 0.80 | 0.77 |
| | 40 | 0.69 | 0.63 | 0.57 | 0.52 | 0.51 | 0.57 | 0.75 | 0.98 | 1.18 | 1.21 |
| | 45 | 0.75 | 0.70 | 0.62 | 0.56 | 0.52 | 0.61 | 0.95 | 1.55 | 2.12 | 2.29 |
| | 50 | 0.69 | 0.65 | 0.59 | 0.55 | 0.54 | 0.68 | 1.23 | 2.25 | 3.32 | 3.74 |
| | 55 | 0.62 | 0.61 | 0.58 | 0.56 | 0.58 | 0.74 | 1.33 | 2.47 | 3.77 | 4.42 |
| | 60 | 0.67 | 0.68 | 0.67 | 0.64 | 0.63 | 0.73 | 1.13 | 1.94 | 2.93 | 3.53 |

(continued)

| <Comparative Example 6> | | | | | | | | | | |
|---|---|---|---|---|---|---|---|---|---|---|
| Average orientation density | Φ2(y) | | | | | | | | | |
| | 0 | 5 | 10 | 15 | 20 | 25 | 30 | 35 | 40 | 45 |
| 65 | 0.77 | 0.78 | 0.78 | 0.72 | 0.65 | 0.67 | 0.85 | 1.18 | 1.58 | 1.87 |
| 70 | 0.87 | 0.85 | 0.88 | 0.82 | 0.70 | 0.65 | 0.69 | 0.74 | 0.76 | 0.78 |
| 75 | 0.98 | 0.95 | 0.99 | 0.94 | 0.81 | 0.71 | 0.66 | 0.60 | 0.54 | 0.50 |
| 80 | 1.08 | 1.03 | 1.04 | 1.00 | 0.89 | 0.79 | 0.68 | 0.58 | 0.55 | 0.55 |
| 85 | 1.10 | 1.06 | 1.04 | 0.96 | 0.86 | 0.79 | 0.70 | 0.63 | 0.65 | 0.68 |
| 90 | 1.12 | 1.09 | 1.03 | 0.92 | 0.83 | 0.79 | 0.73 | 0.68 | 0.74 | 0.80 |

[Table 26B]

| <Comparative Example 6> | | | | | | | | | | |
|---|---|---|---|---|---|---|---|---|---|---|
| Average orientation density | | Φ2(y) | | | | | | | | |
| | | 50 | 55 | 60 | 65 | 70 | 75 | 80 | 85 | 90 |
| Φ (x) | 0 | 1.05 | 1.07 | 1.10 | 1.09 | 1.08 | 1.07 | 1.07 | 1.08 | 1.08 |
| | 5 | 1.09 | 1.11 | 1.12 | 1.10 | 1.08 | 1.08 | 1.08 | 1.09 | 1.10 |
| | 10 | 1.15 | 1.16 | 1.14 | 1.10 | 1.07 | 1.07 | 1.06 | 1.07 | 1.07 |
| | 15 | 1.16 | 1.16 | 1.13 | 1.08 | 1.03 | 1.00 | 0.98 | 0.96 | 0.95 |
| | 20 | 1.09 | 1.09 | 1.06 | 1.01 | 0.96 | 0.92 | 0.88 | 0.86 | 0.83 |
| | 25 | 0.91 | 0.90 | 0.89 | 0.87 | 0.85 | 0.83 | 0.81 | 0.79 | 0.77 |
| | 30 | 0.72 | 0.71 | 0.71 | 0.71 | 0.71 | 0.71 | 0.73 | 0.72 | 0.71 |
| | 35 | 0.72 | 0.66 | 0.63 | 0.62 | 0.60 | 0.60 | 0.65 | 0.67 | 0.69 |
| | 40 | 1.05 | 0.82 | 0.65 | 0.58 | 0.55 | 0.55 | 0.62 | 0.69 | 0.76 |
| | 45 | 1.93 | 1.30 | 0.80 | 0.57 | 0.52 | 0.54 | 0.62 | 0.72 | 0.81 |
| | 50 | 3.23 | 2.15 | 1.18 | 0.66 | 0.50 | 0.50 | 0.56 | 0.65 | 0.74 |
| | 55 | 3.99 | 2.79 | 1.58 | 0.85 | 0.57 | 0.50 | 0.52 | 0.58 | 0.63 |
| | 60 | 3.34 | 2.51 | 1.56 | 0.93 | 0.70 | 0.65 | 0.64 | 0.64 | 0.65 |
| | 65 | 1.86 | 1.55 | 1.13 | 0.86 | 0.82 | 0.88 | 0.89 | 0.82 | 0.75 |
| | 70 | 0.81 | 0.80 | 0.79 | 0.82 | 0.93 | 1.07 | 1.10 | 0.99 | 0.88 |
| | 75 | 0.49 | 0.55 | 0.69 | 0.88 | 1.05 | 1.18 | 1.23 | 1.13 | 1.03 |
| | 80 | 0.51 | 0.51 | 0.67 | 0.91 | 1.10 | 1.22 | 1.28 | 1.21 | 1.15 |
| | 85 | 0.62 | 0.56 | 0.64 | 0.83 | 0.99 | 1.12 | 1.21 | 1.19 | 1.17 |
| | 90 | 0.72 | 0.60 | 0.62 | 0.75 | 0.89 | 1.03 | 1.15 | 1.16 | 1.18 |

[Table 27A]

| <Comparative Example 6> | | | | | | | | | | |
|---|---|---|---|---|---|---|---|---|---|---|
| Coefficient of variation | | Φ2(y) | | | | | | | | |
| | | 0 | 5 | 10 | 15 | 20 | 25 | 30 | 35 | 40 | 45 |
| | 0 | N/A | N/A | N/A | N/A | N/A | N/A | N/A | N/A | N/A | N/A |
| | 5 | N/A | N/A | N/A | N/A | N/A | N/A | N/A | N/A | N/A | N/A |
| | 10 | N/A | N/A | N/A | N/A | N/A | N/A | N/A | N/A | N/A | N/A |

(continued)

| <Comparative Example 6> | | | | | | | | | | | | |
|---|---|---|---|---|---|---|---|---|---|---|---|---|
| Coefficient of variation | | Φ2(y) | | | | | | | | | | |
| | | 0 | 5 | 10 | 15 | 20 | 25 | 30 | 35 | 40 | 45 |
| Φ (x) | 15 | N/A | N/A | N/A | N/A | N/A | N/A | N/A | N/A | N/A | N/A |
| | 20 | N/A | N/A | N/A | N/A | N/A | N/A | N/A | N/A | N/A | N/A |
| | 25 | N/A | N/A | N/A | N/A | N/A | N/A | N/A | N/A | N/A | N/A |
| | 30 | N/A | N/A | N/A | N/A | N/A | N/A | N/A | N/A | N/A | N/A |
| | 35 | N/A | N/A | N/A | N/A | N/A | N/A | N/A | N/A | N/A | N/A |
| | 40 | N/A | N/A | N/A | N/A | N/A | N/A | N/A | N/A | N/A | 0.23 |
| | 45 | N/A | N/A | N/A | N/A | N/A | N/A | N/A | 0.14 | 0.17 | 0.17 |
| | 50 | N/A | N/A | N/A | N/A | N/A | N/A | 0.11 | 0.08 | 0.08 | 0.07 |
| | 55 | N/A | N/A | N/A | N/A | N/A | N/A | 0.11 | 0.07 | 0.05 | 0.02 |
| | 60 | N/A | N/A | N/A | N/A | N/A | N/A | N/A | 0.12 | 0.07 | 0.04 |
| | 65 | N/A | N/A | N/A | N/A | N/A | N/A | N/A | N/A | 0.10 | 0.10 |
| | 70 | N/A | N/A | N/A | N/A | N/A | N/A | N/A | N/A | N/A | N/A |
| | 75 | N/A | N/A | N/A | N/A | N/A | N/A | N/A | N/A | N/A | N/A |
| | 80 | N/A | N/A | N/A | N/A | N/A | N/A | N/A | N/A | N/A | N/A |
| | 85 | N/A | N/A | N/A | N/A | N/A | N/A | N/A | N/A | N/A | N/A |
| | 90 | N/A | N/A | N/A | N/A | N/A | N/A | N/A | N/A | N/A | N/A |

[Table 27B]

| <Comparative Example 6> | | | | | | | | | | | | |
|---|---|---|---|---|---|---|---|---|---|---|---|---|
| Coefficient of variation | | Φ2(y) | | | | | | | | | | |
| | | 50 | 55 | 60 | 65 | 70 | 75 | 80 | 85 | 90 |
| Φ (x) | 0 | N/A | N/A | N/A | N/A | N/A | N/A | N/A | N/A | N/A |
| | 5 | N/A | N/A | N/A | N/A | N/A | N/A | N/A | N/A | N/A |
| | 10 | N/A | N/A | N/A | N/A | N/A | N/A | N/A | N/A | N/A |
| | 15 | N/A | N/A | N/A | N/A | N/A | N/A | N/A | N/A | N/A |
| | 20 | N/A | N/A | N/A | N/A | N/A | N/A | N/A | N/A | N/A |
| | 25 | N/A | N/A | N/A | N/A | N/A | N/A | N/A | N/A | N/A |
| | 30 | N/A | N/A | N/A | N/A | N/A | N/A | N/A | N/A | N/A |
| | 35 | N/A | N/A | N/A | N/A | N/A | N/A | N/A | N/A | N/A |
| | 40 | N/A | N/A | N/A | N/A | N/A | N/A | N/A | N/A | N/A |
| | 45 | 0.15 | 0.13 | N/A | N/A | N/A | N/A | N/A | N/A | N/A |
| | 50 | 0.04 | 0.08 | N/A | N/A | N/A | N/A | N/A | N/A | N/A |
| | 55 | 0.04 | 0.11 | 0.17 | N/A | N/A | N/A | N/A | N/A | N/A |
| | 60 | 0.08 | 0.12 | 0.14 | N/A | N/A | N/A | N/A | N/A | N/A |
| | 65 | 0.13 | 0.13 | N/A | N/A | N/A | N/A | N/A | N/A | N/A |
| | 70 | N/A | N/A | N/A | N/A | N/A | N/A | N/A | N/A | N/A |
| | 75 | N/A | N/A | N/A | N/A | N/A | N/A | 0.11 | N/A | N/A |

(continued)

| <Comparative Example 6> | | | | | | | | | | |
|---|---|---|---|---|---|---|---|---|---|---|
| Coefficient of variation | | Φ2(y) | | | | | | | | |
| | | 50 | 55 | 60 | 65 | 70 | 75 | 80 | 85 | 90 |
| | 80 | N/A | N/A | N/A | N/A | N/A | 0.12 | 0.13 | 0.12 | N/A |
| | 85 | N/A | N/A | N/A | N/A | N/A | N/A | 0.13 | N/A | N/A |
| | 90 | N/A | N/A | N/A | N/A | N/A | N/A | N/A | N/A | N/A |

[Table 28A]

| <Comparative Example 7> | | | | | | | | | | |
|---|---|---|---|---|---|---|---|---|---|---|
| Average orientation density | | Φ2(y) | | | | | | | | |
| | | 0 | 5 | 10 | 15 | 20 | 25 | 30 | 35 | 40 | 45 |
| Φ (x) | 0 | 0.88 | 1.00 | 1.16 | 1.05 | 0.70 | 0.40 | 0.30 | 0.24 | 0.10 | 0.04 |
| | 5 | 0.89 | 1.02 | 1.18 | 1.05 | 0.69 | 0.42 | 0.30 | 0.21 | 0.08 | 0.03 |
| | 10 | 0.89 | 1.03 | 1.20 | 1.08 | 0.75 | 0.48 | 0.31 | 0.18 | 0.10 | 0.09 |
| | 15 | 0.92 | 1.07 | 1.24 | 1.12 | 0.83 | 0.55 | 0.32 | 0.17 | 0.17 | 0.17 |
| | 20 | 0.94 | 1.10 | 1.27 | 1.13 | 0.87 | 0.61 | 0.36 | 0.26 | 0.31 | 0.28 |
| | 25 | 0.93 | 1.09 | 1.24 | 1.10 | 0.88 | 0.69 | 0.47 | 0.41 | 0.47 | 0.46 |
| | 30 | 0.92 | 1.07 | 1.19 | 1.06 | 0.90 | 0.76 | 0.57 | 0.52 | 0.64 | 0.86 |
| | 35 | 0.94 | 1.07 | 1.17 | 1.05 | 0.91 | 0.79 | 0.64 | 0.70 | 1.04 | 1.73 |
| | 40 | 0.93 | 1.05 | 1.15 | 1.03 | 0.91 | 0.85 | 0.89 | 1.24 | 1.91 | 2.98 |
| | 45 | 0.88 | 1.00 | 1.10 | 1.01 | 0.92 | 0.98 | 1.30 | 2.00 | 2.87 | 3.88 |
| | 50 | 0.87 | 0.98 | 1.08 | 1.00 | 0.92 | 1.05 | 1.53 | 2.33 | 3.08 | 3.64 |
| | 55 | 0.92 | 1.01 | 1.10 | 1.01 | 0.89 | 0.97 | 1.34 | 1.91 | 2.30 | 2.39 |
| | 60 | 0.95 | 1.04 | 1.12 | 1.02 | 0.86 | 0.84 | 1.01 | 1.22 | 1.23 | 1.09 |
| | 65 | 0.93 | 1.01 | 1.11 | 1.02 | 0.83 | 0.74 | 0.77 | 0.74 | 0.56 | 0.42 |
| | 70 | 0.92 | 1.01 | 1.12 | 1.03 | 0.80 | 0.64 | 0.59 | 0.50 | 0.31 | 0.23 |
| | 75 | 0.93 | 1.02 | 1.15 | 1.06 | 0.77 | 0.52 | 0.42 | 0.33 | 0.21 | 0.15 |
| | 80 | 0.92 | 1.01 | 1.15 | 1.08 | 0.76 | 0.45 | 0.32 | 0.24 | 0.14 | 0.09 |
| | 85 | 0.89 | 0.99 | 1.15 | 1.07 | 0.74 | 0.42 | 0.30 | 0.24 | 0.11 | 0.04 |
| | 90 | 0.86 | 0.97 | 1.14 | 1.06 | 0.72 | 0.40 | 0.29 | 0.24 | 0.08 | -0.01 |

[Table 28B]

| <Comparative Example 7> | | | | | | | | | | |
|---|---|---|---|---|---|---|---|---|---|---|
| Average orientation density | | Φ2(y) | | | | | | | | |
| | | 50 | 55 | 60 | 65 | 70 | 75 | 80 | 85 | 90 |
| | 0 | 0.10 | 0.24 | 0.30 | 0.40 | 0.70 | 1.05 | 1.16 | 1.00 | 0.84 |
| | 5 | 0.11 | 0.24 | 0.31 | 0.43 | 0.75 | 1.11 | 1.25 | 1.15 | 1.04 |
| | 10 | 0.15 | 0.28 | 0.46 | 0.65 | 0.85 | 1.04 | 1.19 | 1.25 | 1.31 |
| | 15 | 0.19 | 0.42 | 0.81 | 1.06 | 1.05 | 0.99 | 1.03 | 1.11 | 1.18 |
| | 20 | 0.30 | 0.76 | 1.43 | 1.69 | 1.44 | 1.09 | 0.87 | 0.76 | 0.65 |
| | 25 | 0.69 | 1.55 | 2.45 | 2.54 | 1.91 | 1.22 | 0.73 | 0.45 | 0.18 |

(continued)

| <Comparative Example 7> | | | | | | | | | | |
|---|---|---|---|---|---|---|---|---|---|---|
| Average orientation density | | Φ2(y) | | | | | | | | |
| | | 50 | 55 | 60 | 65 | 70 | 75 | 80 | 85 | 90 |
| Φ (x) | 30 | 1.63 | 2.99 | 3.81 | 3.30 | 2.11 | 1.14 | 0.57 | 0.32 | 0.08 |
| | 35 | 3.15 | 4.75 | 4.96 | 3.49 | 1.75 | 0.77 | 0.37 | 0.24 | 0.12 |
| | 40 | 4.64 | 5.94 | 5.27 | 3.00 | 1.11 | 0.38 | 0.20 | 0.12 | 0.05 |
| | 45 | 5.15 | 5.76 | 4.53 | 2.23 | 0.70 | 0.27 | 0.15 | 0.05 | -0.05 |
| | 50 | 4.19 | 4.25 | 3.17 | 1.59 | 0.66 | 0.36 | 0.17 | 0.08 | -0.01 |
| | 55 | 2.45 | 2.40 | 1.89 | 1.17 | 0.68 | 0.38 | 0.18 | 0.18 | 0.17 |
| | 60 | 1.07 | 1.17 | 1.11 | 0.87 | 0.59 | 0.36 | 0.26 | 0.29 | 0.31 |
| | 65 | 0.49 | 0.68 | 0.73 | 0.63 | 0.52 | 0.48 | 0.48 | 0.45 | 0.43 |
| | 70 | 0.34 | 0.46 | 0.47 | 0.49 | 0.58 | 0.65 | 0.68 | 0.69 | 0.70 |
| | 75 | 0.21 | 0.25 | 0.29 | 0.45 | 0.64 | 0.72 | 0.74 | 0.88 | 1.02 |
| | 80 | 0.12 | 0.16 | 0.25 | 0.46 | 0.67 | 0.74 | 0.78 | 0.95 | 1.12 |
| | 85 | 0.08 | 0.20 | 0.30 | 0.44 | 0.67 | 0.87 | 0.94 | 0.94 | 0.94 |
| | 90 | 0.05 | 0.24 | 0.34 | 0.43 | 0.68 | 1.00 | 1.10 | 0.93 | 0.77 |

[Table 29A]

| <Comparative Example 7> | | | | | | | | | | |
|---|---|---|---|---|---|---|---|---|---|---|
| Coefficient of variation | | Φ2(y) | | | | | | | | |
| | | 0 | 5 | 10 | 15 | 20 | 25 | 30 | 35 | 40 | 45 |
| Φ (x) | 0 | N/A | N/A | N/A | N/A | N/A | N/A | N/A | N/A | N/A | N/A |
| | 5 | N/A | N/A | N/A | N/A | N/A | N/A | N/A | N/A | N/A | N/A |
| | 10 | N/A | N/A | 0.31 | N/A | N/A | N/A | N/A | N/A | N/A | N/A |
| | 15 | N/A | N/A | 0.26 | N/A | N/A | N/A | N/A | N/A | N/A | N/A |
| | 20 | N/A | N/A | 0.29 | N/A | N/A | N/A | N/A | N/A | N/A | N/A |
| | 25 | N/A | N/A | 0.30 | N/A | N/A | N/A | N/A | N/A | N/A | N/A |
| | 30 | N/A | N/A | N/A | N/A | N/A | N/A | N/A | N/A | N/A | N/A |
| | 35 | N/A | N/A | N/A | N/A | N/A | N/A | N/A | N/A | N/A | 0.41 |
| | 40 | N/A | N/A | N/A | N/A | N/A | N/A | N/A | 1.13 | 1.10 | 0.74 |
| | 45 | N/A | N/A | N/A | N/A | N/A | N/A | 1.25 | 1.52 | 1.43 | 0.99 |
| | 50 | N/A | N/A | N/A | N/A | N/A | N/A | 1.22 | 1.45 | 1.43 | 1.10 |
| | 55 | N/A | N/A | N/A | N/A | N/A | N/A | 1.05 | 1.24 | 1.29 | 1.10 |
| | 60 | N/A | N/A | N/A | N/A | N/A | N/A | N/A | 1.31 | 1.33 | N/A |
| | 65 | N/A | N/A | N/A | N/A | N/A | N/A | N/A | N/A | N/A | N/A |
| | 70 | N/A | N/A | N/A | N/A | N/A | N/A | N/A | N/A | N/A | N/A |
| | 75 | N/A | N/A | N/A | N/A | N/A | N/A | N/A | N/A | N/A | N/A |
| | 80 | N/A | N/A | N/A | N/A | N/A | N/A | N/A | N/A | N/A | N/A |
| | 85 | N/A | N/A | N/A | N/A | N/A | N/A | N/A | N/A | N/A | N/A |
| | 90 | N/A | N/A | N/A | N/A | N/A | N/A | N/A | N/A | N/A | N/A |

[Table 29B]

<Comparative Example 7>

| Coefficient of variation | | Φ2(y) | | | | | | | | |
|---|---|---|---|---|---|---|---|---|---|---|
| | | 50 | 55 | 60 | 65 | 70 | 75 | 80 | 85 | 90 |
| Φ (x) | 0 | N/A | N/A | N/A | N/A | N/A | N/A | N/A | N/A | N/A |
| | 5 | N/A | N/A | N/A | N/A | N/A | N/A | 0.36 | N/A | N/A |
| | 10 | N/A | N/A | N/A | N/A | N/A | N/A | N/A | 0.38 | 0.47 |
| | 15 | N/A | N/A | N/A | N/A | N/A | N/A | N/A | N/A | N/A |
| | 20 | N/A | N/A | 1.15 | 1.00 | 0.84 | N/A | N/A | N/A | N/A |
| | 25 | N/A | 1.07 | 1.18 | 1.15 | 1.02 | 0.85 | N/A | N/A | N/A |
| | 30 | 0.47 | 0.79 | 1.02 | 1.17 | 1.18 | N/A | N/A | N/A | N/A |
| | 35 | 0.32 | 0.51 | 0.78 | 1.05 | 1.22 | N/A | N/A | N/A | N/A |
| | 40 | 0.32 | 0.29 | 0.52 | 0.80 | N/A | N/A | N/A | N/A | N/A |
| | 45 | 0.44 | 0.15 | 0.32 | 0.53 | N/A | N/A | N/A | N/A | N/A |
| | 50 | 0.57 | 0.16 | 0.19 | 0.41 | N/A | N/A | N/A | N/A | N/A |
| | 55 | 0.68 | 0.30 | 0.16 | N/A | N/A | N/A | N/A | N/A | N/A |
| | 60 | N/A | N/A | N/A | N/A | N/A | N/A | N/A | N/A | N/A |
| | 65 | N/A | N/A | N/A | N/A | N/A | N/A | N/A | N/A | N/A |
| | 70 | N/A | N/A | N/A | N/A | N/A | N/A | N/A | N/A | N/A |
| | 75 | N/A | N/A | N/A | N/A | N/A | N/A | N/A | N/A | N/A |
| | 80 | N/A | N/A | N/A | N/A | N/A | N/A | N/A | N/A | N/A |
| | 85 | N/A | N/A | N/A | N/A | N/A | N/A | N/A | N/A | N/A |
| | 90 | N/A | N/A | N/A | N/A | N/A | N/A | N/A | N/A | N/A |

[Table 30A]

<Comparative Example 8>

| Average orientation density | | Φ2(y) | | | | | | | | | |
|---|---|---|---|---|---|---|---|---|---|---|---|
| | | 0 | 5 | 10 | 15 | 20 | 25 | 30 | 35 | 40 | 45 |
| Φ (x) | 0 | 0.68 | 0.68 | 0.68 | 0.67 | 0.67 | 0.70 | 0.73 | 0.74 | 0.74 | 0.74 |
| | 5 | 0.67 | 0.69 | 0.69 | 0.70 | 0.71 | 0.73 | 0.77 | 0.77 | 0.75 | 0.73 |
| | 10 | 0.60 | 0.64 | 0.69 | 0.72 | 0.75 | 0.79 | 0.81 | 0.80 | 0.74 | 0.66 |
| | 15 | 0.44 | 0.50 | 0.58 | 0.66 | 0.73 | 0.79 | 0.82 | 0.81 | 0.74 | 0.61 |
| | 20 | 0.27 | 0.32 | 0.40 | 0.51 | 0.63 | 0.73 | 0.80 | 0.83 | 0.78 | 0.67 |
| | 25 | 0.18 | 0.21 | 0.26 | 0.36 | 0.51 | 0.65 | 0.76 | 0.83 | 0.82 | 0.70 |
| | 30 | 0.17 | 0.20 | 0.24 | 0.29 | 0.41 | 0.58 | 0.78 | 0.93 | 0.95 | 0.80 |
| | 35 | 0.16 | 0.23 | 0.26 | 0.29 | 0.38 | 0.62 | 1.05 | 1.50 | 1.66 | 1.39 |
| | 40 | 0.12 | 0.20 | 0.28 | 0.31 | 0.41 | 0.81 | 1.73 | 2.81 | 3.31 | 2.83 |
| | 45 | 0.11 | 0.13 | 0.25 | 0.33 | 0.49 | 1.14 | 2.67 | 4.61 | 5.73 | 5.19 |
| | 50 | 0.12 | 0.13 | 0.24 | 0.36 | 0.62 | 1.40 | 3.24 | 5.83 | 7.82 | 7.91 |
| | 55 | 0.16 | 0.15 | 0.23 | 0.35 | 0.64 | 1.31 | 2.85 | 5.34 | 7.90 | 9.19 |
| | 60 | 0.17 | 0.18 | 0.19 | 0.25 | 0.46 | 0.87 | 1.73 | 3.34 | 5.57 | 7.56 |

(continued)

| <Comparative Example 8> | | | | | | | | | | | |
|---|---|---|---|---|---|---|---|---|---|---|---|
| Average orientation density | | Φ2(y) | | | | | | | | | |
| | | 0 | 5 | 10 | 15 | 20 | 25 | 30 | 35 | 40 | 45 |
| | 65 | 0.18 | 0.20 | 0.17 | 0.17 | 0.25 | 0.43 | 0.76 | 1.40 | 2.60 | 4.13 |
| | 70 | 0.27 | 0.21 | 0.20 | 0.19 | 0.16 | 0.21 | 0.34 | 0.56 | 0.90 | 1.46 |
| | 75 | 0.44 | 0.28 | 0.23 | 0.24 | 0.18 | 0.13 | 0.20 | 0.34 | 0.41 | 0.44 |
| | 80 | 0.60 | 0.39 | 0.27 | 0.23 | 0.19 | 0.14 | 0.16 | 0.19 | 0.21 | 0.22 |
| | 85 | 0.67 | 0.53 | 0.39 | 0.28 | 0.21 | 0.19 | 0.16 | 0.12 | 0.12 | 0.14 |
| | 90 | 0.74 | 0.67 | 0.51 | 0.33 | 0.24 | 0.24 | 0.16 | 0.05 | 0.03 | 0.06 |

[Table 30B]

| <Comparative Example 8> | | | | | | | | | | | |
|---|---|---|---|---|---|---|---|---|---|---|---|
| Average orientation density | | Φ2(y) | | | | | | | | | |
| | | 50 | 55 | 60 | 65 | 70 | 75 | 80 | 85 | 90 |
| Φ (x) | 0 | 0.74 | 0.74 | 0.73 | 0.72 | 0.69 | 0.66 | 0.66 | 0.68 | 0.69 |
| | 5 | 0.70 | 0.68 | 0.67 | 0.66 | 0.65 | 0.63 | 0.63 | 0.65 | 0.68 |
| | 10 | 0.57 | 0.51 | 0.48 | 0.48 | 0.49 | 0.50 | 0.52 | 0.56 | 0.60 |
| | 15 | 0.48 | 0.36 | 0.31 | 0.28 | 0.29 | 0.31 | 0.35 | 0.40 | 0.44 |
| | 20 | 0.51 | 0.38 | 0.28 | 0.21 | 0.18 | 0.19 | 0.22 | 0.24 | 0.26 |
| | 25 | 0.53 | 0.36 | 0.24 | 0.16 | 0.12 | 0.13 | 0.15 | 0.17 | 0.18 |
| | 30 | 0.55 | 0.32 | 0.17 | 0.09 | 0.06 | 0.06 | 0.10 | 0.14 | 0.18 |
| | 35 | 0.89 | 0.46 | 0.23 | 0.14 | 0.08 | 0.07 | 0.06 | 0.09 | 0.12 |
| | 40 | 1.76 | 0.82 | 0.38 | 0.25 | 0.17 | 0.09 | 0.08 | 0.07 | 0.07 |
| | 45 | 3.44 | 1.68 | 0.69 | 0.33 | 0.20 | 0.11 | 0.12 | 0.09 | 0.06 |
| | 50 | 6.16 | 3.77 | 1.89 | 0.80 | 0.30 | 0.14 | 0.17 | 0.17 | 0.17 |
| | 55 | 8.51 | 6.33 | 3.77 | 1.78 | 0.64 | 0.22 | 0.16 | 0.19 | 0.22 |
| | 60 | 8.18 | 6.97 | 4.64 | 2.41 | 1.03 | 0.42 | 0.20 | 0.17 | 0.13 |
| | 65 | 5.16 | 4.92 | 3.60 | 2.14 | 1.20 | 0.72 | 0.40 | 0.22 | 0.04 |
| | 70 | 2.01 | 2.17 | 1.87 | 1.45 | 1.19 | 0.97 | 0.69 | 0.42 | 0.16 |
| | 75 | 0.51 | 0.63 | 0.75 | 0.91 | 1.04 | 1.02 | 0.87 | 0.66 | 0.45 |
| | 80 | 0.23 | 0.24 | 0.30 | 0.50 | 0.74 | 0.89 | 0.89 | 0.79 | 0.69 |
| | 85 | 0.21 | 0.21 | 0.19 | 0.24 | 0.44 | 0.67 | 0.79 | 0.78 | 0.76 |
| | 90 | 0.18 | 0.17 | 0.07 | -0.02 | 0.14 | 0.46 | 0.69 | 0.77 | 0.84 |

[Table 31A]

| <Comparative Example 8> | | | | | | | | | | | |
|---|---|---|---|---|---|---|---|---|---|---|---|
| Coefficient of variation | | Φ2(y) | | | | | | | | | |
| | | 0 | 5 | 10 | 15 | 20 | 25 | 30 | 35 | 40 | 45 |
| | 0 | N/A | N/A | N/A | N/A | N/A | N/A | N/A | N/A | N/A | N/A |
| | 5 | N/A | N/A | N/A | N/A | N/A | N/A | N/A | N/A | N/A | N/A |
| | 10 | N/A | N/A | N/A | N/A | N/A | N/A | N/A | N/A | N/A | N/A |

(continued)

| <Comparative Example 8> | | | | | | | | | | | |
|---|---|---|---|---|---|---|---|---|---|---|---|
| Coefficient of variation | | Φ2(y) | | | | | | | | | |
| | | 0 | 5 | 10 | 15 | 20 | 25 | 30 | 35 | 40 | 45 |
| Φ (x) | 15 | N/A | N/A | N/A | N/A | N/A | N/A | N/A | N/A | N/A | N/A |
| | 20 | N/A | N/A | N/A | N/A | N/A | N/A | N/A | N/A | N/A | N/A |
| | 25 | N/A | N/A | N/A | N/A | N/A | N/A | N/A | N/A | N/A | N/A |
| | 30 | N/A | N/A | N/A | N/A | N/A | N/A | N/A | N/A | N/A | N/A |
| | 35 | N/A | N/A | N/A | N/A | N/A | N/A | N/A | 0.56 | 0.70 | 0.86 |
| | 40 | N/A | N/A | N/A | N/A | N/A | N/A | 0.43 | 0.46 | 0.56 | 0.71 |
| | 45 | N/A | N/A | N/A | N/A | N/A | N/A | 0.39 | 0.28 | 0.34 | 0.45 |
| | 50 | N/A | N/A | N/A | N/A | N/A | 0.83 | 0.54 | 0.25 | 0.13 | 0.17 |
| | 55 | N/A | N/A | N/A | N/A | N/A | 1.04 | 0.77 | 0.40 | 0.16 | 0.07 |
| | 60 | N/A | N/A | N/A | N/A | N/A | N/A | 0.91 | 0.50 | 0.23 | 0.12 |
| | 65 | N/A | N/A | N/A | N/A | N/A | N/A | N/A | 0.64 | 0.54 | 0.39 |
| | 70 | N/A | N/A | N/A | N/A | N/A | N/A | N/A | N/A | N/A | 0.81 |
| | 75 | N/A | N/A | N/A | N/A | N/A | N/A | N/A | N/A | N/A | N/A |
| | 80 | N/A | N/A | N/A | N/A | N/A | N/A | N/A | N/A | N/A | N/A |
| | 85 | N/A | N/A | N/A | N/A | N/A | N/A | N/A | N/A | N/A | N/A |
| | 90 | N/A | N/A | N/A | N/A | N/A | N/A | N/A | N/A | N/A | N/A |

[Table 31B]

| <Comparative Example 8> | | | | | | | | | | | |
|---|---|---|---|---|---|---|---|---|---|---|---|
| Coefficient of variation | | Φ2(y) | | | | | | | | | |
| | | 50 | 55 | 60 | 65 | 70 | 75 | 80 | 85 | 90 |
| Φ (x) | 0 | N/A | N/A | N/A | N/A | N/A | N/A | N/A | N/A | N/A |
| | 5 | N/A | N/A | N/A | N/A | N/A | N/A | N/A | N/A | N/A |
| | 10 | N/A | N/A | N/A | N/A | N/A | N/A | N/A | N/A | N/A |
| | 15 | N/A | N/A | N/A | N/A | N/A | N/A | N/A | N/A | N/A |
| | 20 | N/A | N/A | N/A | N/A | N/A | N/A | N/A | N/A | N/A |
| | 25 | N/A | N/A | N/A | N/A | N/A | N/A | N/A | N/A | N/A |
| | 30 | N/A | N/A | N/A | N/A | N/A | N/A | N/A | N/A | N/A |
| | 35 | N/A | N/A | N/A | N/A | N/A | N/A | N/A | N/A | N/A |
| | 40 | 0.87 | N/A | N/A | N/A | N/A | N/A | N/A | N/A | N/A |
| | 45 | 0.53 | 0.52 | N/A | N/A | N/A | N/A | N/A | N/A | N/A |
| | 50 | 0.15 | 0.11 | 0.46 | N/A | N/A | N/A | N/A | N/A | N/A |
| | 55 | 0.03 | 0.18 | 0.43 | 0.65 | N/A | N/A | N/A | N/A | N/A |
| | 60 | 0.06 | 0.15 | 0.33 | 0.52 | N/A | N/A | N/A | N/A | N/A |
| | 65 | 0.28 | 0.24 | 0.29 | 0.43 | 0.54 | N/A | N/A | N/A | N/A |
| | 70 | 0.56 | 0.45 | 0.42 | 0.48 | N/A | N/A | N/A | N/A | N/A |
| | 75 | N/A | N/A | N/A | N/A | N/A | N/A | N/A | N/A | N/A |

(continued)

| <Comparative Example 8> | | | | | | | | | | |
|---|---|---|---|---|---|---|---|---|---|---|
| Coefficient of variation | | Φ2(y) | | | | | | | | |
| | | 50 | 55 | 60 | 65 | 70 | 75 | 80 | 85 | 90 |
| | 80 | N/A | N/A | N/A | N/A | N/A | N/A | N/A | N/A | N/A |
| | 85 | N/A | N/A | N/A | N/A | N/A | N/A | N/A | N/A | N/A |
| | 90 | N/A | N/A | N/A | N/A | N/A | N/A | N/A | N/A | N/A |

<Evaluation of Film Formation Characteristics>

The molybdenum sputtering targets and chromium sputtering targets obtained in the Examples and Comparative Examples were each machined and then bonded to an oxygen-free copper backing plate. Sputtering was performed under the following conditions using each target, and a film formation rate (film formation speed) was measured.

Gas species: argon (Ar)
Gas pressure: 0.5 Pa
Accelerating voltage: 2 kV
Substrate: Si substrate
Substrate temperature: room temperature (25°C)
Substrate rotation: none

The film formation rate was calculated by the following equation.

Film formation rate [nm/min] = average film thickness [nm]/film formation time [min]

In the above equation, the average film thickness is an average value of film thicknesses at measurement points.
In measuring the film thickness, the measurement points were a total of 64 points on a glass substrate after film formation (a glass substrate having a sputtered film), including: (1) the center; (2) 6 equally spaced points on the circumference of a concentric circle having a diameter corresponding to 1/4 of the diameter of the substrate; (3) 13 equally spaced points on the circumference of a concentric circle having a diameter corresponding to 2/4 of the diameter of the substrate; (4) 19 equally spaced points on the circumference of a concentric circle having a diameter corresponding to 3/4 of the diameter of the substrate; and (5) 25 equally spaced points on the circumference of a concentric circle having a diameter corresponding to 4/4 of the diameter of the substrate.
The film thickness at each measurement point was measured using a spectroscopic ellipsometer (device name: M-2000, manufactured by J.A. Woollam). The average value of the film thicknesses at the measurement points thus obtained was defined as the average film thickness. Based on the film thicknesses at the measurement points thus obtained, "maximum value - minimum value" and "film thickness standard deviation $\sigma$" were determined. Using the film thickness standard deviation $\sigma$ and the average film thickness, the coefficient of variation of the film thickness was determined by the following equation. The results are presented in Table 32.

Coefficient of variation of film thickness = film thickness standard deviation $\sigma$/average film thickness

[Table 32]

| | Average film thickness | Film formation rate | Film thickness | | Film thickness standard deviation $\sigma$ | Coefficient of variation of film thickness |
|---|---|---|---|---|---|---|
| | | | Maximum value - minimum value | | | |
| | nm | nm/min | nm | | nm | |
| Example 1 | 39.93 | 4.41 | 26.73 | | 7.48 | 0.187 |
| Example 3 | 30.64 | 1.99 | 19.07 | | 5.70 | 0.186 |
| Example 5 | 31.61 | 2.63 | 21.30 | | 5.90 | 0.187 |

(continued)

| | Average film thickness | Film formation rate | Film thickness | Film thickness standard deviation $\sigma$ | Coefficient of variation of film thickness |
|---|---|---|---|---|---|
| | | | Maximum value - minimum value | | |
| | nm | nm/min | nm | nm | |
| Comparative Example 1 | 39.90 | 3.51 | 32.85 | 9.06 | 0.227 |
| Comparative Example 2 | 28.68 | 2.39 | 27.70 | 6.44 | 0.225 |
| Comparative Example 3 | 32.52 | 2.71 | 28.20 | 8.40 | 0.258 |

This application is based on Japanese Patent Application (Patent Application No. 2023-133069) filed on Aug. 17, 2023, and Japanese Patent Application (Patent Application No. 2023-202660) filed on Nov. 30, 2023, the entire contents of each of which are incorporated herein by reference. In addition, the entire contents of all references cited herein are incorporated herein by reference.

**Reference Signs List**

10 metal sputtering target, 20 backing plate, 30 bonding material, 100 metal sputtering target structure, 200 film-attached substrate, 201 substrate, 202 film

**Claims**

1. A metal sputtering target, comprising a metal having a body-centered cubic structure or a face-centered cubic structure,

   wherein, when a cross section perpendicular to a sputtering surface of the metal sputtering target is observed using an electron backscatter diffraction method to analyze crystal orientations in a normal direction (ND direction) of the sputtering surface , a proportion, relative to all measurement points, of measurement points having a plane orientation within 15° from the plane orientation with the highest intensity in an inverse pole figure space obtained from all the measurement points is 35% or more by area, and
   wherein, when a crystal orientation distribution function of the metal sputtering target is represented by Euler angles ($\varphi1$, $\Phi$, $\varphi2$), which express a crystal orientation by rotating a crystal coordinate system, in which the [100] direction of a crystal is taken as an X-axis, the [010] direction is taken as a Y-axis, and the [001] direction is taken as a Z-axis, from a state in which the crystal coordinate system coincides respectively with an orthogonal sample coordinate system RD, TD, and ND of the metal sputtering target, by rotating the crystal coordinate system around the Z-axis by $\varphi1$, subsequently around the rotated X-axis by $\Phi$, and further around the rotated Z-axis by $\varphi2$, in orientation groups of $\varphi1$: $k°$ ($0 \le k \le 90$), $\Phi$: $x°$ ($0 \le x \le 90$), and $\varphi2$: $y°$ ($0 \le y \le 90$), for all combinations of ($x$, $y$) for which an average value of orientation density in a range of $0 \le k \le 90$ is 1.2 or more, a coefficient of variation of the average value is 0.5 or less.

2. The metal sputtering target according to claim 1, wherein the proportion is 98% or less by area.

3. The metal sputtering target according to claim 1 or 2, wherein the coefficient of variation of the average value is 0.01 or more.

4. The metal sputtering target according to any one of claims 1 to 3, wherein the maximum value of the crystal orientation distribution function is 2.0 or more.

5. The metal sputtering target according to any one of claims 1 to 4, wherein the maximum value of the crystal orientation distribution function is 50 or less.

6. The metal sputtering target according to any one of claims 1 to 5, wherein the metal is one or more selected from the group consisting of chromium (Cr), iron (Fe), ruthenium (Ru), niobium (Nb), molybdenum (Mo), tantalum (Ta), vanadium (V), tungsten (W), aluminum (Al), copper (Cu), and nickel (Ni).

7. The metal sputtering target according to any one of claims 1 to 6, wherein the metal is one or more selected from the group consisting of chromium (Cr), ruthenium (Ru), molybdenum (Mo), and tungsten (W).

8. A metal sputtering target structure, comprising a metal sputtering target according to any one of claims 1 to 7; and a backing plate.

9. A method for producing a film, comprising using the metal sputtering target according to any one of claims 1 to 7 or the metal sputtering target structure according to claim 8.

10. A method for producing a metal sputtering target according to any one of claims 1 to 7, the method comprising: a pressing step of subjecting an ingot made of a metal having a body-centered cubic structure or a face-centered cubic structure to pressing treatment at a pressing temperature of 500°C or higher using a buffer member including a buffer layer to obtain a processed ingot; and a heat treatment step of treating the processed ingot at 900°C or higher.

11. The method for producing a metal sputtering target according to claim 10, wherein the buffer layer is a buffer layer including a coating.

12. The method for producing a metal sputtering target according to claim 10 or 11, wherein the buffer layer is a buffer layer including a graphite lubricant coating.

EP 4 752 256 A1

**Fig.1**

58

**Fig.2**

200

202

201

## INTERNATIONAL SEARCH REPORT

| International application No. |
|---|
| **PCT/JP2024/029116** |

| A. | CLASSIFICATION OF SUBJECT MATTER |
|---|---|

*C23C 14/34*(2006.01)i
FI:    C23C14/34 A

According to International Patent Classification (IPC) or to both national classification and IPC

| B. | FIELDS SEARCHED |
|---|---|

Minimum documentation searched (classification system followed by classification symbols)

C23C14/34

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

JSTPlus/JST7580/JSTChina (JDreamIII)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | WO 2009/107763 A1 (NIPPON STEEL MATERIALS CO., LTD.) 03 September 2009 (2009-09-03) claims 1-5 | 1-12 |
| A | WO 2011/052171 A1 (ULVAC, INC.) 05 May 2011 (2011-05-05) claim 1 | 1-12 |
| A | CN 111286703 A (SINO-PLATINUM METALS CO., LTD.) 16 June 2020 (2020-06-16) claim 1 | 1-12 |
| A | JP 2012-507626 A (TOSOH SMD, INC.) 29 March 2012 (2012-03-29) claim 1 | 1-12 |
| A | US 2005/0155677 A1 (WICKERSHAM, Charles E. Jr.) 21 July 2005 (2005-07-21) claim 16, paragraph [0031] | 1-12 |

| ☐ Further documents are listed in the continuation of Box C. | ☑ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **03 October 2024** | **15 October 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**
Information on patent family members

International application No.

**PCT/JP2024/029116**

| Patent document cited in search report | | | Publication date (day/month/year) | Patent family member(s) | | | Publication date (day/month/year) |
|---|---|---|---|---|---|---|---|
| WO | 2009/107763 | A1 | 03 September 2009 | CN | 101960042 | A | |
| WO | 2011/052171 | A1 | 05 May 2011 | US claim 1 | 2012/0217158 | A1 | |
| | | | | CN | 102597301 | A | |
| CN | 111286703 | A | 16 June 2020 | (Family: none) | | | |
| JP | 2012-507626 | A | 29 March 2012 | US claim 1 | 2011/0214987 | A1 | |
| US | 2005/0155677 | A1 | 21 July 2005 | WO | 2005/071135 | A2 | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014129599 A
- JP 2012507626 A
- JP 2023133069 A
- JP 2023202660 A

**Non-patent literature cited in the description**

- **GOTTFRIED K. WEHNER**. *Phys. Rev.*, 1956, vol. 102, 690
- **F. BOUCHARD et al.** *J. Vac. Sci. Technol. A*, 1993, vol. 11, 2765